Europäisches Patentamt

European Patent Office

Office européen des brevets

(19)

(11) **EP 1 132 745 A2**

(12) ## EUROPEAN PATENT APPLICATION

(43) Date of publication:
**12.09.2001 Bulletin 2001/37**

(51) Int Cl.⁷: **G01R 31/00**, G01R 29/08

(21) Application number: **01302063.1**

(22) Date of filing: **06.03.2001**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **08.03.2000 JP 2000063783**

(71) Applicant: **MATSUSHITA ELECTRIC INDUSTRIAL
CO., LTD.
Kadoma-shi, Osaka (JP)**

(72) Inventors:
• **Shimazaki, Kenji
Kobe-shi, Hyogo (JP)**

• **Tsujikawa, Hiroyuki
Kusatsu-shi, Shiga (JP)**
• **Hirano, Shouzou
Ibaraki-shi, Osaka (JP)**
• **Mizokawa, Takashi
Nagaokayo-shi, Kyoto (JP)**

(74) Representative: **Rackham, Stephen Neil
GILL JENNINGS & EVERY,
Broadgate House,
7 Eldon Street
London EC2M 7LH (GB)**

(54) **Electromagnetic interference analysis method and apparatus**

(57) Method and apparatus for analysing the amount of Electromagnetic Interference (EMI) produced by large scale integrated circuits (LSIs). The invention includes a discrete analysis frequency width change specifying process for specifying, in a particular frequency range, a change in a discrete high-speed Fast Fourier transform (FFT) analysis frequency width. The invention also includes a modelling process for allocating different discrete FFT analysis frequency widths to the particular frequency range and to a frequency range other than the particular frequency range and performing modelling. The EMI analysis method of the invention takes into account the influence of decoupling by resistance, capacitance and inductance of the power supply and ground on the gate level power supply current calculations. Accordingly, it is possible to evaluate the EMI of LSIs in simulation in a realistic time and to provide efficient EMI countermeasures by identifying EMI causing locations.

*FIG. 10*

```
          ( START FFT ANALYSIS MEANS )
                      │
          ┌───────────────────────────────┐
          │ READ DETAILED FREQUENCY INFORMATION │ ~ 1001
          └───────────────────────────────┘
                      │
          ┌───────────────────────────────┐
          │ READ POWER SUPPLY CURRENT INFORMATION │ ~ 1002
          └───────────────────────────────┘
                      │
   ┌─────────────────────────────────────────────┐
   │ IN THE DETAILED FREQUENCY INFORMATION RANGE,  │
   │ USE PREDETERMINED, NORMAL DISCRETE ANALYSIS   │
   │   FREQUENCY WIDTH OF 5MHz IN PERFORMING       │ ~ 1003
   │ FREQUENCY ANALYSIS; IN OTHER RANGE, USE COARSE│
   │  DISCRETE ANALYSIS FREQUENCY WIDTH OF 25MHz   │
   └─────────────────────────────────────────────┘
                      │
          ┌───────────────────────┐
          │    STORE FFT RESULT    │ ~ 1004
          └───────────────────────┘
                      │
          ( END FFT ANALYSIS MEANS )
```

EP 1 132 745 A2

Printed by Jouve, 75001 PARIS (FR)

**Description**

The present invention relates to a method of analyzing electromagnetic interference (EMI) and more particularly to a method of analyzing EMI by performing a high-speed, high-precision logic simulation on a large and high-speed LSI (large-scale integrated circuit).

LSIs have found a wide range of applications, including computers, communication devices such as cellular phones, home products, toys, and automobiles. These devices, however, produce electromagnetic interferences, which cause electromagnetic wave interferences to television and radio receivers and erroneous operations in other systems. Although measures to deal with these problems have been taken on the product side, such as filtering and shielding, there is a growing demand for suppressing noise of the individual LSIs themselves because such measures on the products entail increased parts count and cost and implementing such measures is not easy.

At the same time, LSI is taken as a key device in any product and, to secure competitiveness of the product, an increased size and speed of the LSI is being called for. At a time when the product cycles are becoming shorter and shorter, it is essential to automate the LSI design in meeting these requirements and there is a growing necessity under current situation to adopt a synchronous design as a condition for introducing the design automation technology. In large-scale and high-speed LSIs in which all circuits operate in synchronism with a reference clock, an instantaneous current becomes very large, increasing electromagnetic interferences.

This invention relates to a simulation technique that can perform an EMI evaluation essential in reducing EMI while maintaining the momentum of increasing the size and speed of the LSIs.

Noise that LSIs impart to other electronic devices can be classified into radiative noise and conductive noise. The radiative noise directly emitted from the LSI includes one radiated from internal wiring of the LSI, but the internal wiring is not significant as an antenna. Although the noise radiated directly from the LSI is considered to pose a problem in the future as the operation frequency of the LSI increases, the radiative noise level of the internal wiring of LSI is not problematically high at present.

The conductive noise, on the other hand, affects other devices on a printed circuit board through direct interconnects, such as internal wiring in the LSI, lead frames and wires on the printed circuit board. At the same time, these wires work as antennas or noise transmitting sources. The antennas made up of these interconnecting paths are very large compared with the internal wiring of the LSI and are a dominant factor in considering the EMI.

The paths for the conductive noise from the LSI include power supply paths and signal paths. Considering nearby electromagnetic fields, noise generated by current changes in the power supply and radiated from the power supply line as antenna is considered to be dominant. As for signals, ringing overshoots produced by signal changes may become a problem, but variations in the LSI internal power supply level are often conducted as signal waveforms, causing problems. Noise passing through either of power supply paths and signal paths for radiation is considered to have a strong correlation with changes in power supply current.

A power supply current in a CMOS circuit will be explained by using a simple inverter circuit. When an input voltage to the inverter circuit changes, a load capacitance charging/discharging current, the main power supply current for the CMOS circuit, flows. In addition to this current, a through current also flows. In designing such a CMOS circuit, the CMOS circuit is synchronized in order to meet the requirement imposed by the use of the automatic design tool. Because the whole circuits of the LSI operate at the same time, a power supply peak current occurs in synchronism with the reference clock. Further, to increase the operation speed, i.e., reduce the period of cycle, the transistor size is increased to allow charging and discharging in a short period of time, resulting in an increased peak current. The power supply current of the LSI as a whole also increases naturally as the size of LSI is increased. In this way the peak current of the power supply has increased and the power supply current has come to change sharply. This sharp change increases harmonic components and therefore the EMI.

Performing a highly accurate simulation on the change in the power supply current, the main factor of the EMI, is considered to be effective in evaluating the EMI of LSI.

A conventional current simulation technique performs the current analysis at the transistor level as described below.

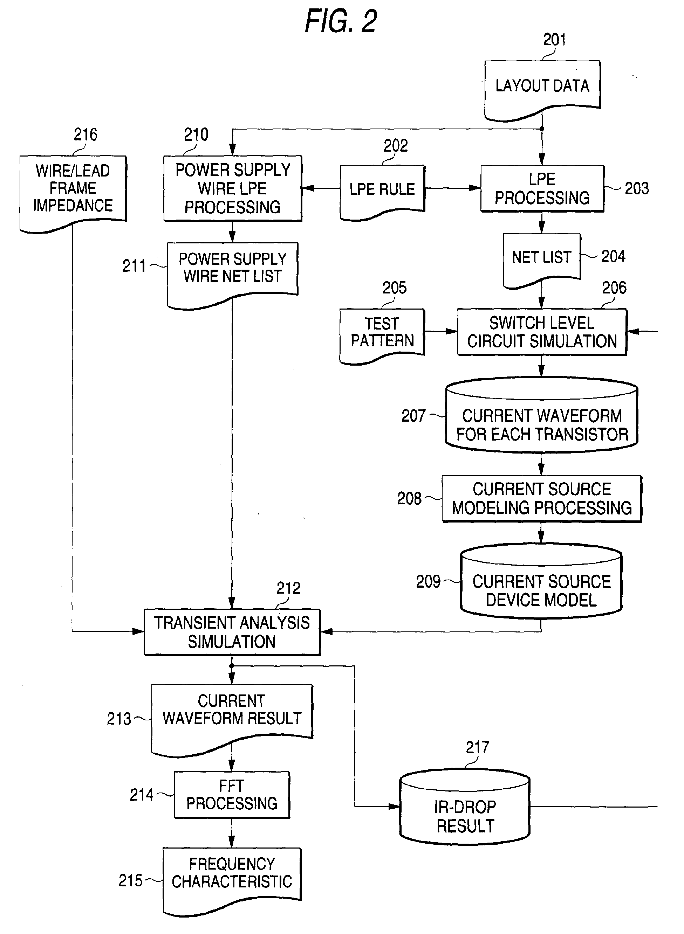

Fig. 2 is a block diagram showing the processing flow of the conventional EMI analyzing method that adopts the transistor level current analyzing technique. In this method, based on the layout information of LSI to be analyzed, a layout parameter extraction (LPE) processing 203 is performed. Then, a circuit simulation 206 is performed on a switch level netlist. This is followed by current source modeling processing 208, power supply wiring LPE processing 210, a transient analysis simulation 212, and FFT processing 214.

Each step of the above processing will be described by referring to Fig. 2.

The step 203 takes in layout data 201 of a semiconductor integrated circuit to be analyzed for EMI and an LPE rule 202 that defines parameter values of transistors, various wiring parasitic devices (resistors, capacitors, etc.) and other devices as well as the output format of the extracted results. Based on the LPE rule 202, the step 203 calculates parameters of the devices in the layout data 201 and generates a netlist 204. In this step, parameter extraction is not performed on parasitic devices of the power supply (and ground) wires.

The step 206 takes in the netlist 204 generated by the step 203 and a test pattern 205 for reproducing a desired logic operation in the circuit to be analyzed, and then calculates a load capacitance charging/discharging current and a through current according to the operating state of the internal circuit to generate current waveform information 207 for each transistor. The first processing of this step is performed by assuming that the power supply (and ground) potential is an ideal potential without variations.

The step 208 takes in the current waveform information 207 for each transistor generated by the step 206 and models each current waveform into a form that is applicable in a subsequent step 212 to generate current source device model information 209. To alleviate the processing load on the subsequent step 212, it is common practice to model the current source devices for each functional circuit block made up of a plurality of transistors.

The explanation of the step 210 is omitted as it is similar to the step 203 except that the parameter extraction objects only change from the transistor devices and various wiring parasitic devices that are to be analyzed for EMI to the parasitic devices of the power and ground wires (resistor, decoupling capacitor, etc.). This step generates a power supply (and ground) wire netlist 211.

The step 212 takes in the current source device model information 209 generated by the step 208, the power supply (and ground) wire netlist 211 generated by the step 210 and a wire/lead frame impedance (resistance, capacitance and inductance) 216, and uses a transient analysis simulator as represented by the SPICE to calculate the power supply voltage variations in the circuit to be analyzed and generate a power supply voltage drop result 217.

Then, the step 206 is performed again. In the first processing of this step 206 it was assumed that the power supply (and ground) potential was an ideal potential with no variations. This time, however, the step 206 receives the power supply voltage drop result 217 and again generates the current waveform information 207 for each transistor considering the power supply voltage variations. The step 208 and 212 are performed again in the similar manner.

The loop processing comprised of the steps 206, 208, 212 is performed a plurality of times to generate a current waveform result 213 that reproduces the power supply voltage variations with high precision. The next step 214 receives the current waveform result 213 generated by the step 212 and performs high-speed Fourier transform (FFT) on the current waveform result to analyze the frequency spectrum and thereby produce an EMI analysis result 215.

In this example of conventional processing, the combination of the LPE processing 203, the power supply wiring LPE processing 210 and the current source modeling processing 208 can be expected to provide a certain level of analysis precision although the verification precision may vary widely. However, because the current analysis at the transistor level uses a transient analysis simulator as represented by the SPICE, the scale of the circuit to be analyzed for EMI is limited and the processing takes very long. As the semiconductor integrated circuits are becoming increasingly larger in recent years, there is a growing call for an established EMI analysis method capable of high-speed analysis with a higher degree of abstraction than the transistor level.

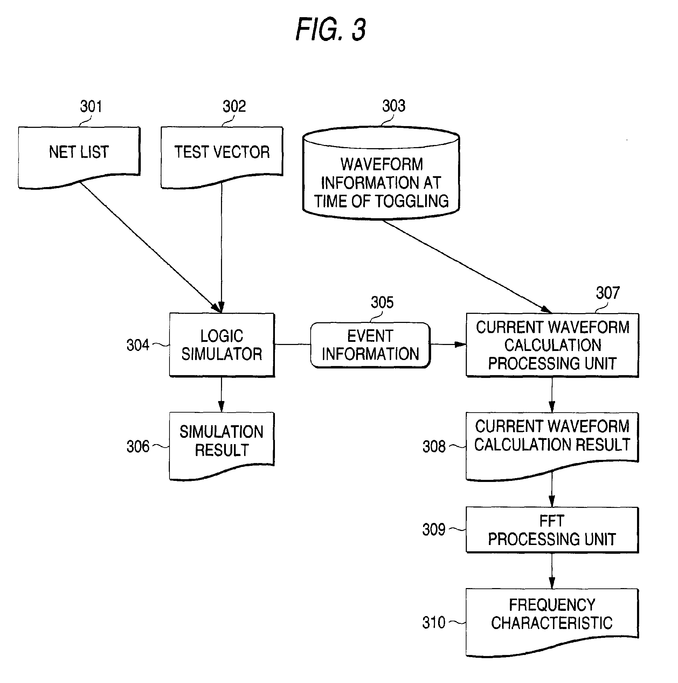

To meet this demand a gate level EMI current analysis method has been proposed as the one that can increase the processing speed. An example of such an EMI current analysis method is an EMI-noise analysis under ISIC design environment ('EMI-Noise Analysis under ASIC Designs Environment' ISPD&99, pp16-21). This technique retrieves events from the result of the gate level simulation using a test vector, estimates a current waveform, and performs FFT to analyze the frequency. That is, as shown in Fig. 3, a logic simulation 303 is performed using a Verilog Netlist 301 and a test vector 302. Based on event data 304 produced by the logic simulation and waveform information at time of toggling, a waveform estimation step 305 is executed. An estimated current waveform 307 obtained by the waveform estimation step is subjected to FFT processing to obtain a frequency characteristic. This method can increase the processing speed compared with the conventional transistor level EMI analysis.

In the logic simulator, however, the power supply and ground are generally treated as ideal potentials with no variations, so the influences of decoupling by resistance, capacitance and inductance of the power supply and ground cannot be reflected on the power supply current calculation. If the influences of decoupling is to be considered, it is necessary to perform a transient analysis on the network of power supply and ground including the parasitic devices such as resistance, capacitance and inductance and on the current value of each device calculated by the logic simulation, significantly increasing the time required for processing.

Furthermore, increases in the chip scale and the number of devices have enlarged the network of power supply lines and thus an increased processing time is becoming a significant obstacle in the EMI analysis. Although a means for reducing the resistance and capacitance of the power supply line has been proposed to reduce the processing time, it is only applicable to a gate array in which the power supply lines are structured in a grid.

If the EMI analysis is made by Fourier-transforming the power supply current value, the FFT characteristic needs to be judged by a designer. With this means, identifying the cause either takes very long or is impossible to perform. Another drawback is that the analysis information provided by this means is not sufficient to be directly reflected on the correction.

As described above, the conventional EMI analysis method for LSI cannot be considered satisfactory in terms of coping with both two conditions -- considering the decoupling by resistance, capacitance and inductance of the power supply and ground and increasing the processing speed -- and also in terms of quickly reflecting the EMI analysis result on the design.

Although the conventional method using the transistor level current analysis technique can be expected to provide a certain level of analysis precision, as described above, because the transistor level current analysis uses a transient analysis simulator as represented by the SPICE, the size of a circuit to be analyzed is limited and the processing takes very long. As the semiconductor integrated circuit increases in size in recent years, it is desired to establish an EMI analysis method that uses a gate level current analysis technique capable of high speed processing with a higher abstraction degree than the transistor level.

Gate level current analysis techniques have already been proposed, but they have the following problems. If the power supply and ground are treated as ideal potentials with no variations, the decoupling effect cannot be taken into account. Another problem is that performing the transient analysis on the power supply and ground network including parasitic devices in order to reflect the decoupling effect increases the analysis time.

A further drawback of the conventional gate level current analysis techniques is that if the EMI analysis is done, the cause of EMI cannot be identified leaving unanswered the question of which circuit should be modified for the improvement of EMI.

This invention has been accomplished under these circumstances to provide an EMI analyzing method and apparatus that can evaluate EMI of LSIs in the simulation in a realistic time by reflecting the influence of decoupling by resistance, capacitance and inductance of the power and ground on the power supply current calculation while executing the analysis at high speed.

It is also an object of this invention to provide an efficient measure that enables identification of EMI originating locations.

[1) Analyzing Function in EMI analysis of LSI]

The first invention is a method of analyzing the amount of electromagnetic interference of LSI by executing a logic simulation, the method including the steps of: allocating a discrete FFT analysis frequency width in each frequency range and performing modeling; and performing high-speed Fourier transform processing on current change information calculated by the modeling step.

In performing the EMI analysis on LSI, the second invention is characterized to have a means for specifying a frequency range in which a discrete FFT analysis frequency width is to be changed, and a means for allocating different discrete FFT analysis frequency widths to the specified frequency range and to a frequency range other than the specified frequency range and performing the FFT analysis.

With this configuration, the FFT result can be obtained at a higher speed and with a smaller memory while maintaining the precision of the frequency at which the current frequency component becomes large. Thus, it is possible to obtain a highly precise analysis result particularly in a synchronizing circuit where the influence of noise is determined by cyclic repetitions.

The third invention is a method of analyzing the amount of electromagnetic interference by executing a logic simulation, and is characterized to have a step of calculating a current frequency component simultaneously with the calculation at each point in time of a current of a circuit to be analyzed for electromagnetic interference.

This invention has an advantage that the memory required for the current calculation buffer can be saved although the processing takes longer than in the conventional method.

The fourth invention is a method of analyzing the amount of electromagnetic interference by executing a logic simulation and is characterized to include a step of calculating a current frequency component for a time interval each time the current calculation is performed for that time interval, the time interval being less than a time range of an object to be analyzed, and then calculating current frequency components for the entire time range of the object based on the calculated current frequency component.

This configuration provides an advantage that the memory required for the current calculation buffer can be saved, making it possible to produce the FFT result at a higher speed and with a smaller memory than in the conventional method while maintaining the frequency precision over the entire frequency range. At the same time, because the amount of memory required for the current calculation buffer can be predicted in advance, a highly precise, stable operation can be assured particularly in a synchronizing circuit in which the influence of noise is determined by cyclic repetitions.

This method, when combined with the first method, can produce the FFT result with a still higher speed and with a smaller amount memory.

The fifth invention is a method of analyzing the amount of electromagnetic interference by executing a logic simulation, and is characterized to include: a current frequency component storage step for calculating and storing a current frequency component; and a step for checking whether the calculated current frequency component exceeds a predetermined threshold and excluding those calculated current frequency components less than this threshold from an object group that is to be stored by the current frequency component storage step.

This configuration provides an advantage that the FFT result can be obtained with a smaller amount of memory and that the memory saving level becomes high particularly in a circuit that has a limited number of frequencies for which the current frequency component is large.

This method, when combined with the first, second and third methods, can produce the FFT result at a faster speed and with a smaller amount of memory.

The sixth invention is a method of analyzing the amount of electromagnetic interference by executing a logic simulation, and is characterized to have: a current frequency component storage step; and a current frequency component calculation step for calculating only a predetermined number of current frequency component values in the order of magnitude and storing them in the current frequency component storage means.

This configuration provides an advantage that because the FFT result can be obtained with a smaller amount of memory and because the amount of memory required for the FFT result information can be predicted in advance, a stable operation is assured particularly in a circuit that can limit the number of frequencies for which the current frequency component is large.

This method, when combined with the first, second, third and fourth methods, can produce the FFT result at a faster speed and with a smaller amount of memory.

The seventh invention is a method of analyzing the amount of electromagnetic interference by executing a logic simulation, and is characterized by calculating a current frequency component for only a predetermined circuit portion in a network to be analyzed.

This configuration provides an advantage of being able to further increase the processing speed and facilitate the estimation of a noise causing location.

This method, when combined with the first, second, third, fourth, fifth and sixth methods, can produce the FFT result at a faster speed and with a smaller amount of memory and facilitate the estimation of a noise causing location.

The eighth invention is a method of analyzing the amount of electromagnetic interference by executing a logic simulation, and is characterized to include a step of calculating a current frequency component for only those circuit portions in an object network having one or more circuit portions whose currents are estimated to exceed a predetermined threshold.

This configuration provides an advantage that the amount of current calculation and FFT can be reduced, increasing the processing speed, and that the areas of large current flows that may cause noise can be limited, facilitating the estimation of the EMI locations.

This method, when combined with first, second, third, fourth, fifth, sixth and seventh methods, can produce the FFT result at a faster speed and with a smaller amount of memory and facilitate the estimation of a noise causing location.

The ninth invention is a method of analyzing the amount of electromagnetic interference by executing a logic simulation, and is characterized to include a step of calculating a current frequency component for only a predetermined number of circuit portions that are selected in the order of estimated current magnitude from an object network having two or more circuit portions.

This configuration provides an advantage that the amount of current calculation and FFT can be reduced increasing the processing speed, that the areas of large current flows that may cause noise can be limited facilitating the identifying of EMI causing locations, and that because the amount of memory required for the current calculation can be predicted in advance, a stable operation can be assured in a circuit that can limit the number of circuit devices having large current flows.

This method, when combined with the first, second, third, fourth, fifth, sixth, seventh and eighth methods, can produce the FFT result at a faster speed and with a smaller amount of memory and facilitate the estimation of a noise causing location.

The 10th invention is a method of analyzing the amount of electromagnetic interference by executing a logic simulation, and is characterized to include: a step of calculating a current frequency component for only those circuit portions in an object network having one or more circuit portions whose logic change numbers exceed a predetermined threshold.

This configuration provides an advantage that because the calculation load saving can be determined at a stage of logic change calculation, the amount of current calculation and FFT can be reduced, increasing the processing speed, and the locations with large logic change numbers, which may cause noise, can be limited, facilitating the estimation of the EMI causing locations.

This method, when combined with first, second, third, fourth, fifth, sixth, seventh, eighth and ninth methods, can produce the FFT at a faster speed and with a smaller amount of memory and facilitate the estimation of a noise causing location.

The 11th invention is a method of analyzing the amount of electromagnetic interference by executing a logic simulation, and is characterized to include a step of calculating a circuit frequency component for only a predetermined number of circuit portions that are selected in the order of logic change number from an object network having one or more circuit portions.

This configuration provides an advantage that because the calculation load saving can be determined at a stage of logic change calculation, the amount of current calculation and FFT can be reduced, the processing speed can be increased and the locations with large logic change numbers, which may cause noise, can be limited, facilitating the estimation of the EMI causing locations. Another advantage is that because the amount of memory required for the current calculation can be predicted in advance, a stable operation is assured particularly in a circuit that can limit the number of circuit devices with large logic change numbers.

This method, when combined with first, second, third, fourth, fifth, sixth, seventh, eighth, ninth and 10th methods, can produce the FFT result at a faster speed and with a smaller amount of memory and facilitate the estimation of a noise causing location.

The 12th invention is a method of analyzing the amount of electromagnetic interference by executing a logic simulation, and is characterized to have: a step of estimating from network information the number of logic changes in an object network; and a step of calculating a current frequency component for those circuit portions that are selected based on the number of logic changes from the object circuit having one or more circuit portions.

This configuration provides an advantage that because the calculation load saving can be determined at a stage preceding the logic change calculation to reduce the amount of logic change calculation, current calculation and FFT, compared with the conventional method, the processing speed can be increased and the locations with large logic change numbers, which may cause noise, can be limited, facilitating the estimation of the EMI causing locations.

This method, when combined with first, second, third, fourth, fifth, sixth, seventh and eighth methods, can produce the FFT result at a faster speed and with a smaller amount of memory and facilitate the estimation of a noise causing location.

[2) User interface in the EMI analysis for LSIs]

The 13th invention is an apparatus for analyzing the amount of electromagnetic interference by executing a logic simulation, the apparatus having a means as a user interface for identifying, from a result of performing FFT on a current waveform for each instance, an instance name which mainly causes noise in an associated frequency component with large noise.

This configuration provides an advantage of being able to identify a noise affecting location by an instance for each circuit device.

The 14th invention is an apparatus for analyzing the amount of electromagnetic interference by executing a logic simulation, the apparatus including a means as a user interface for identifying, from a result of performing FFT on current waveforms for each instance group consisting of one or more instances, an instance group which mainly causes noise in an associated frequency component with large noise.

This configuration provides an advantage that because a noise affecting location is identified by a block of one or more instances, a problematic location can be identified speedily and macroscopically in a top-down manner at the preceding stage of the 13th invention where the instance name as the main cause of noise is identified for each frequency component with large noise.

The 15th invention is an apparatus for analyzing the amount of electromagnetic interference by executing a logic simulation, the apparatus having a means as a user interface for grouping instances according to flag information written in library or for grouping them into instance groups of registers, combined circuits and memories.

This configuration has a means for identifying a noise affecting location for each instance group of, say, registers, combined circuits and memories and thus has an advantage of being able to provide information necessary for a designer to make improvements at an architecture level.

The 16th invention is an apparatus for analyzing the amount of electromagnetic interference by executing a logic simulation, the apparatus having a means for grouping instances according to whether the instances belong to a clock tree connected to each clock input terminal.

This configuration has a means for identifying a noise affecting location for each clock tree group. With this means it is possible to check how the clock portion, which greatly influences an electric power, affects noise. This invention has an advantage of being effective for a designer to make improvements in the clock control.

The 17th invention is an apparatus for analyzing the amount of electromagnetic interference by executing a logic simulation, the apparatus having a means as a user interface for grouping instances according to a result of identifying the timing at which status changes occur simultaneously or in a predetermined time duration.

This configuration has a means for identifying a noise affecting location for each group of instances that change simultaneously (within a specified length of time) . With this means, it is possible to check how the location where signals change simultaneously affects noise. This invention thus has an advantage of being effective for a designer to make improvements in the signal control.

The 18th invention is an electromagnetic interference analysis apparatus for analyzing the amount of electromagnetic interference by executing a logic simulation, the apparatus having a means as a user interface for identifying, from the instance grouping information produced in the 15th to 17th invention, an instance name which mainly causes noise in an associated frequency component with large noise and then reporting information on noise level.

With this configuration it is possible to identify the noise affecting location at an instance level, not in a block consisting of two or more instances.

(With this invention it is possible to identify a noise affecting location in a block of registers, combined circuits and memories in the case of embodiment 14, a noise affecting location in a clock tree connected to the clock input terminal in the case of embodiment 15, and a noise affecting location where simultaneous status changes occur in the case of embodiment 16.)

Further, this invention has an advantage of being able to display the locations where noise of each current frequency component is large by relating them to the netlist and to display such locations in connection with the position information on layout by replacing the netlist information with the corresponding layout information.

The 19th invention is an apparatus for analyzing the amount of electromagnetic interference by executing a logic simulation, the apparatus having a means as a user interface for performing FFT only on a predetermined frequency.

This configuration provides an advantage of being able to locate more quickly a noise causing location that affects a particular frequency. This invention is effective where a frequency to be analyzed is predetermined as in the cause locating stage after the one-chip FFT analysis has been performed.

[3) Method for considering power supply wires in the EMI analysis for LSIs]

The 20th invention is a method of analyzing the amount of electromagnetic interference of LSI by executing a logic simulation, the method including a current waveform correction step, the current waveform correction step comprising: a step of calculating an equivalent resistance and an equivalent capacitance of an entire chip from a resistance and a capacitance of a power supply circuit of the chip that were determined by performing LPE based on layout data, and calculating a correction coefficient; and a step of correcting, by using the correction coefficient, an event-based model of an estimated current waveform obtained in advance as an ideal power supply.

This invention, because it does not use the transient analysis, provides an advantage of being able to reflect the influence of decoupling on the power supply current value while virtually maintaining the high speed of the gate level power supply current analysis.

The 21st invention is an electromagnetic interference analysis method according to claim 20, wherein the correction coefficient calculation step includes a step of calculating the equivalent resistance and equivalent capacitance of the entire chip from information on resistance and capacitance of a power supply circuit of the chip and calculating the correction coefficient by performing processing according to a table prepared in advance.

This configuration provides an advantage of being able to reflect the influence of power supply wires decoupling on the power supply current value by calculating a table in advance while virtually maintaining the high speed of the gate level power supply current analysis and is particularly effective when the amount of information used in calculating the correction coefficient is large.

The 22nd invention is an electromagnetic interference analysis method according to claim 20, wherein the correction coefficient calculation step includes a step of calculating the equivalent resistance and equivalent capacitance of the entire chip from information on resistance and capacitance of a power supply circuit of the chip and calculating the correction coefficient by performing processing according to a mathematical expression prepared in advance. Another advantage is that because the amount of data is small, this invention is effective when statistical variations are small or when a variation portion in the mathematical expression is small.

This configuration provides an advantage of being able to reflect the influence of decoupling on the power supply current value by calculating a mathematical expression in advance while virtually maintaining the high speed of the gate level power supply current analysis. By selecting between the mathematical expression and the table according to the characteristic of information, it is possible to optimize the processing time and the amount of data.

The 23rd invention is an electromagnetic interference analysis method according to claim 20, wherein the current waveform correction step includes a step of correcting a base of the event-based model of the estimated current waveform obtained as an ideal power supply.

This configuration provides an advantage of being able to reflect a dullness of instantaneous current due to influence of power supply RC component on the power supply current waveform by correcting the base of the event-based model of the current waveform estimated as an ideal power supply to optimize the base of the current waveform.

The 24th invention is an electromagnetic interference analysis method according to claim 20, wherein the current waveform correction step includes a step of correcting an area of the event-based model of the estimated current waveform obtained as an ideal power supply.

This configuration provides an advantage of being able to reflect the influence of a power supply voltage drop (IR drop) due to a power supply RC component on the power supply current waveform by correcting the area of the event-based model of a current waveform estimated as an ideal current to optimize the area of the current waveform.

The 25th invention is an electromagnetic interference analysis method according to claim 20, wherein the correction coefficient calculation step includes a step of estimating the equivalent resistance of the chip from the resistance information of the power supply circuit by using shape information of the power supply circuit and then performing the correction coefficient calculation step at high speed.

This configuration provides an advantage of being able to realize a faster EMI analysis, though with less precision, because there is no need to solve a complex network of power supply resistors when calculating an equivalent resistance of the chip power supply circuit.

The 26th invention is a method of analyzing the amount of electromagnetic interference by executing a logic simulation, the method having: a step of estimating an equivalent resistance and an equivalent capacitance of a power supply circuit of a chip at a floorplan stage; a step of calculating a correction coefficient from the information on the equivalent resistance and equivalent capacitance; and a step of correcting an event-based model of an estimated current waveform obtained in advance as an ideal power supply.

This configuration provides an advantage of being able to reflect the influence of power supply wires on the power supply current value at an early design stage without having to wait for the completion of layout.

The 27th invention is an electromagnetic interference analysis method according to claim 26, wherein the step of estimating the equivalent resistance and equivalent capacitance of the power supply circuit includes a step of estimating the resistance and capacitance of the power supply circuit by considering an area of the chip.

This configuration provides an advantage of being able to realize the EMI analysis that considers the influence of power supply wires with high precision at an early design stage by using the chip area information.

The 28th invention is an electromagnetic interference analysis method according to claim 26, wherein the step of estimating the equivalent resistance and equivalent capacitance of the power supply circuit further includes a step of estimating the resistance and capacitance of the power supply circuit by further considering technology information.

This configuration provides an advantage of being able to realize the EMI analysis that considers the influence of power supply wires with high precision at an early design stage by using the technology information. Another advantage is that there is no need to prepare database for each technology.

The 29th invention is an electromagnetic interference analysis method according to claim 27, wherein the step of estimating the equivalent resistance and equivalent capacitance of the power supply circuit further includes a step of estimating the resistance and capacitance of the power supply circuit by considering a chip shape and a power supply pad position.

This configuration provides an advantage of being able to realize the EMI analysis that considers the influence of power supply wires with a still higher precision at an early design stage by using information on chip shape and power supply pad position.

The 30th invention is an electromagnetic interference analysis method according to claim 27, wherein the step of estimating the equivalent resistance and equivalent capacitance of the power supply circuit further includes a step of estimating the resistance and capacitance of the power supply circuit by considering the number of power supply pads.

With this configuration it is possible to realize the EMI analysis that considers the influence of power supply wires with high precision at an early design stage by using the information on the number of power supply pads. It is also possible to optimize the number of power supply pads with respect to EMI at a floorplan stage.

The 31st invention is an electromagnetic interference analysis method according to claim 27, wherein the step of estimating the equivalent resistance and equivalent capacitance of the power supply circuit further includes a step of estimating the resistance and capacitance of the power supply circuit by considering information on a width of the power supply wire making up the chip.

This configuration provides an advantage of being able to realize the EMI analysis that considers the influence of power supply wires with high precision at an early design stage by using the width information of the power supply wires making up the chip. Another advantage is that the optimization of the power supply wire width with respect to EMI can be made at a floorplan stage.

The 32nd invention is an electromagnetic interference analysis method according to claim 27, wherein the step of estimating the equivalent resistance and equivalent capacitance of the power supply circuit further includes a step of estimating the resistance and capacitance of the power supply circuit by considering a capacitance generation area under the power supply wire.

This configuration provides an advantage of being able to realize the EMI analysis that considers the influence of power supply wires with high precision at an early design stage by using the information on capacitance generation areas under the power supply wires. Another advantage is that the optimization of the capacitance generation with respect to EMI can be made at a floorplan stage.

The 33rd invention is an electromagnetic interference analysis method according to any one of claims 20 to 25, wherein as a method of considering the power supply wire for each module in a post-layout electromagnetic interference analysis, an equivalent resistance and an equivalent capacitance for each module, rather than for the entire chip, are calculated and a correction coefficient for each module is calculated to make corrections to the estimated current waveform more precisely for each module.

With this configuration it is possible to reflect the possible influence of power supply wires including decoupling capacitances on the power supply current value at each early design stage, while virtually maintaining the high speed of the gate level power supply current analysis. Further, by calculating the equivalent resistance and equivalent capacitance for each module rather than for the entire chip and by calculating the correction coefficient for each module, more precise corrections can be made to the estimated current waveform for the individual modules. Another advantage is that when performing the FFT analysis for each module, the highly precise EMI analysis for each module can be realized by storing and using for the FFT analysis the module-based current model that was corrected for each module.

The 34th invention is an electromagnetic interference analysis method according to any one of claims 26 to 32, wherein as a method of considering the power supply wire for each module in a pre-layout electromagnetic interference analysis, the current waveform correction step includes a step of estimating an equivalent resistance and an equivalent capacitance for each module, rather than for the entire chip, by considering information on a position of each module making up the chip and information on a kind of each module and calculating a correction coefficient for each module to make corrections to the estimated current waveform more precisely for each module.

This configuration provides an advantage of being able to correct the estimated current waveform precisely for individual modules.

The 35th invention is an electromagnetic interference analysis method according to any one of claims 26 to 32 and claim 34 which adopts the current waveform correction means of claims 21 to 24.

This configuration provides an advantage of being able to correct various power supply current waveforms at a pre-layout stage.

The 36th invention is an electromagnetic interference analysis method according to any one of claims 20 to 35, wherein a method of considering an inductance component of a power supply wire in the electromagnetic interference analysis involves calculating from package information of the chip an inductance component corresponding to the power supply lead portion and the power supply wire bonding portion and using it as a third element following the resistance and capacitance.

This configuration provides an advantage of being able to make a highly precise current correction considering the inductance component of the chip package.

The 37th invention is an electromagnetic interference analysis method according to any one of claims 20 to 36, wherein as a method of considering an influence of a power supply wire on the current waveform obtained as an ideal power supply in the electromagnetic interference analysis, the current waveform correction step includes a step of correcting the current waveform obtained as an ideal power supply that is to be analyzed for electromagnetic interference, instead of correcting an event-based model of the estimated current waveform.

With this configuration, since the power supply current waveform obtained as an ideal power supply for the chip or module is corrected, it is possible to perform the processing up to the stage of calculating the power supply current for the chip or module. By initiating the processing before the completion of the layout or before the floorplan stage, the TAT of the EMI analysis as a whole can be shortened. Further, this invention can adopt a technique of correcting the current waveform to consider the influence of power supply wires also in the transistor level EMI analysis.

Particular embodiments of the invention will now be described with reference to the accompanying drawings; in which:-

A block diagram showing a conceptual configuration for implementing the EMI analysis method of this invention.

[Fig. 2]

A block diagram showing a conceptual configuration for implementing a conventional transistor level EMI analysis method.

[Fig. 3]

A block diagram showing a conceptual configuration for implementing a conventional gate level EMI analysis method.

[Fig. 4]

A block diagram showing a configuration for implementing a conventional EMI analysis method centering on an FFT calculation unit.

[Fig. 5]

A diagram showing an example of data contained in an FFT result storage means used in the conventional method and in the second and third embodiments.

[Fig. 6]

A block diagram showing a configuration for implementing the EMI analysis method according to a first embodiment of this invention.

[Fig. 7]

A diagram showing an example of data contained in a detailed frequency storage means in the first embodiment of this invention.

[Fig. 8]

A diagram showing an example of data contained in a power supply current storage means in the first embodiment of this invention.

[Fig. 9]

A diagram showing an example of data contained in an FFT result storage means in the first embodiment of this invention.

[Fig. 10]

A flow chart of an FFT analysis in the first embodiment of this invention.

[Fig. 11]

A block diagram showing a configuration for implementing the EMI analysis method according to a second embodiment of this invention.

[Fig. 12]

A diagram showing an example of data contained in a netlist storage means in the first embodiment of this invention.

[Fig. 13]

A diagram showing an example of data contained in a test vector storage means in the second, third, sixth, seventh and eighth embodiments of this invention.

[Fig. 14]

A diagram showing an example of data contained in an FFT result storage means in the sixth, seventh, eighth, ninth, 10th and 11th embodiments of this invention.

[Fig. 15]

A flow chart of a current FFT analysis in the second embodiment of this invention.

[Fig. 16]

A block diagram showing a configuration for implementing the EMI analysis method according to a third embodiment of this invention.

[Fig. 17]

A diagram showing an example of data contained in a power supply current storage means in the third embodiment of this invention.

[Fig. 18]

A flow chart of an FFT analysis in the third embodiment of this invention.

[Fig. 19]

A block diagram showing a configuration for implementing the EMI analysis method according to a fourth embodiment of this invention.

[Fig. 20]

A diagram showing an example of data contained in an FFT result storage means in the fourth embodiment of this invention.

[Fig. 21]

A flow chart of an FFT analysis in the fourth embodiment of this invention.

[Fig. 22]

A block diagram showing a configuration for implementing the EMI analysis method according to a fifth embodiment of this invention.

[Fig. 23]

A diagram showing an example of data contained in an FFT result storage means in the fifth embodiment of this invention.

[Fig. 24]

A flow chart of an FFT analysis in the fifth embodiment of this invention.

[Fig. 25]

A diagram showing an example of data contained in a netlist storage means in the sixth, seventh and eighth embodiments of this invention.

[Fig. 26]

A diagram showing an example of data contained in an EMI analysis object information storage means in the sixth embodiment of this invention.

[Fig. 27]

A block diagram showing a configuration for implementing the EMI analysis method according to a sixth embodiment of this invention.

[Fig. 28]

A flow chart of a current FFT analysis in the sixth embodiment of this invention.

[Fig. 29]

A block diagram showing a configuration for implementing the EMI analysis method according to a seventh embodiment of this invention.

[Fig. 30]

A flow chart of a current FFT analysis in the seventh embodiment of this invention.

[Fig. 31]

A block diagram showing a configuration for implementing the EMI analysis method according to an eighth embodiment of this invention.

[Fig. 32]

A flow chart of a current FFT analysis in the eighth embodiment of this invention.

[Fig. 33]

A block diagram showing a configuration for implementing the EMI analysis method according to a ninth embodiment of this invention.

[Fig. 34]

A diagram showing an example of data contained in a netlist storage means in the ninth, 10th and 11th embodiments of this invention.

[Fig. 35]

A diagram showing an example of data contained in a test vector storage means in the ninth, 10th and 11th embodiments of this invention.

[Fig. 36]

A diagram showing an example of data contained in a logic change storage means in the ninth and 10th embodiments of this invention.

[Fig. 37]

A flow chart of a current FFT analysis in the ninth embodiment of this invention.

[Fig. 38]

A block diagram showing a configuration for implementing the EMI analysis method according to a 10th embodiment of this invention.

[Fig. 39]

A flow chart of a current FFT analysis in the 10th embodiment of this invention.

[Fig. 40]

A block diagram showing a configuration for implementing the EMI analysis method according to an 11th embodiment of this invention.

[Fig. 41]

A flow chart of a current FFT analysis in the 11th embodiment of this invention.

[Fig. 42]

A block diagram showing a configuration for implementing the EMI analysis method according to a 12th and 13th embodiments of this invention.

[Fig. 43]

A diagram showing an example of data contained in an FFT result storage means in the 12th embodiment of this invention.

[Fig. 44]

A diagram showing an example of data contained in a sort result storage means in the 12th embodiment of this invention.

[Fig. 45]

A flow chart of an FFT sort means in the 12th embodiment of this invention.

[Fig. 46]

A diagram showing an example of data contained in an FFT result storage means in the 13th embodiment of this invention.

[Fig. 47]

A diagram showing an example of data contained in a sort result storage means in the 13th embodiment of this invention.

[Fig. 48]

A flow chart of an FFT sort means in the 13th embodiment of this invention.

[Fig. 49]

A block diagram showing a configuration for implementing the EMI analysis method according to a 14th embodiment of this invention.

[Fig. 50]

A diagram showing an example of data contained in an instance-based current information storage means in the 14th embodiment of this invention.

[Fig. 51]

A diagram showing an example of data contained in grouping information in the 14th embodiment of this invention.

[Fig. 52]

A diagram showing an example of data contained in a group-based current information storage means in the 14th embodiment of this invention.

[Fig. 53]

A diagram showing an example of data contained in a group-instance correspondence information storage means in the 14th embodiment of this invention.

[Fig. 54]

A flow chart of an instance grouping means in the 14th embodiment of this invention.

[Fig. 55]

Ablock diagram showing a configuration for implementing the EMI analysis method according to 15th and 16th embodiments of this invention.

[Fig. 56]

A diagram showing an example of data contained in grouping information in the 15th embodiment of this invention.

[Fig. 57]

A flow chart of an instance grouping means in the 15th embodiment of this invention.

[Fig. 58]

A diagram showing an example of data contained in a netlist information storage means in the 15th embodiment of this invention.

[Fig. 59]

A flow chart of an instance grouping means in the 16th embodiment of this invention.

[Fig. 60]

A diagram showing an example of data contained in a netlist information storage means in the 16th embodiment of this invention.

[Fig. 61]

A block diagram showing a configuration for implementing the EMI analysis method according to 17th embodiment of this invention.

[Fig. 62]

A block diagram showing a configuration for implementing the EMI analysis method according to 18th embodiment of this invention.

[Fig. 63]

A diagram showing a chip power supply current in 19th to 23rd embodiments of this invention.

[Fig. 64]

A block diagram showing a configuration for implementing the EMI analysis method according to 19th to 23rd embodiments of this invention.

[Fig. 65]

A diagram showing an example of data contained in a resistance storage means in the 19th to 23rd embodiments of this invention.

[Fig. 66]

A diagram showing an example of data contained in a capacitance storage means in the 19th to 23rd embodiments of this invention.

[Fig. 67]

A diagram showing an example of data contained in a current waveform storage means in the 19th to 23rd embodiments of this invention.

[Fig. 68]

A diagram showing an example of data contained in a power supply wire dependence information storage means in the 19th to 23rd embodiments of this invention.

[Fig. 69]

A flow chart of an current waveform correction means in the 19th to 23rd embodiments of this invention.

[Fig. 70]

A conceptual diagram showing a current waveform correction means in the 19th to 23rd embodiments of this invention.

[Fig. 71]

A conceptual diagram showing a table calculation method in a 20th embodiment of this invention.

[Fig. 72]

A conceptual diagram showing an equivalent capacitance and equivalent resistance calculation method in the 20th embodiment of this invention.

[Fig. 73]

A conceptual diagram showing a current waveform correction means in a 22nd embodiment of this invention.

[Fig. 74]

A conceptual diagram showing a current waveform correction means in a 23rd embodiment of this invention.

[Fig. 75]

A block diagram showing a configuration for implementing the EMI analysis method according to 24th embodiment of this invention.

[Fig. 76]

A flow chart of a current waveform correction means in the 24th embodiment of this invention.

[Fig. 77]

A block diagram showing a configuration for implementing the EMI analysis method according to 25th to 31st embodiments of this invention.

[Fig. 78]

A flow chart of a current waveform correction means in the 25th to 31rst embodiments of this invention.

[Fig. 79]

A block diagram showing a configuration for implementing the EMI analysis method according to 25th to 31st embodiments of this invention.

[Fig. 80]

A flow chart of an equivalent resistance estimation means in the 25th to 31rst embodiments of this invention.

[Fig. 81]

A diagram showing an example of data contained in a database storage means in the 25th to 31rst embodiments of this invention.

[Fig. 82]

A schematic illustration of a database chip in the 25th to 31rst embodiments of this invention.

[Fig. 83]

A diagram showing an example of data contained in a power supply wire width information storage means in the 25th to 31rst embodiments of this invention.

[Fig. 84]

A schematic illustration of a chip to be subjected to the power supply waveform correction in the 25th to 31rst embodiments of this invention.

[Fig. 85]

A diagram showing an area dependency of an equivalent resistance and an equivalent capacitance in a 26th embodiment of this invention.

[Fig. 86]

A diagram showing a dependency of an equivalent resistance on the chip shape and the power supply pad position in a 28th embodiment of this invention.

[Fig. 87]

A schematic illustration showing resistance components of a power supply circuit in the 28th embodiment of this invention.

[Fig. 88]

A diagram showing a dependency of an equivalent resistance on the number of power supply pads in a 29th embodiment of this invention.

[Fig. 89]

A diagram showing a dependency of an equivalent resistance on a power supply wire width in a 30th embodiment of this invention.

[Fig. 90]

A diagram showing a dependency of an equivalent capacitance on a power supply wire width in the 30th embodiment of this invention.

    101: Power supply-considered calculation unit
    106: FFT calculation unit
    107: Input/output calculation unit
    104: External storage device
    103: Input device
    105: Output device

Now embodiments of the EMI analyzing method according to this invention will be described.

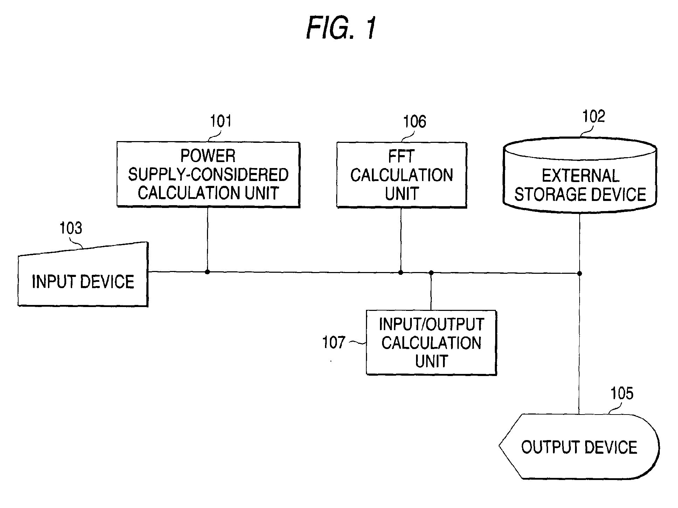

Fig. 1 shows one embodiment of the EMI analyzing apparatus to implement the EMI analyzing method of this invention.

The EMI analyzing apparatus has a computer system that comprises: a power supply-considered calculation unit 101 that performs steps as its constitutional elements associated with the calculation that considers the power supply; an FFT calculation unit 106 that performs steps as its constitutional elements associated with the frequency conversion FFT; an input/output calculation unit 107 that performs steps as its constitutional elements associated with the user interface calculation; an input device 103 such as keyboard; an external storage device 104 such as memory device and disk device; and an output device 105 such as display. The power supply-considered calculation unit 101, the FFT calculation unit 106 and the input/output calculation unit 107 may each be used solely or in mutual link with one another, or may also be used in combination with the content of other calculation units than those described in this invention.

For a network to be evaluated, the FFT calculation unit 106 calculates the power supply current described later, performs the FFT calculation, and calculates the amount of EMI noise (current frequency component) produced as a result of variations of the power supply current. The power supply-considered calculation unit 101 makes corrections to the power supply current value and the FFT result calculated by the FFT calculation unit 106 by considering the influences of resistance, capacitance and reactance of the power supply wires . The input/output calculation unit 107 converts the FFT result calculated by the FFT calculation unit 106 to facilitate the EMI analysis.

(First Embodiment)

In the conventional EMI analysis of LSI, the current change that was analyzed by the power supply current transient analysis tool on transistor level is FFT-analyzed. However, because the analysis width of FFT is uniform, a problem arises that more memory is needed to store information and the analysis takes more time.

To cope with this problem, this embodiment is characterized by a frequency analysis technique in which a frequency analysis result prepared in advance and expected to have a peak is analyzed in detail and other portions of the analysis result are analyzed coarsely.

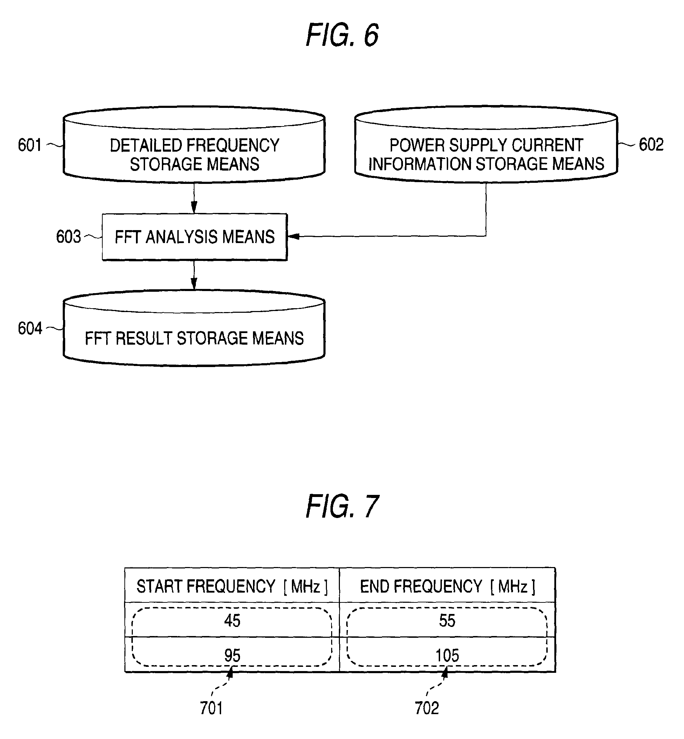

Fig. 6 shows a configuration of the EMI analysis method according to one embodiment of this invention. The EMI analysis method in the figure has a detailed frequency storage means 601, a power supply current information storage means 602, an FFT analysis means 603, and an FFT result storage means 604.

Of these, the detailed frequency storage means 601, the power supply current information storage means 602 and the FFT result storage means 604 are allocated to the external storage device of the computer system described earlier.

The FFT analysis means 603 is stored in the FFT calculation unit of the computer system as a group of programs each having steps as its constitutional elements.

Next, individual elements making up the EMI analysis method of Fig. 6 will be explained. At the same time the procedure of analyzing EMI by using the detailed frequency information of Fig. 7 and the power supply current information of Fig. 8 will also be explained.

The detailed frequency storage means 601 stores in advance detailed frequency information shown in Fig. 7, the information on one or more frequency ranges that need detailed analysis.

The detailed frequency information has information on one or more frequency ranges to be analyzed in detail, each defined by a start frequency 701 and an end frequency 702.

This example shows that a range between 45 MHz and 55 MHz and a range between 95 MHz and 105 MHz are analyzed with a normal, discrete analysis frequency width of 5 MHz and that other ranges, 0-45 MHz, 55-95 MHz and 105 MHz or higher, are analyzed with a coarse, discrete frequency width of 25 MHz. In a synchronizing circuit, an object frequency to be examined particularly closely is specified at around the frequency where the current frequency component becomes large, which is determined by a multiple of clock frequency. The current frequency component means the current valve for each frequency as the result of FFT analysis. It is called "spectrum" usually.

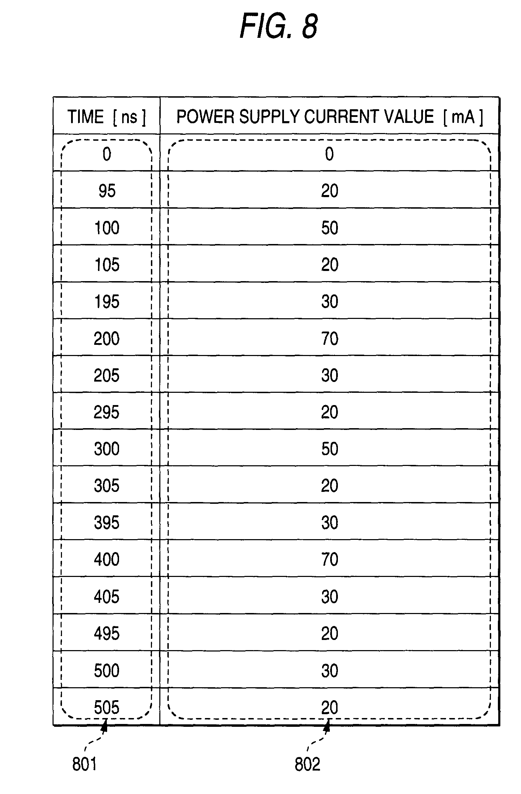

The power supply current information storage means 602 stores the power supply current information on a circuit to be analyzed for EMI, as shown in Fig. 8, that was estimated in advance as by a transistor simulator.

This power supply current information includes one or more sets of power supply current change information for the circuit being analyzed, each of which consists of time 801 and power supply current value 802.

In this example the information shows the estimated result of discrete current changes. For example, a current of 0 mA is estimated to flow for a time duration from 0 ns to 95 ns and 20 mA for a time duration from 95 ns to 100 ns.

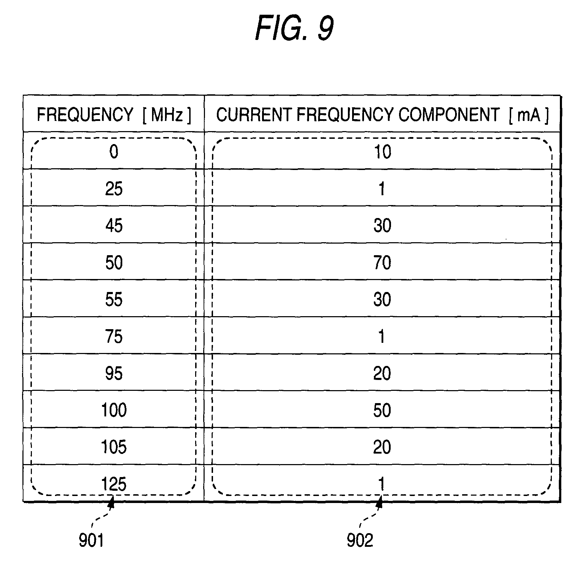

The FFT result storage means 604 stores the FFT result information calculated by the FFT analysis means 603, as shown in Fig. 9.

The FFT result information includes one or more sets of FFT result information for the circuit being analyzed, each of which consists of frequency 901 and current frequency component value 902.

In this example, this information shows the current frequency component values at discrete frequencies, such as a current frequency component value of 10 mA at 0 MHz and 1 mA at 25 MHz.

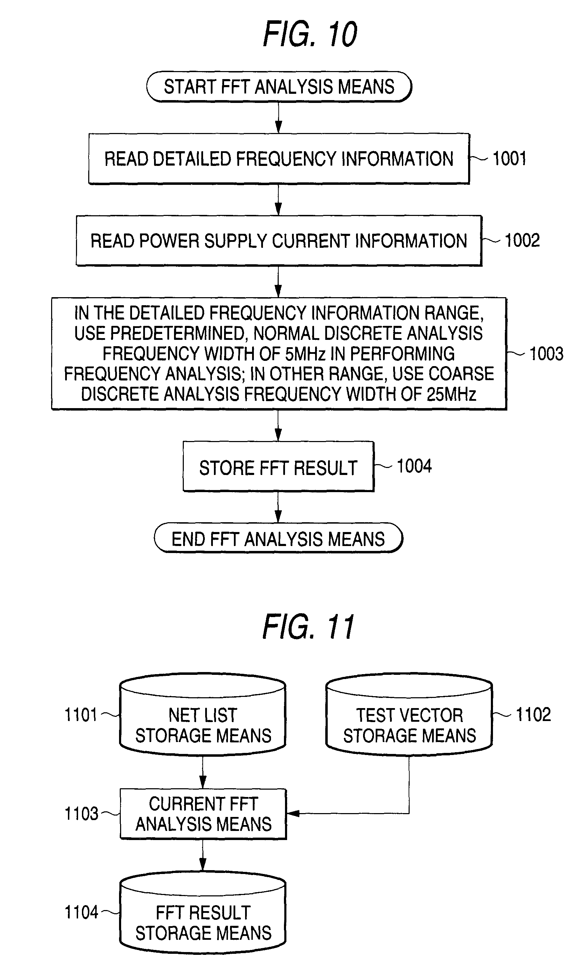

The FFT analysis means 603 executes the analysis operation according to the flow chart of Fig. 10.

Step 1001 reads the detailed frequency information of Fig. 7 stored in the detailed frequency storage means 601.

Step 1002 reads the power supply current information of Fig. 8 stored in the power supply current information storage means 602.

Step 1003 performs the frequency analysis with a predetermined, normal, discrete analysis frequency width of 5 MHz if the frequency is in the range of the detailed frequency information of Fig. 7 and, in other frequency range, performs the frequency analysis with a coarse, discrete frequency width of 25 MHz.

Step 1004 stores the FFT result of Fig. 9 in the FFT result storage means 604.

Then, the FFT result as shown in Fig. 9 is obtained by performing the frequency analysis with the normal discrete analysis frequency width of 5 MHz when the frequency is in the range of 45-55 MHz and 95-105 MHz, and with the coarse discrete analysis frequency width of 25 MHz when it is in other ranges of 0-45 MHz, 55-95 MHz and 105 MHz or higher.

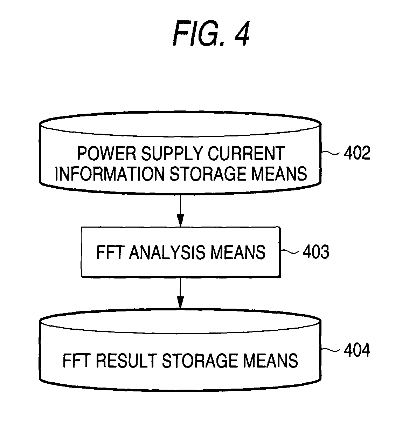

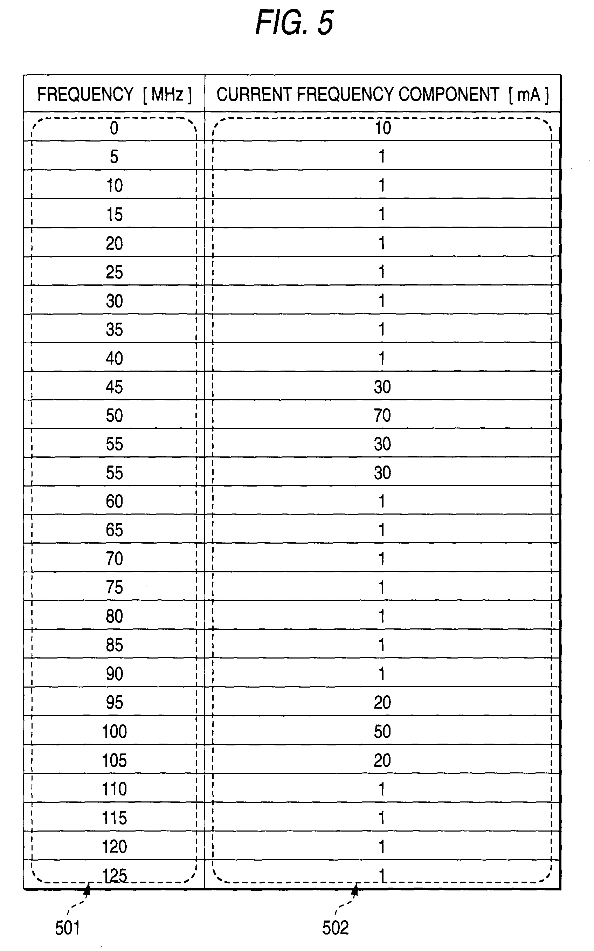

The conventional technique shown in Fig. 4 has no detailed frequency storage means and performs the FFT analysis uniformly with the normal discrete width of 5 MHz. When the power supply current information of Fig. 8 is used, the FFT result occupies a large memory area as shown in Fig. 5 and the amount of calculation performed to implement the FFT also increases.

The method of this embodiment reduces the number of frequency analysis points for those frequencies other than the noise-affecting detailed frequency to reduce the amount of calculations, thereby making it possible to obtain the FFT result at speeds higher than and with a smaller amount of memory than the conventional method while maintaining the precision of the frequency at which the current frequency component is large. This method offers a particularly high precision in a synchronizing circuit in which the magnitude of noise is determined by the cyclic repetition.

(Second Embodiment)

The conventional EMI analysis of LSI is performed by FFT-analyzing the current change that was obtained by using the transient analysis tool for the transistor level power supply current. The conventional method has a problem that because the current change information is stored temporarily in a buffer, a larger amount of memory is needed for storing that information and the analysis takes longer.

To solve this problem this embodiment uses a technique of performing the frequency analysis along with the current calculation. Fig. 11 shows a configuration of a device used for the EMI analysis method according to one embodiment of this invention. This EMI analysis apparatus has a netlist storage means 1101, a test vector storage means 1102, a current FFT analysis means 1103, and an FFT result storage means 1104.

Of these means, the netlist storage means 1101, the test vector storage means 1102 and the FFT result storage means 1104 are allocated to the external storage device of the computer system described earlier.

The current FFT analysis means 1103 is stored in the FFT calculation unit of the computer system as a group of programs each having steps as its constitutional elements.

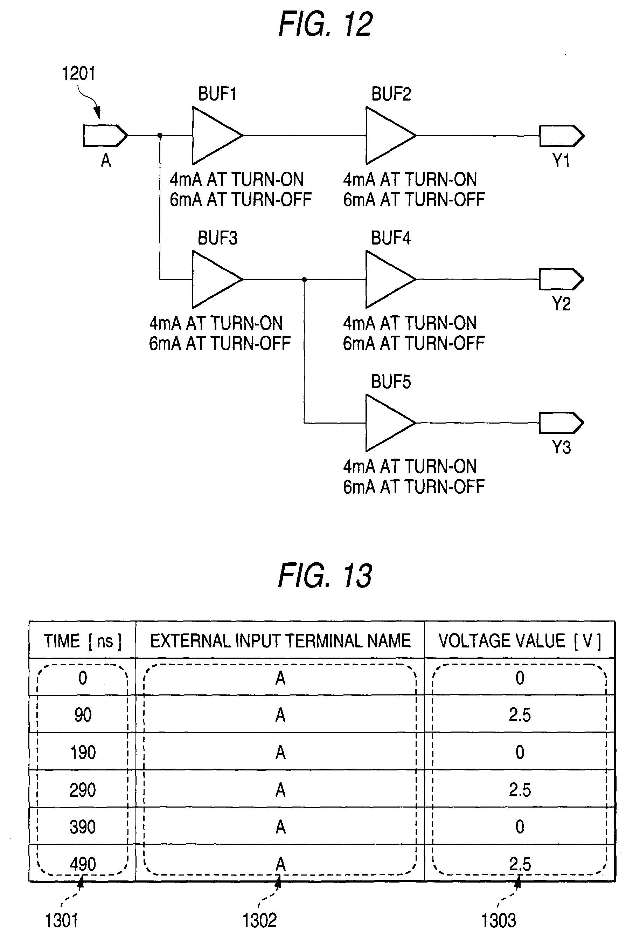

Next, the individual elements of Fig. 11 making up the EMI analysis method will be described. The procedure for analyzing the EMI by using the netlist information shown in Fig. 12 and the test vector information shown in Fig. 13 will also be explained.

The netlist storage means 1101 stores in advance the netlist information on a circuit to be analyzed for EMI, as shown in Fig. 12.

This netlist information comprises connection information of one or more circuit devices, wires and external terminals and information on currents that flow when the associated circuit devices are driven.

In this example, the netlist includes buffers BUF1, BUF2, BUF3, BUF4, BUF5 through which 4 mA flows when they are turned on and 6 mA flows when they are turned off, an external input terminal A, external output terminals Y1, Y2, Y3, and wires connecting these. The test vector storage means 1102 stores in advance the information on test vectors to be applied to the external terminals of a circuit being analyzed, as shown in Fig. 13.

The test vector information comprises a time 1301, an external input terminal name 1302, and voltage information 1303 of external terminal of the object circuit at a point in time.

This example specifies discrete voltage changes. For example, a voltage value of 0 V is applied to the external input terminal A for a duration from 0 ns to 90 ns and a voltage value of 2.5 V for a duration from 90 ns to 190 ns.

The FFT result storage means 1104 , as in the conventional method shown in the first embodiment, stores the FFT result information like the one shown in Fig. 5 calculated by the current FFT analysis means 1103.

The FFT result information has one or more sets of FFT result information on the object circuit, each of which includes a frequency 501 and a current frequency component value 502.

In this example, the FFT result information shows current frequency component values at discrete frequencies, such as a current frequency component value of 10 mA at 0 MHz and 1 mA at 5 MHz.

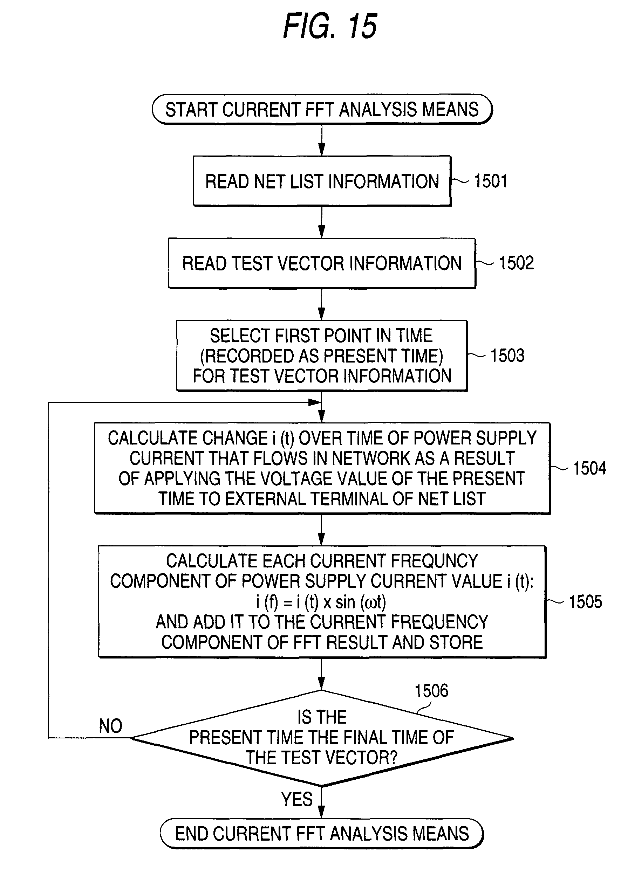

The current FFT analysis means 1103 executes the analysis operation according to the flow chart shown in Fig. 15.

First, step 1501 reads the netlist information of Fig. 12 stored in the netlist storage means 1101.

Next, step 1502 reads the test vector information of Fig. 13 stored in the test vector storage means 1102.

Then, step 1503 selects a first point in time (denoted as present point in time) for the test vector information.

Then, step 1504 to step 1506 are repeated until the processing of a final point in time recorded in the test vector is completed.

Further, step 1504 calculates a change over time i(t) of the power supply current that flows in a network as a result of applying the voltage value at the present point in time to the external terminal of the netlist.

Then, step 1505 calculates each current frequency component $i(t) \times \sin(\omega t)$ for the power supply current value i(t) calculated by the step 1504 and stores the calculated result in the FFT result storage information.

Finally, step 1506 checks whether the present point in time is the final point in time. If not, it returns to step 1504. If the present point in time is the final point in time, it is terminated.

This procedure calculates the current and also the frequency component of the calculated current and therefore can obviate the power supply current information storage means 402 which stores current changes within the analyzing time that are required by the FFT analyzing process although the result obtained is the same as the one shown in Fig. 5 produced by the conventional method of Fig. 4.

It is however noted that, unlike the FFT, the frequency component calculation method has an additional step of calculating $i(t) \times \sin(\omega t)$ and therefore the processing speed itself becomes slightly slower.

With the above method, by calculating the power supply current and the current frequency component at the same time, it is possible to save the memory required for the current calculation buffer although the processing takes longer than the conventional method.

(Third Embodiment)

The conventional EMI analysis method for LSI is done by FFT-analyzing the current changes that were obtained at one time for the entire analysis time span by using the transistor level power supply current transient analysis tool. This method has a problem that because the current change information is stored temporarily in the buffer, a memory for storing the information is needed.

To solve this problem this embodiment adopts a technique that performs the frequency analysis along with the current calculation for each predetermined time interval.

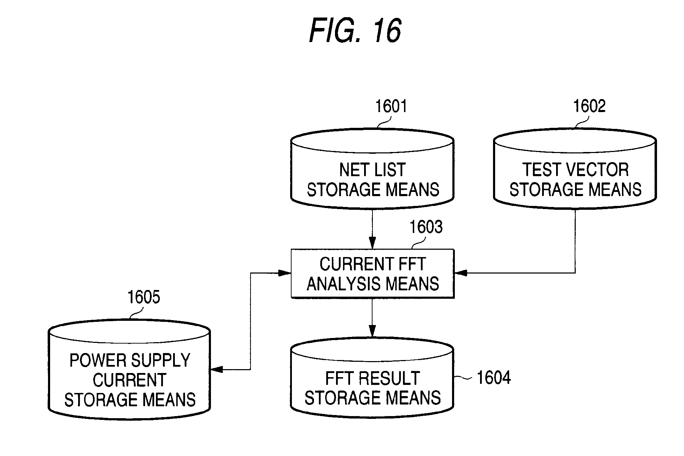

Fig. 16 shows a configuration of a device used for the EMI analysis method according to one embodiment of this invention.

The EMI analysis apparatus shown comprises a netlist storage means 1601, a test vector storage means 1602, a current FFT analysis means 1603, an FFT result storage means 1604, and a power supply current storage means 1605.

Of these, the netlist storage means 1601, the test vector storage means 1602, the FFT result storage means 1604 , and a power supply current storage means 1605are allocated to the external storage device of the computer system described earlier.

The current FFT analysis means 1603 is stored in the FFT calculation unit of the computer system as a group of programs each having steps as its constitutional elements.

Next, individual elements making up the EMI analysis method of Fig. 16 will be explained. At the same time the procedure of analyzing EMI by using the netlist information of Fig. 12 and the test vector information of Fig. 13 will also be explained.

The netlist storage means 1601, as in the second embodiment, stores in advance the netlist information on a circuit to be analyzed for EMI as shown in Fig. 12.

The test vector storage means 1602, as in the second embodiment, stores in advance the information on test vector of Fig. 13 to be applied to the external terminal of an object circuit.

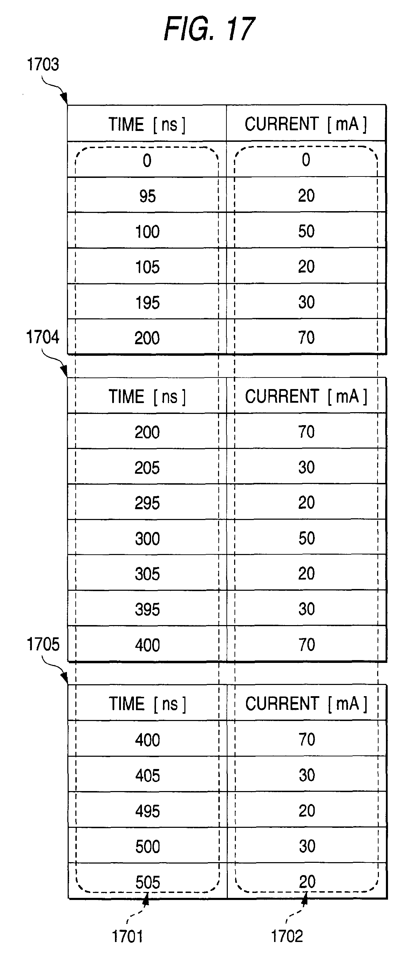

The current value storage means 1605 stores power supply current information of Fig. 17 calculated by the current FFT analysis means 1603.

This power supply current information includes one or more sets of power supply current information for the object circuit, which contain points in time 1701 at predetermined intervals of 200 ns and current values 1702.

It stores the power supply current information indicated by 1703 for a time duration of 0-200 ns, information indicated by 1704 for a time duration of 200-400 ns, and information indicated by 1705 for a time duration after 400 ns.

The FFT result storage means 1604, as in the second embodiment, stores the FFT result information like the one shown in Fig. 5 calculated by the current FFT analysis means 1603.

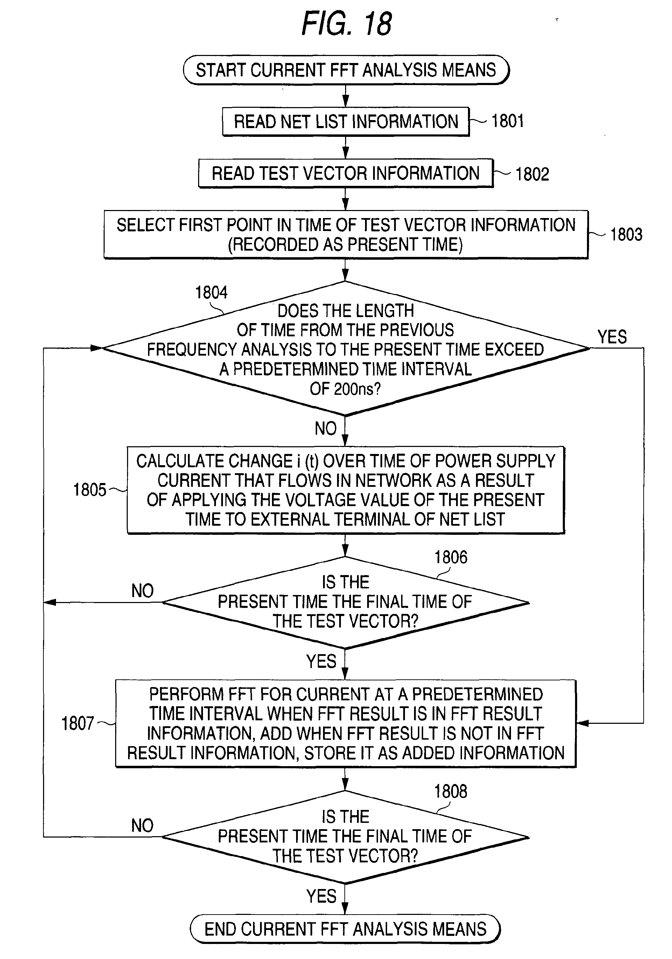

The current FFT analysis means 1603 executes the analysis operation according to a flow chart of Fig. 18.

First, step 1801 reads the netlist information of Fig. 12 stored in the netlist storage means 1601.

Next, step 1802 reads the test vector information of Fig. 13 stored in the test vector storage means 1602.

Further, step 1803 selects a first point in time (denoted as the present point in time) for the test vector information.

Then, step 1804 to step 1808 are repeated until the present point in time becomes the final point in time.

Then, step 1804 checks whether the time duration from the previous frequency analysis to the present time exceeds a predetermined time interval. If the predetermined time interval is exceeded, the processing proceeds to step 1807.

Further, step 1805 calculates a change over time of the power supply current that flows in the network as a result of applying the voltage value of the present point in time to the external terminal of the netlist.

Step 1806 checks if the present point in time is the final point in time for the test vector. If it is not the final point in time, the processing returns to step 1804. If it is the final point in time, the processing moves to step 1807.

Then, step 1807 performs the FFT on the current values of the predetermined time interval and adds the result to the FFT result information.

Then, step 1808 checks whether the present point in time is the final point in time for the test vector. If it is not the final, the processing returns to step 1804. If it is the final, the processing is terminated.

That is, rather than calculating all the currents at all points in time before performing the FFT as in the conventional method, this embodiment performs the FFT each time it calculates the currents in each interval of 200 ns and adds the FFT result to the previous one, thus obtaining the final FFT result similar to the one produced in the conventional method.

The power supply current information of Fig. 17 is calculated in the form of 1703 for the duration of 0-200 ns, 1704 for the duration of 200-400 ns, and 1705 for the duration after 400 ns. The FFT result in each time interval is added as it is obtained, thus producing the FFT result as shown in Fig. 5.

With the above method, the current frequency component is calculated each time the power supply current is calculated in a predetermined time interval. This makes it possible to save the memory required for the current calculation buffer without reducing the processing speed and to obtain the FFT result at a higher speed and with a smaller amount of memory than in the conventional method while maintaining the frequency precision in the entire frequency range. Further, because the amount of memory required by the current calculation buffer can be predicted in advance, a highly precise, stable operation can be performed particularly in a synchronizing circuit in which the magnitude of noise is determined by cyclic repetitions.

This method, when combined with the first embodiment, can produce the FFT result more faster with a still smaller amount of memory.

(Fourth Embodiment)

The conventional EMI analysis of LSI is performed by FFT-analyzing the current change that was obtained by using the transient analysis tool for the transistor level power supply current. The conventional method has a problem that because all the current frequency component values for individual predetermined discrete FFT values are stored, an increased amount of memory is needed to store that information.

To solve this problem this embodiment uses a technique of storing only those current frequency component values which exceed a threshold value in the frequency analysis.

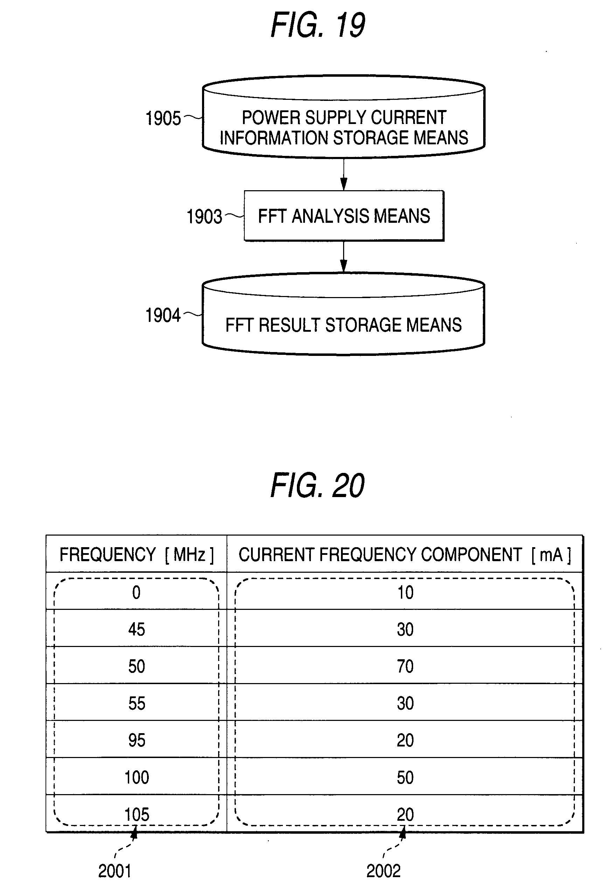

Fig. 19 shows a configuration of a device used for the EMI analysis method according to one embodiment of this invention. The EMI analysis apparatus shown in the figure has a power supply current information storage means 1905, an FFT analysis means 1903 and an FFT result storage means 1904.

Of these means, the power supply current information storage means 1905 and the FFT result storage means 1904 are allocated to the external storage device of the computer system described earlier.

The FFT analysis means 1903 is stored in the FFT calculation unit of the computer system as a group of programs each having steps as its constitutional elements.

Next, the individual elements of Fig. 19 making up the EMI analysis method will be described. The procedure for analyzing the EMI by using the power supply current information shown in Fig. 8 will also be explained.

The power supply current information storage means 1905, as in the first embodiment, stores the power supply current information on a circuit to be analyzed for EMI, as shown in Fig. 8, that was estimated in advance as by a transistor simulator.

The power supply current information is comprised of one or more sets of power supply current change information for an object circuit, each of which has time 801 and power supply current value 802.

The FFT result storage means 1904 stores the FFT result information calculated by the FFT analysis means 1903, as shown in Fig. 20.

The FFT result information comprises one or more sets of FFT result information for an object circuit, each of which has frequency 2001 and current frequency component value 2002 in excess of a threshold.

In this example the FFT result information shows the current frequency component values in excess of a threshold of 10 mA at discrete frequencies, such as a current frequency component value of 10 mA for 0 MHz and 30 mA for 45 MHz. The FFT result information excludes information on the current frequency component values less than 10 mA, such as 1 mA for 25 MHz which is included in the FFT analysis result of Fig. 9 in the first embodiment.

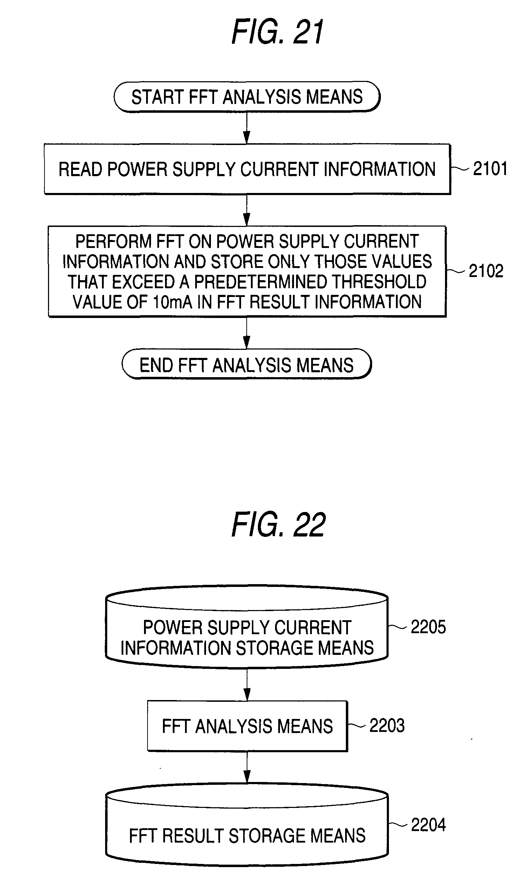

The FFT analysis means 1903 executes the analysis operation according to the flow chart of Fig. 21.

First, step 2101 reads the power supply information of Fig. 12 stored in the power supply information storage means 1905.

Next, step 2102 performs FFT on the power supply current information and stores only the FFT result information in excess of a predetermined threshold of 10 mA.

That is, unlike the conventional method which outputs all the FFT analysis results, this embodiment outputs only those results in excess of a predetermined threshold of 10 mA.

As described above, by performing calculation on only those current frequency components in excess of the threshold, the FFT results can be obtained with a smaller amount of memory than in the conventional method. Particularly in a circuit that has a limited number of frequencies for which the current frequency component is large, this method assures a high level of memory saving.

This method, when combined with the first, second and third embodiments, can produce the FFT result at a faster speed and with a smaller amount of memory.

(Fifth Embodiment)

The conventional EMI analysis of LSI is performed by FFT-analyzing the current change that was obtained by using the transient analysis tool for the transistor level power supply current. The conventional method has a problem that because all the current frequency component values for individual predetermined discrete FFT values are stored, an increased amount of memory is needed to store that information.

To deal with this problem, this embodiment adopts a technique that, in a frequency analysis, stores only a predetermined number of current frequency component values in the order of magnitude.

Fig. 22 shows a configuration of a device used for the EMI analysis method according to one embodiment of this invention.

The EMI analysis apparatus shown in the figure comprises a power supply current information storage means 2205, an FFT analysis means 2203 and an FFT result storage means 2204.

Of these, the power supply current information storage means 2205 and the FFT result storage means 2204 are allocated to the external storage device of the computer system described earlier.

The FFT analysis means 2203 is stored in the FFT calculation unit of the computer system as a group of programs each having steps as its constitutional elements.

Next, the individual elements of Fig. 22 making up the EMI analysis method will be described. The procedure for analyzing the EMI by using the power supply current information shown in Fig. 8 will also be explained.

The power supply current information storage means 2205, as in the first embodiment, stores the power supply current information on a circuit to be analyzed for EMI, as shown in Fig. 8, that was estimated in advance by a transistor simulator.

This power supply current information includes one or more sets of power supply current change information for the circuit being analyzed, each of which comprises time 801 and power supply current value 802.

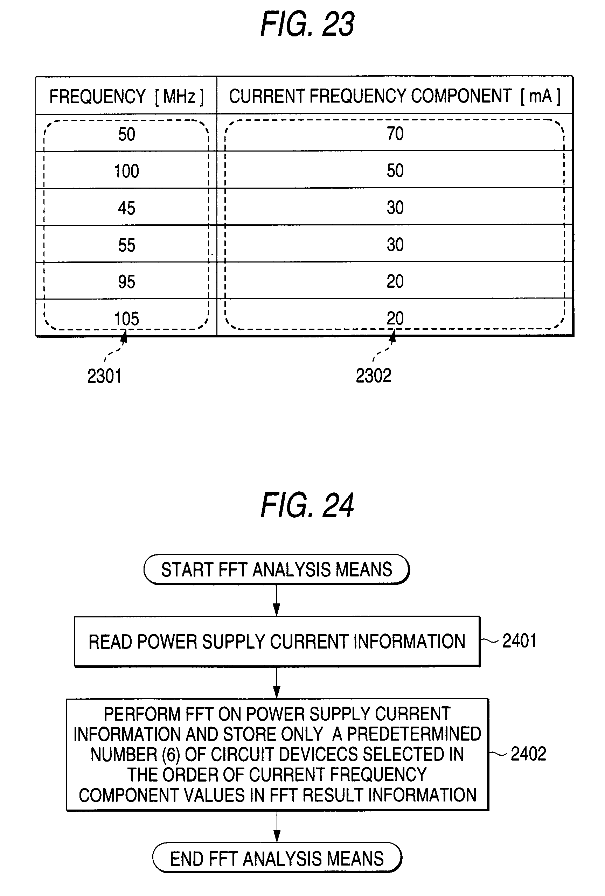

The FFT result storage means 2204 stores the FFT result information calculated by the FFT analysis means 2203 shown in Fig. 23.

This FFT result information includes one or more sets of FFT result information for the circuit being analyzed, each of which consists of frequency 2301 and current frequency component value 2302 in excess of a threshold.

In this example, this information shows six largest current frequency component values for discrete frequencies, such as 70 mA for 50 MHz and 50 mA for 100 MHz. This FFT result information excludes those information that do not fall within the six largest current frequency component values, such as 1 mA for 25 MHz contained in the FFT analysis result of Fig. 9 in the first embodiment.

Then, the current FFT analysis means 2203 executes the analysis operation according to the flow chart of Fig. 24.

First, step 2401 reads the power supply information of Fig. 12 stored in the power supply information storage means 1905.

Then, step 2402 performs FFT on the power supply current information and stores only a predetermined number, or six, of the largest current frequency component values in the FFT result information.

That is, rather than outputting all the FFT analysis results as in the conventional method, only the predetermined number, six, of FFT analysis results are output to produce the FFT results shown in Fig. 23.

As described above, by limiting the number of results to be stored, the FFT result can be obtained with a smaller amount of memory than in the conventional method. Further, because the amount of memory required for the FFT result information can be predicted in advance, the operation becomes stable particularly in a circuit that can limit the number of frequencies for which the current frequency component is large.

This method, when combined with the first, second, third and fourth embodiments, can produce the FFT result at a higher speed and with a smaller amount of memory.

(Sixth Embodiment)

This embodiment uses a technique of limiting the range of EMI analysis in order to solve the problem encountered in the conventional EMI analysis of LSI that the conventional method only measures the current of an object circuit and does not offer a sufficient function to identify the cause of EMI.

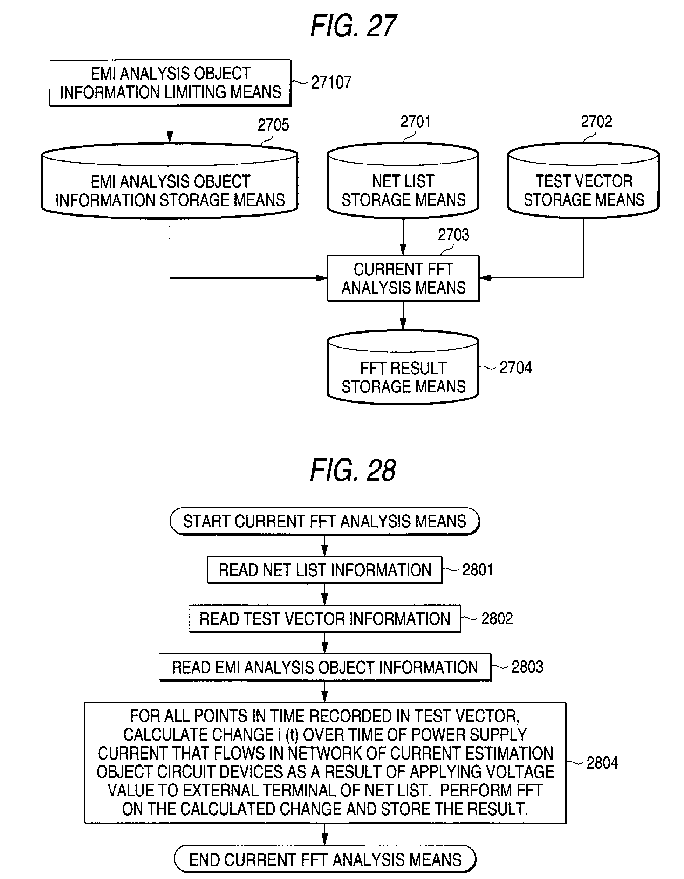

Fig. 27 shows a configuration of a device used for the EMI analysis method according to one embodiment of the invention. The EMI analysis apparatus shown in the figure comprises an EMI analysis object storage means 2705, a netlist storage means 2701, a test vector storage means 2702, a current FFT analysis means 2703, and an FFT result storage means 2704. Of these, the netlist storage means 2701, the EMI analysis object storage means 2705, the test vector storage means 2702 and the FFT result storage means 2704 are allocated to the external storage device of the computer system described earlier.

The current FFT analysis means 2703 and an EMI analysis object limiting means 27107 are stored in the FFT calculation unit of the computer system as a group of programs each having steps as its constitutional elements.

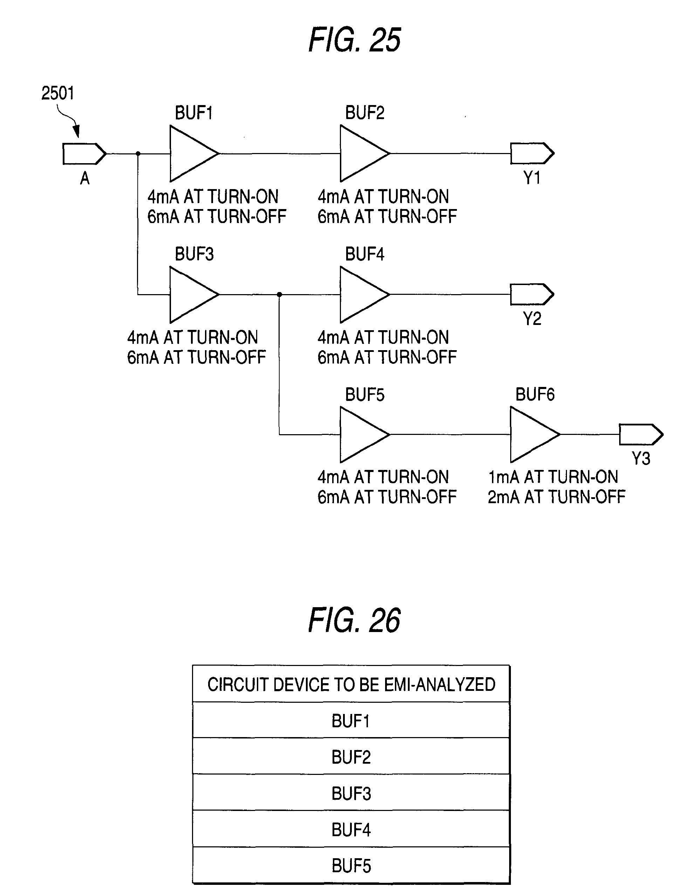

Next, the individual elements of Fig. 27 making up the EMI analysis method will be described. The procedure for analyzing the EMI by using the EMI analysis object information of Fig. 26, the netlist information of Fig. 25 and the test vector information of Fig. 13 will also be explained.

First, the netlist storage means 2701 stores in advance the netlist information on the circuit to be analyzed for EMI, as shown in Fig. 25.

The netlist information includes connection information of one or more circuit devices, wires and external terminals and information on current when each of the circuit devices is driven.

In this example, the netlist comprises buffers BUF1, BUF2, BUF3, BUF4, BUF5 through which currents of 4 mA and 6 mA flow when the circuit devices are turned on and off, respectively, a buffer BUF6 through which currents of 1 mA and 2 mA flow when the device is turned on and off, respectively, an external input terminal A, an external output terminals Y1, Y2, Y3 and wires connecting these.

The test vector storage means 2702, as in the second embodiment, stores in advance the information on test vectors to be applied to the external terminals of an object circuit, as shown in Fig. 13.

The EMI analysis object storage means 2705 stores the EMI analysis object, like the one shown in Fig. 26, calculated by the EMI analysis object limiting means 27107. The EMI analysis object information consists of circuit device names to be analyzed for EMI. The circuit device name may indicate a plurality of circuit devices, such as a block name.

In this example, the EMI analysis object storage means stores the circuit devices to be analyzed BUF1, BUF2, BUF3, BUF4, BUF5.

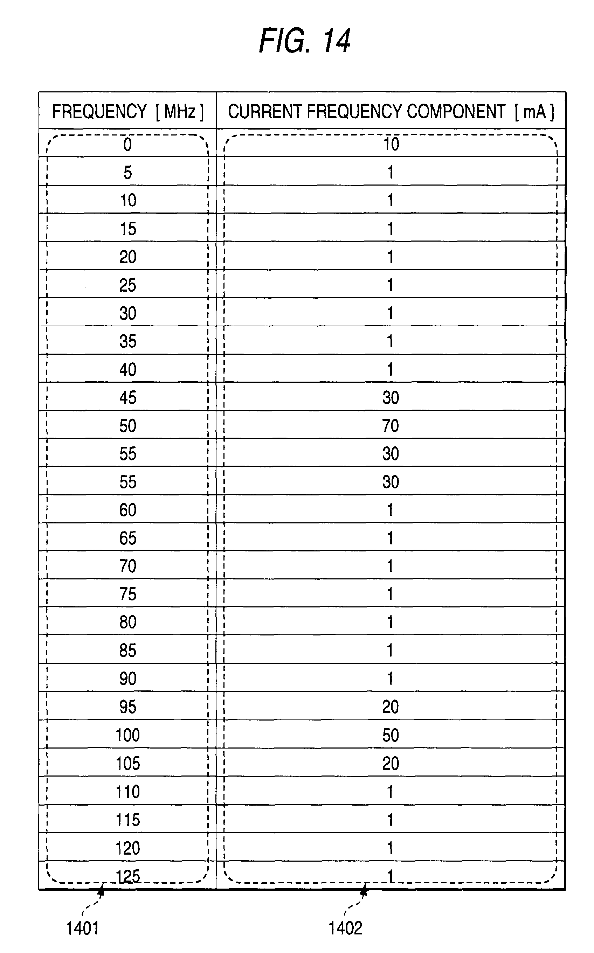

The FFT result storage means 2704 stores the FFT result information, like the one shown in Fig. 14, calculated by the current FFT analysis means 2703.

The FFT result information includes one or more sets of FFT result information for a circuit to be analyzed, each of which comprises a frequency 1401 and a current frequency component value 1402 for all power supply currents of circuit devices BUF1, BUF2, BUF3, BUF4, BUF5.

In this example, this information indicates the current frequency component values at discrete frequencies, such as a current frequency component value of 10 mA at 0 MHz and 1 mA at 5 MHz.

The current FFT analysis means 2703 executes the FFT analysis according to the flow chart of Fig. 28.

First, step 2801 reads the netlist information of Fig. 12 stored in the netlist storage means 2701.

Then, step 2802 reads the test vector information of Fig. 13 stored in the test vector storage means 2702.

Further, step 2803 reads the EMI analysis object information of Fig. 26 stored in the EMI analysis object storage means 2705.

After this, for all points in time listed in the test vector, step 2803 calculates a change over time i(t) of the power supply current that, as a result of applying the voltage value to the external terminal of the netlist, flows in a circuit device network for which the current is to be estimated.

In this example, the current is calculated for only five circuit devices BUF1, BUF2, BUF3, BUF4, BUF5 and the FFT is performed on only these currents. This makes it possible to produce the FFT result as shown in Fig. 14 while reducing the amount of current calculation and FFT calculation associated with the BUF6 which has little effect on the FFT result. It is also possible to perform the FFT on only BUF1 to produce the FFT result that allows the EMI cause to be roughly identified.

As described above, limiting the EMI analysis object makes the analysis faster and allows the cause of EMI to be identified easily.

This method, when combined with the first, second, third, fourth and fifth embodiments, can produce the FFT result at a faster speed and with a smaller amount of memory and facilitate the locating of the EMI cause.

(Seventh Embodiment)

The conventional EMI analysis of LSI is performed by FFT-analyzing the current change that was obtained by using the transient analysis tool for the transistor level power supply current. The conventional method has a problem that because the current change information is stored temporarily in a buffer, a larger amount of memory is needed for storing that information.

To deal with this problem, this embodiment adopts a technique of performing calculation on only the circuit devices whose current values exceed a threshold.

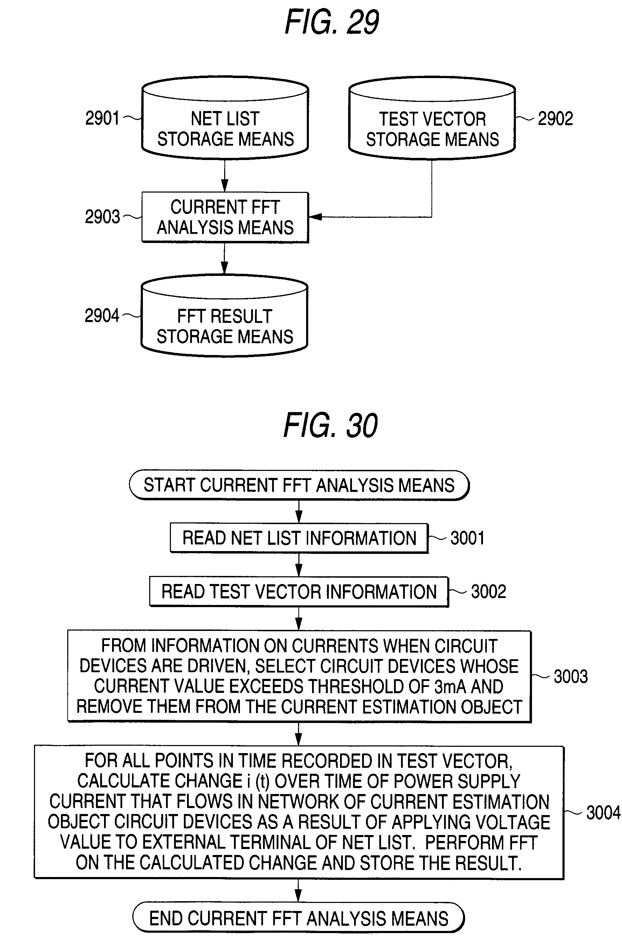

Fig. 29 shows a configuration of a device used for the EMI analysis method according to one embodiment of this invention. The EMI analysis apparatus shown in the figure comprises a netlist storage means 2901, a test vector storage means 2902, a current FFT analysis means 2903, and an FFT result storage means 2904.

Of these, the netlist storage means 2901, the test vector storage means 2902 and the FFT result storage means 2904 are allocated to the external device of the computer system described earlier.

The current FFT analysis means 2903 is stored in the FFT calculation unit of the computer system as a group of programs each having steps as its constitutional elements.

Next, the individual elements making up the EMI analysis apparatus of Fig. 29 will be described. At the same time the procedure for analyzing EMI by using the netlist information of Fig. 25 and the test vector information of Fig. 13 will also be explained.

The netlist storage means 2901, as in the sixth embodiment, stores in advance the netlist information on a circuit to be analyzed for EMI, as shown in Fig. 25.

The test vector storage means 2902, as in the second embodiment, stores in advance the information on test vectors to be applied to the external terminal of an object circuit, as shown in Fig. 13.

The FFT result storage means 2904, as in the sixth embodiment, stores the FFT result information like the one shown in Fig. 14 calculated by the current FFT analysis means 2903.

The current FFT analysis means 2903 executes the analysis according to the flow chart of Fig. 30.

First, step 3001 reads the netlist information of Fig. 12 stored in the netlist storage means 2901.

Next, step 3002 reads the test vector information of Fig. 13 stored in the test vector storage means 2902.

Then, based on the information on currents that flow when the circuit devices are driven, step 3003 excludes the circuit devices whose currents exceed the threshold of 3 mA from the current estimation object.

After this, for all points in time listed in the test vector, step 3004 calculates a change over time i(t) of the power supply current that, as a result of applying the voltage value to the external terminal of the netlist, flows in a circuit device network for which the current is to be estimated. The result is subjected to FFT before being stored in the FFT result information.

That is, rather than calculating the FFT analysis result for all devices as in the conventional method, the current calculation and FFT calculation are performed on only those devices BUF1, BUF2, BUF3, BUF4, BUF5 whose currents exceed a predetermined threshold of 3 mA. This makes it possible to produce the FFT result as shown in Fig. 14 while reducing the amount of calculation associated with the BUF6 which has little effect on the FFT result.

As described above, performing calculation only on the devices whose currents exceed the threshold can reduce the current calculation and FFT calculation, thereby increasing the speed. Further, this method can limit the locations of large current flows which may cause noise and therefore facilitate the identification of the EMI cause. This method, when combined with the first, second, third, fourth, fifth and sixth embodiments, can produce the FFT result at a faster speed and with a smaller amount of memory and facilitate the identification of the EMI cause.

(Eighth Embodiment)

The conventional EMI analysis method for LSI is performed by FFT-analyzing the current change that was obtained by using the transient analysis tool for the transistor level power supply current. The conventional method has a problem that because the current change information is stored temporarily in a buffer, a larger amount of memory is needed for storing that information.

To deal with this problem, this embodiment adopts a technique of selecting only a predetermined number of circuit devices whose currents are large and performing calculation on only the selected circuit devices.

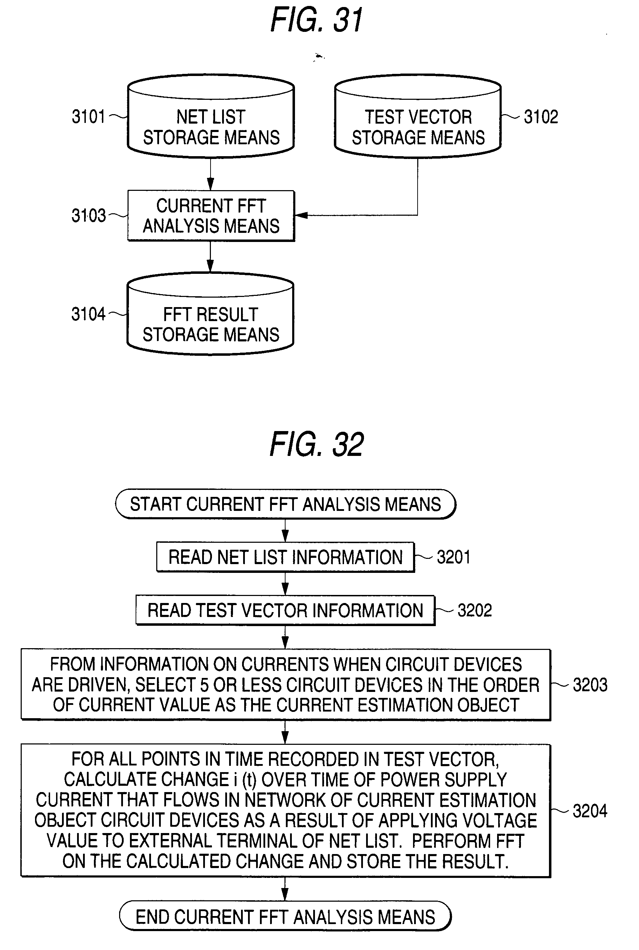

Fig. 31 shows a configuration of the EMI analysis apparatus according to one embodiment of this invention. The EMI analysis apparatus shown in the figure comprises a netlist storage means 3101, a test vector storage means 3102, a current FFT analysis means 3103 and an FFT result storage means 3104.

Of these, the netlist storage means 3101, the test vector storage means 3102 and the FFT result storage means 3104 are allocated to the external device of the computer system described earlier.

The current FFT analysis means 3103 is stored in the FFT calculation unit of the computer system as a group of programs each having steps as its constitutional elements.

Next, the individual elements of Fig. 31 making up the EMI analysis method will be described. At the same time, the procedure for analyzing EMI by using the netlist information of Fig. 25 and the test vector information of Fig. 13 will also be explained.

The netlist storage means 3101, as in the sixth embodiment, stores in advance the netlist information on a circuit to be analyzed for EMI, as shown in Fig. 25.

The test vector storage means 3102, as in the second embodiment, stores in advance the information on test vectors to be applied to the external terminal of an object circuit, as shown in Fig. 13.

The FFT result storage means 3104, as in the sixth embodiment, stores the FFT result information like the one shown in Fig. 14 calculated by the current FFT analysis means 3103.

The current FFT analysis means 3103 executes the analysis according to the flow chart of Fig. 32.

First, step 3201 reads the netlist information of Fig. 12 stored in the netlist storage means 3101.

Then, step 3202 reads the test vector information of Fig .13 stored in the test vector storage means 3102.

After this, based on the information on current that flows when each circuit device is driven, step 3203 selects a predetermined number, five, or less of circuit devices in the order of magnitude.

Finally, for all points in time listed inthe test vector, step 3204 calculates a change over time i (t) of the power supply current that, as a result of applying the voltage value to the external terminal of the netlist, flows in a circuit device network for which the current is to be estimated. The result is subjected to FFT before being stored in the FFT result information.

That is, rather than calculating the FFT analysis result for all devices as in the conventional method, the current calculation and FFT calculation are performed on only five devices or less BUF1, BUF2, BUF3, BUF4, BUF5 that were selected in advance from the current information in the order of magnitude, the current information representing currents that flow when the circuit devices are driven. This makes it possible to produce the FFT result as shown in Fig. 14 while reducing the amount of calculation associated with the BUF6 which has little effect on the FFT result.

As described above, performing calculations on only a predetermined number of circuit devices having large current values can reduce the current calculation and FFT calculation compared with the conventional method and therefore increase the speed of the analysis. Further, this method can limit the locations of large current flows which may cause noise and therefore facilitate the estimation of the EMI cause. Further, because the amount of memory required for the current calculation can be predicted in advance, a stable operation is assured particularly in a circuit that can limit the number of circuit devices with high current flows.

This method, when combined with the first, second, third, fourth, fifth, sixth and seventh embodiments, can produce the FFT result at a faster speed and with a smaller amount of memory and facilitate the identification of the EMI cause.

(Ninth Embodiment)

The conventional gate level EMI analysis method for LSI is performed by FFT-analyzing a current change estimated from a change in signal from an event drive simulator.

This method has a problem that because the current change information is stored temporarily in a buffer, an additional memory is needed to store that information.

To deal with the above problem, this embodiment uses a technique of performing the frequency analysis along with the current calculation for each predetermined time interval and also performing the current calculation on a circuit device which has undergone a predetermined number of logic changes.

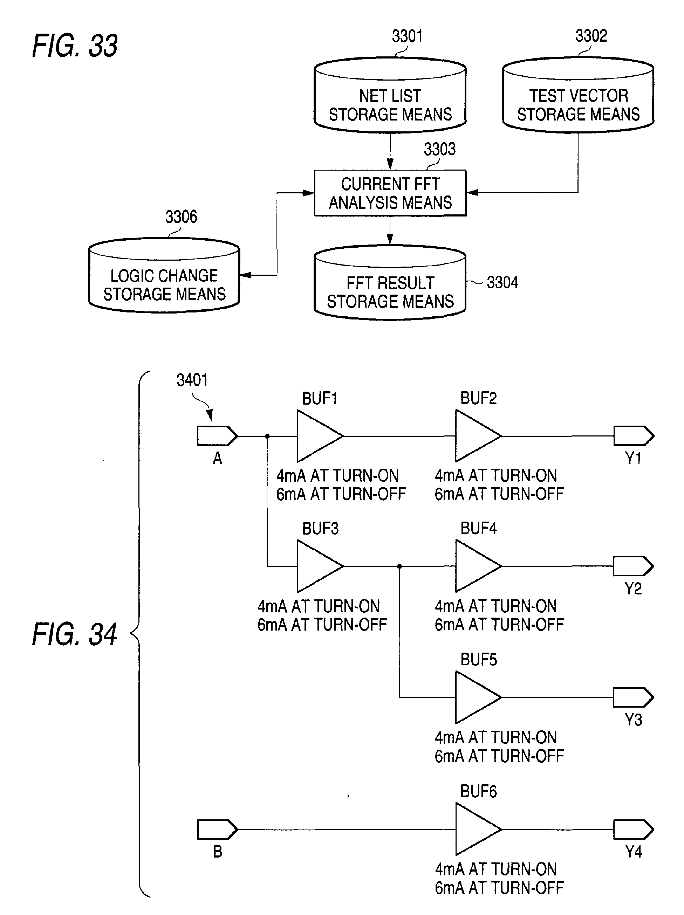

Fig. 33 shows a configuration of the EMI analysis apparatus according to one embodiment of this invention. The EMI analysis apparatus shown in the figure comprises a netlist storage means 3301, a test vector storage means 3302, a current FFT analysis means 3303, a logic change storage means 3306, and an FFT result storage means 3304.

The netlist storage means 3301, the test vector storage means 3302, the logic change storage means 3306 and the FFT result storage means 3304 are allocated to the external storage device of the computer system described earlier.

The current FFT analysis means 3303 is stored in the FFT calculation unit of the computer system as a group of programs each having steps as its constitutional elements.

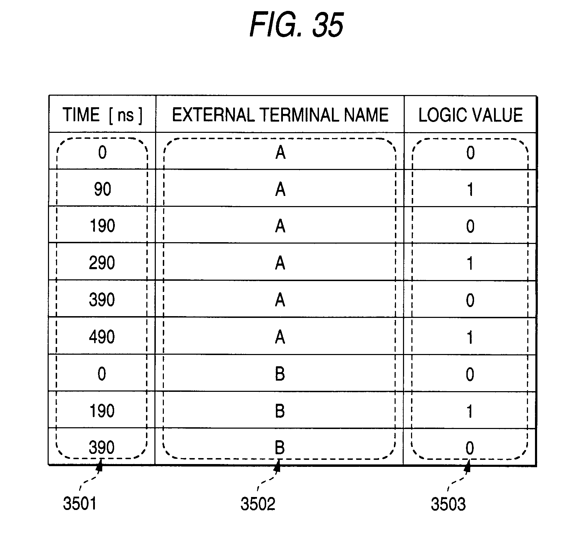

Next, individual elements of Fig. 33 making up the EMI analysis method will be described. The procedure for analyzing EMI by using the test vector information of Fig. 35 will also be explained.

The netlist storage means 3301 stores in advance the netlist information on a circuit to be analyzed for EMI, as shown in Fig. 34.

The netlist information includes connection information about one or more circuit devices, wires and external devices, and information on currents that flow when circuit devices are driven.

In this example, the netlist comprises buffers BUF1, BUF2, BUF3, BUF4, BUF5 and BUF6 through which currents of 4 mA and 6 mA flow when the circuit devices are turned on and off, respectively, external input terminals A, B, external output terminals Y1, Y2, Y3, Y4, and wires connecting these.

The test vector storage means 3302 stores in advance the information on test vectors to be applied to the external terminals of a circuit under examination, as shown in Fig. 35. The test vector information comprises a point in time 3501, an external input terminal name 3502, and logic information 3503 on the external terminals of the object circuit at each point in time.

Unlike the test vector information in the second embodiment, the test vector information of this embodiment has information on a signal change in a digital form, not in a transient form.

In this example, the vector information specifies discrete logic changes. For example, a logic value 0 is applied to the external input terminal A for a duration from time 0 ns to time 90 ns and a logic value 1 to the external input terminal A for a duration from time 90 ns to 190 ns.

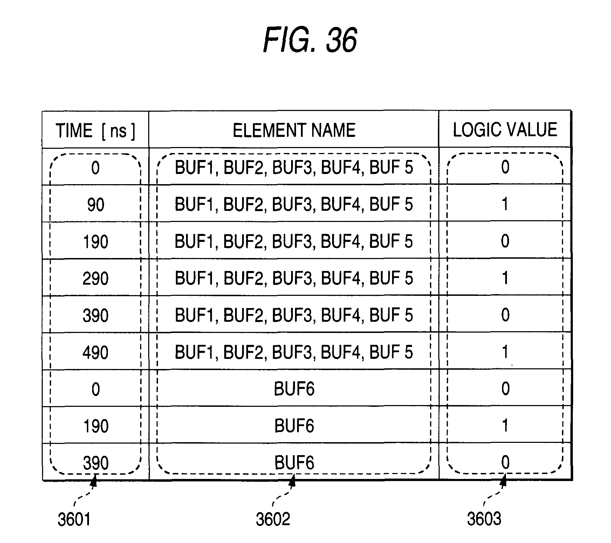

The logic change storage means 3306 stores the logic change information calculated by the current FFT analysis means 3303, as shown in Fig. 36.

The information on the number of logic changes comprises one or more information sets of logic values at outputs of circuit devices of an object circuit, each consisting of a point in time, a circuit device name and a logic value. Unlike the power supply current information in the first embodiment, the information on signal changes is in a digital form, not in a transient form.

In this example, the logic change information specifies discrete logic changes. For example, the logic value at the output terminal Y of circuit devices BUF1, BUF2, BU3, BUF4 and BUF5 changes to 0 at time 0 ns and to 1 at 90 ns.

The FFT result storage means 3304, as in the sixth embodiment, stores the FFT result information like the one shown in Fig. 14 calculated by the current FFT analysis means 3303.

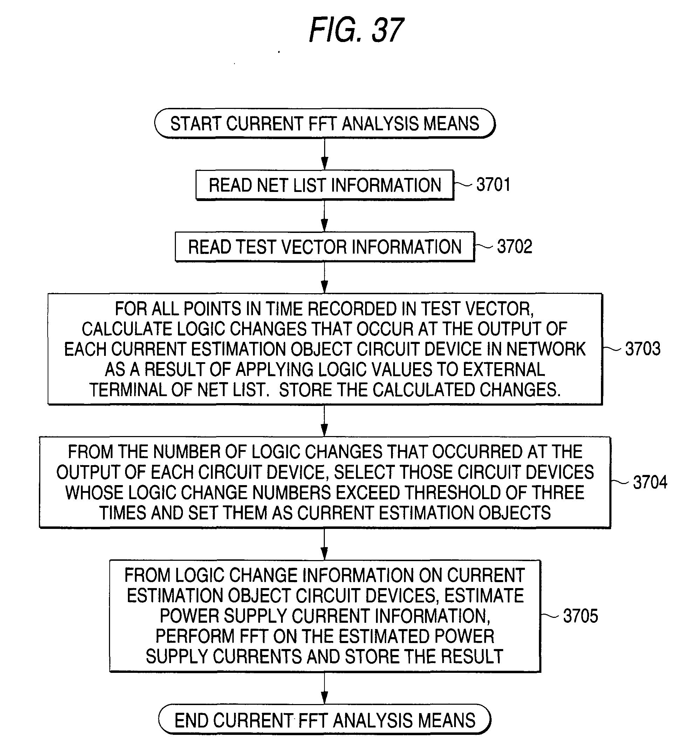

The current FFT analysis means 3303 executes the analysis according to the flow chart of Fig. 37.

First, step 3701 reads the netlist information of Fig. 34 stored in the netlist storage means 3301.

Then, step 3702 reads the test vector information of Fig .35 stored in the test vector storage means 3302.

Then, for all points in time listed in the test vector, step 3703 calculates a logic change which, as a result of applying a logic value to the external terminal of the netlist, occurs at the output of each circuit device of the network for which the current is to be estimated. The calculated logic changes are then stored in the logic change information.

Then, based on the number of logic changes that have occurred at the output of each circuit device, step 3704 selects, as circuit devices for which the current estimation is to be made, those which have undergone logic changes more than three times, a threshold number of times.

Further, step 3705 estimates the power supply current information from the logic change information for the circuit devices that are to be current-estimated. The step 3706 performs FFT on the estimated current information and stores the result in the FFT result information.

That is, the BUF6 that has undergone a total of three logic changes, less than the threshold number of times, including logic rise and fall, is excluded from the group of circuit devices to be analyzed. BUF1, BUF2, BUF3, BUF4 and BUF5 which have undergone six logic changes are included in the group to be analyzed and they are subjected to the FFT calculation. This makes it possible to produce the FFT result as shown in Fig. 14 while reducing the amount of calculation associated with the BUF6 which has little effect on the FFT result.

As described above, performing calculation on only the circuit devices that have undergone logic changes more than the threshold number of times can increase the processing speed, though with less precision, as compared with the conventional method shown in the first embodiment because the peak current calculation and FFT calculation are not performed.

With the method described above, by performing calculation only on those circuit devices that have logic change numbers in excess of the threshold, it is possible to determine a calculation load saving at a stage of logic change calculation compared with the conventional method and reduce the current calculation and FFT calculation. This in turn increases the processing speed, limits the locations having large logic change numbers which may become noise sources, and facilitates the estimation of the EMI cause.

This method, when combined with the first, second, third, fourth, fifth, sixth, seventh and eighth embodiments, can produce the FFT result at a faster speed and with a smaller amount of memory and facilitate the identification of the EMI cause.

(10th Embodiment)

The conventional EMI analysis method for LSI is performed by FFT-analyzing the current change that was estimated from a change in signal from the event drive simulator. This conventional method has a problem that because the current change information is stored temporarily in a buffer, an additional amount of memory is needed for storing that information.

To deal with the above problem, this embodiment adopts a technique of performing the frequency analysis along with the current calculation for each predetermined time interval and performing the current calculation on only a predetermined number of circuit devices that were selected in the order of the number of logic changes.

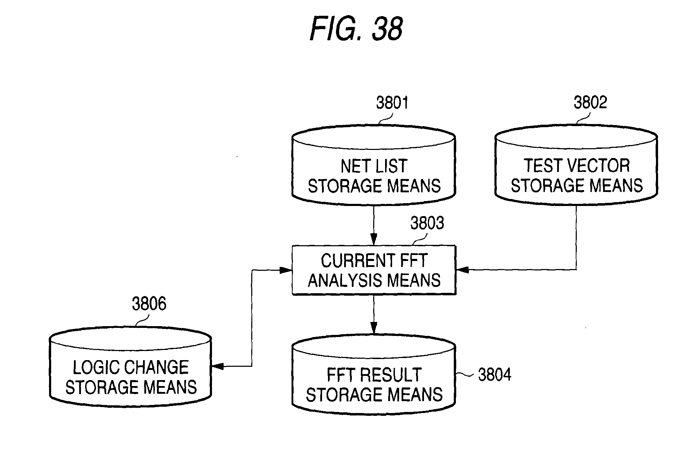

Fig. 38 shows a configuration of the EMI analysis apparatus according to the 10th embodiment of this invention.

The EMI analysis apparatus shown in the figure comprises a netlist storage means 3801, a test vector storage means 3802, a current FFT analysis means 3803, a logic change storage means 3806, and an FFT result storage means 3804.

Of these, the netlist storage means 3801, the test vector storage means 3802, the logic change storage means 3806 and the FFT result storage means 3804 are allocated to the external storage device of the computer system described earlier.

The current FFT analysis means 3803 on the other hand is stored in the FFT calculation unit of the computer system as a group of programs each having steps as its constitutional elements.

Next, individual elements of Fig. 38 making up the EMI analysis method will be described. The procedure for analyzing EMI by using the netlist information of Fig. 34 and the test vector information of Fig. 35 will also explained.

The netlist storage means 3801, as in the ninth embodiment, stores in advance the netlist information on a circuit to be analyzed for EMI, as shown in Fig. 34. The test vector storage means 3802, as in the ninth embodiment, stores in advance the information on test vectors to be applied to the external terminal of an object circuit, as shown in Fig. 35.

The logic change storage means 3806, as in the ninth embodiment, stores the logic change information like the one shown in Fig. 36 calculated by the current FFT analysis means 3303.

The FFT result storage means 3804, as in the sixth embodiment, stores the FFT result information like the one shown in Fig. 14 calculated by the current FFT analysis means 3803.

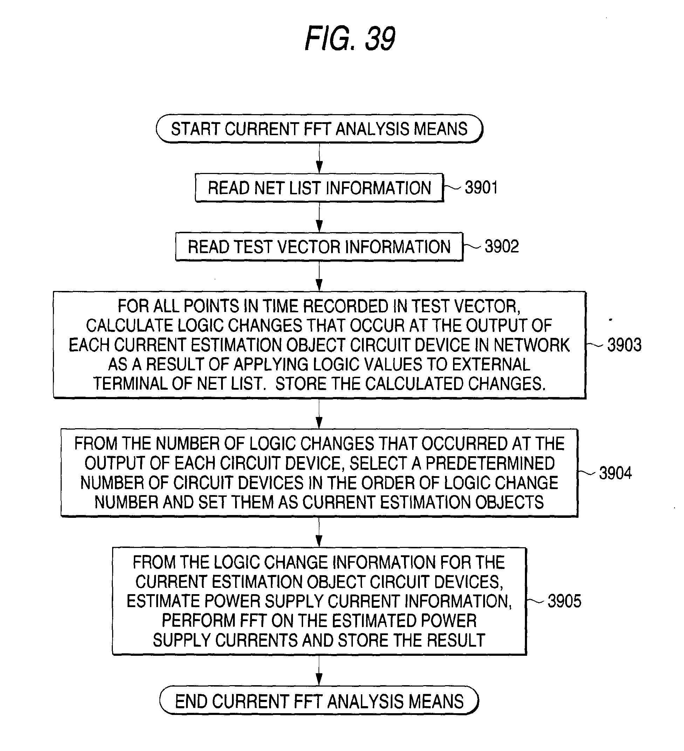

The current FFT analysis means 3803 executes the analysis operation according to the flow chart of Fig. 39.

First, step 3901 reads the netlist information of Fig. 34 stored in the netlist storage means 3801.

Then step 3902 reads the test vector information of Fig. 35 stored in the test vector storage means 3802.

After this, for all points in time listed in the test vector, step 3903 calculates a logic change which, as a result of applying a logic value to the external terminal of the netlist, occurs at the output of each circuit device of the network for which the current is to be estimated. The calculated logic changes are then stored in the logic change information.

Then, based on the number of logic changes that have occurred at the output of each circuit device, step 3904 selects, as circuit devices for which the current estimation is to be made, five circuit devices in the order of the number of logic changes.

Further, step 3905 estimates the power supply current information from the logic change information for the circuit devices that are to be current-estimated, and performs FFT on the estimated currents before storing the result in the FFT result information.

That is, circuit devices BUF1, BUF2, BUF3, BUF4, BUF5 with the top five logic change numbers are selected for analysis and subjected to FFT. This produces the FFT result as shown in Fig. 14 while reducing the amount of calculation associated with BUF6 which has little effect on the FFT result.

As described above, performing calculation on only the predetermined number of circuit devices with large logic change numbers can determine a calculation load saving at a stage of logic change calculation compared with the conventional method. This in turn can reduce the current calculation and FFT calculation, thereby increasing the processing speed. It is also possible to limit the locations having large logic change numbers which may become possible noise sources and to facilitate the identification of the EMI causes. Further, because the amount of memory required for the current calculation can be predicted in advance, a stable operation is assured particularly in a circuit that can limit the number of circuit devices having large logic change numbers.

This method, when combined with the first, second, third, fourth, fifth, sixth, seventh, eighth and ninth embodiments, can produce the FFT result at a faster speed and with a smaller amount of memory and facilitate the identification of the EMI causes.

(11th Embodiment)

The conventional EMI analysis method for LSI has a problem that it only measures the current of an object circuit and does not offer a sufficient function to identify the cause of EMI. This embodiment adopts a technique of performing the EMI analysis on only those locations that are estimated to have a large peak current.

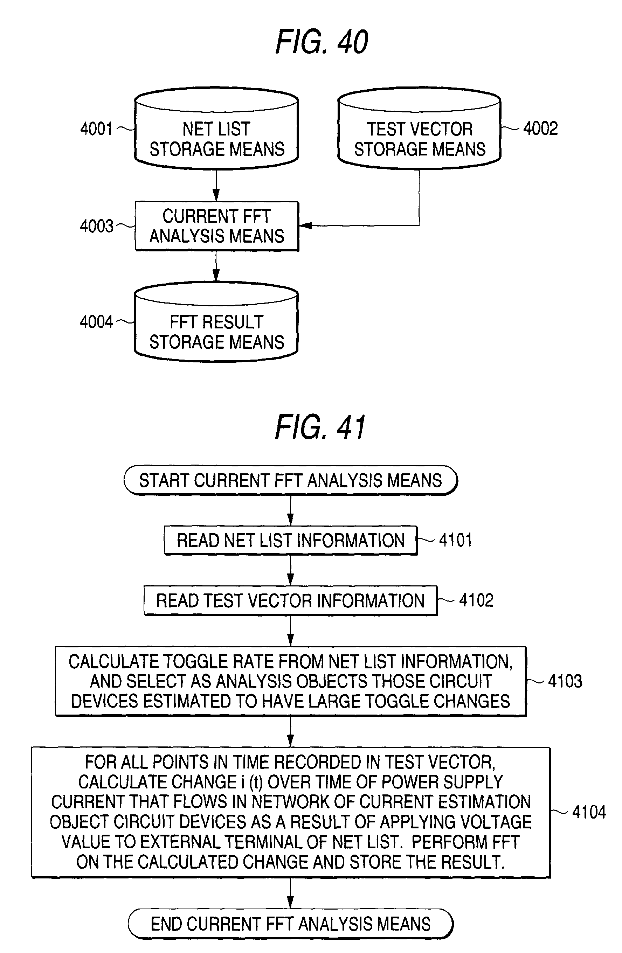

Fig. 40 shows a configuration of the EMI analysis apparatus according to one embodiment of this invention. The EMI analysis apparatus shown in the figure comprises a netlist storage means 4001, a test vector storage means 4002, a current FFT analysis means 4003 and an FFT result storage means 4004.

Of these, the netlist storage means 4001, the test vector storage means 4002 and the FFT result storage means 4004 are allocated to the external storage device of the computer system described earlier.

The current FFT analysis means 4003 on the other hand is saved in the FFT calculation unit of the computer system as a group of programs each having steps as its constitutional elements.

Next, individual elements making up the EMI analysis apparatus of Fig. 40 will be explained. The procedure for analyzing EMI by using the netlist information of Fig. 34 and the test vector information of Fig. 35 will also be explained.

The netlist storage means 4001, as in the ninth embodiment, stores in advance the netlist information on a circuit to be analyzed for EMI, as shown in Fig. 34.

The test vector storage means 4002, as in the ninth embodiment, stores in advance the information on test vectors to be applied to the external terminal of an object circuit, as shown in Fig. 35.

The FFT result storage means 4004, as in the sixth embodiment, stores the FFT result information like the one shown in Fig. 14 calculated by the current FFT analysis means 4003.

The current FFT analysis means 4003 executes the analysis according to the flow chart of Fig. 41.

First, step 4101 reads the netlist information of Fig. 12 stored in the netlist storage means 4001.

Then, step 4102 reads the test vector information of Fig. 13 stored in the test vector storage means 4002.

Then, step 4103 estimates the number of changes at the output of each circuit device by using a transient probability calculation means used in the fault simulator, and selects those circuit devices having the number of changes in excess of a threshold as the circuit devices to be analyzed.

Instead of using the threshold, the circuit devices to be analyzed may be determined by setting the number of circuit devices that are selected in the order of the number of changes.

For all points in time listed in the test vector, step 4103 calculates a change over time i(t) of the power supply current that, as a result of applying the voltage value to the external terminal of the netlist, flows in a circuit device network for which the current is to be estimated.

That is, the first transient probability calculation means calculates the number of changes in the state of each circuit device in the netlist by using the test vector which specifies changing the state of the external terminal A six times and the state of the external terminal B three times and by considering that the number of changes in the state of the buffer at the input is equal to that at the output. In this case, it is estimated that the BUF1, BUF2, BUF3, BUF4 and BUF5 will change their state six times and that the BUF6 will change its state three times.

Then, the BUF6 which changes its state a total of three times, less than the threshold number of times, including rise and fall, is excluded from the object group of circuit devices to be analyzed. The BUF1, BUF2, BUF3, BUF4 and BUF5 which change their state a total of six times, greater than the threshold, are included in the object group and they are subjected to the FFT calculation. This makes it possible to produce the FFT result as shown in Fig. 14 while reducing the amount of calculation associated with the BUF6 that has little effect on the FFT result.

When the circuit device is AND, the similar calculation can be made by utilizing the fact that when two input probabilities are equal, the probability of output 1 being produced is 25% and the probability of output 0 is 75% (because the output is 1 when two inputs are both logic 1 and the output is 0 in three other cases.). When the circuit device is OR, the similar calculation can be made by utilizing the fact that when two input probabilities are equal, the probability of output 1 being produced is 75% and the probability of output 0 is 25%.

As described above, by estimating the number of logic changes from the netlist to determine the circuit devices to be analyzed, it is possible, as opposed to the conventional method, to determine a calculation load saving at a stage prior to the logic change calculation, thus reducing the logic change calculation, current calculation and FFT. This in turn increases the processing speed and makes it possible to limit the locations with a large number of logic changes which may become a noise source, thus facilitating the identification of EMI causes.

This method, when combined with the first, second, third, fourth, fifth, sixth and seventh embodiments, can produce the FFT result at a faster speed and with a smaller amount of memory and facilitate the identification of EMI causes.

(12th Embodiment)

In the conventional EMI analysis means for LSI, it is general practice to report only the FFT result. This method takes very long to locate the EMI cause.

To deal with this problem, this embodiment adopts a user interface technique of performing the FFT on the current waveform for each instance and sorting the instance names in the order of current frequency component noise.

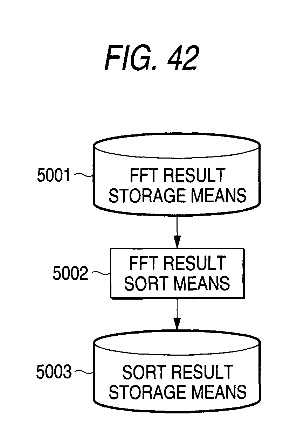

Fig. 42 shows a configuration of the EMI analysis apparatus according to the 12th embodiment of this invention. The EMI analysis apparatus shown in the figure comprises an FFT result storage means 5001, an FFT result sort means 5002, and a sort result storage means 5003.

Of these, the FFT result storage means 5001 and the sort result storage means 5003 are allocated to the external storage device of the computer system described earlier.

The FFT result sort means 5002 on the other hand is stored in the input/output calculation unit of the computer system as a group of programs each having steps as its constitutional elements.

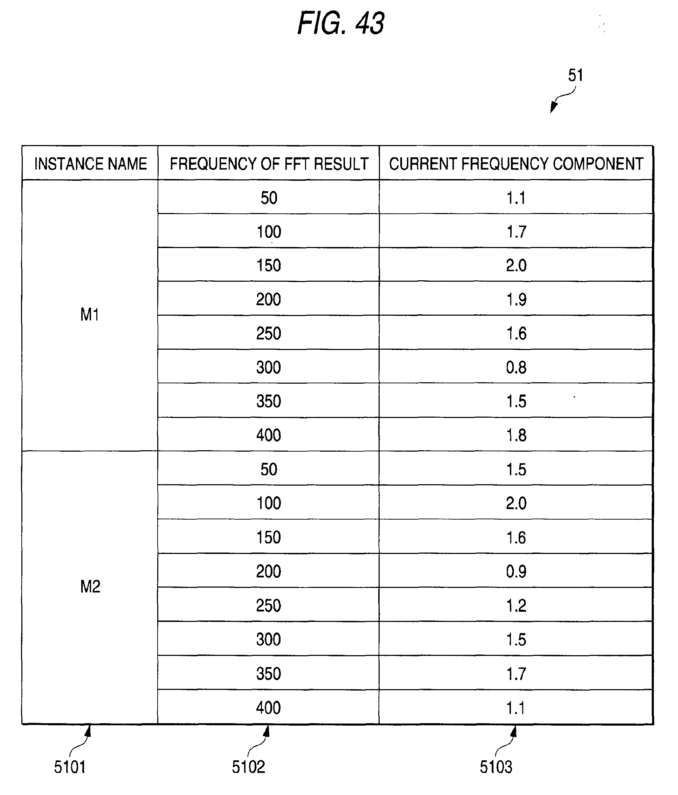

Next, individual elements making up the EMI analysis apparatus of Fig. 42 will be explained. The procedure for analyzing the EMI by using the FFT result information of Fig. 43 will also be explained.

The FFT result storage means 5001 stores in advance the FFT result information as shown in Fig. 43.

The FFT result information comprises, for each instance, the information on the frequency and the current frequency component of the FFT result.

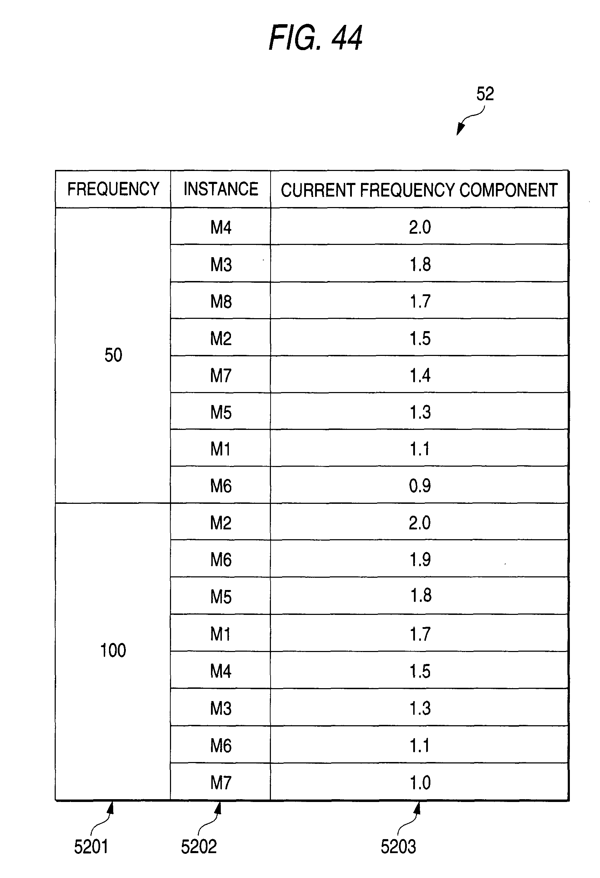

The sort result storage means 5003 stores the sort result information as shown in Fig. 44 calculated by the FFT result sort means 5002.

The sort result information comprises one or more set of FFT result information on the object circuit, each consisting of an instance name and a current frequency component value for each frequency.

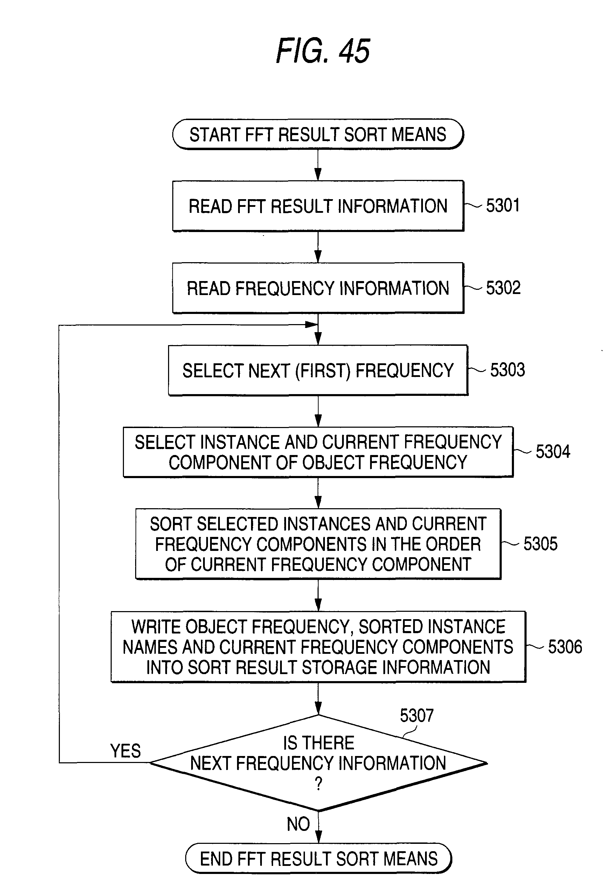

The FFT result sort means 5002 executes the analysis according to the flow chart of Fig. 45.

First, step 5301 reads the FFT result information of Fig. 43 stored in the FFT result storage means 5001.

Next, step 5302 reads the frequency information contained in the FFT result information and step 5303 selects the first frequency.

Then, step 5304 selects all the instances and current frequency components corresponding to the frequencies being examined. Step 5305 sorts the instances and the current frequency components selected by the step 5305 in the order of magnitude of the current frequency component noise.

Step 5306 writes into the sort result storage information the frequencies to be examined and the sorted instance names and current frequency components.

The above sequence of steps 5304 to 5306 is repeated until all the frequency information listed in the FFT result information is processed. When this processing is finished, the FFT result sort means is terminated.

As described above, the user interface technique is used which involves performing the FFT on the current waveform for each instance and sorting the instance names in the order of current frequency component noise. This method allows the noise-relevant instances to be identified.

(13th Embodiment)

In the conventional EMI analysis means for LSI, it is general practice to report only the FFT result. This method takes very long to locate the EMI cause.

This embodiment is a user interface technique that performs the processing of the embodiment 12 for each block (instance group).

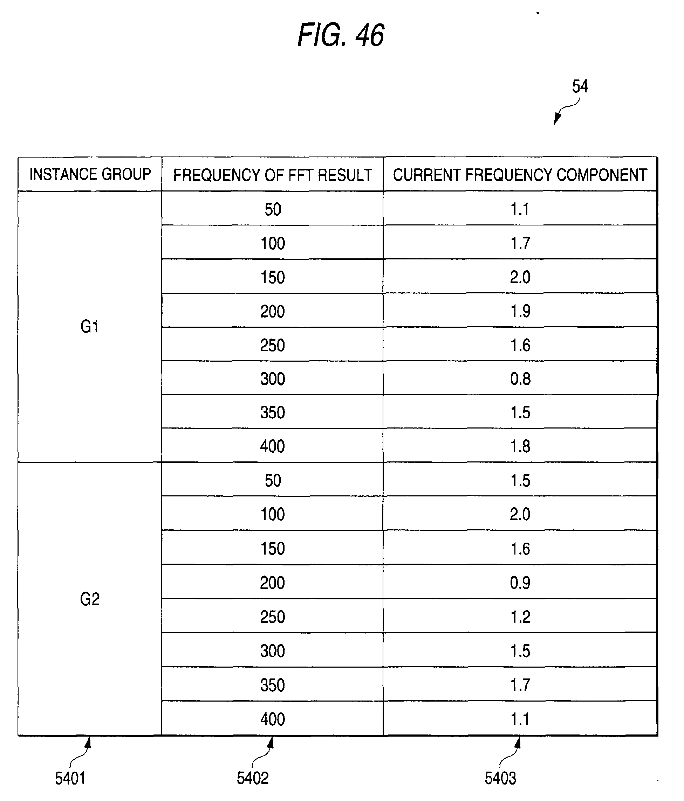

The configuration of the 13th embodiment is similar to that of the 12th embodiment of Fig. 42, except that the FFT result storage means 5001 stores the FFT result information as shown in Fig. 46.

The FFT result information comprises the information on the frequency and the current frequency component of the FFT result for each block (instance group).

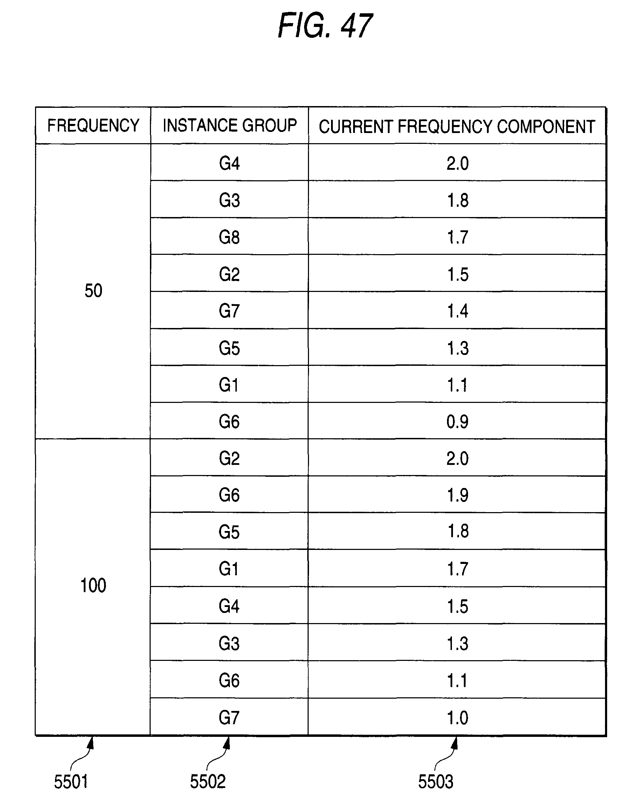

The sort result storage means 5003 stores the sort result information calculated by the FFT result sort means 5002 as shown in Fig. 47.

The sort result information comprises one or more set of FFT result information on the circuit to be analyzed, each consisting of a block name (instance group name) and a current frequency component for each frequency.

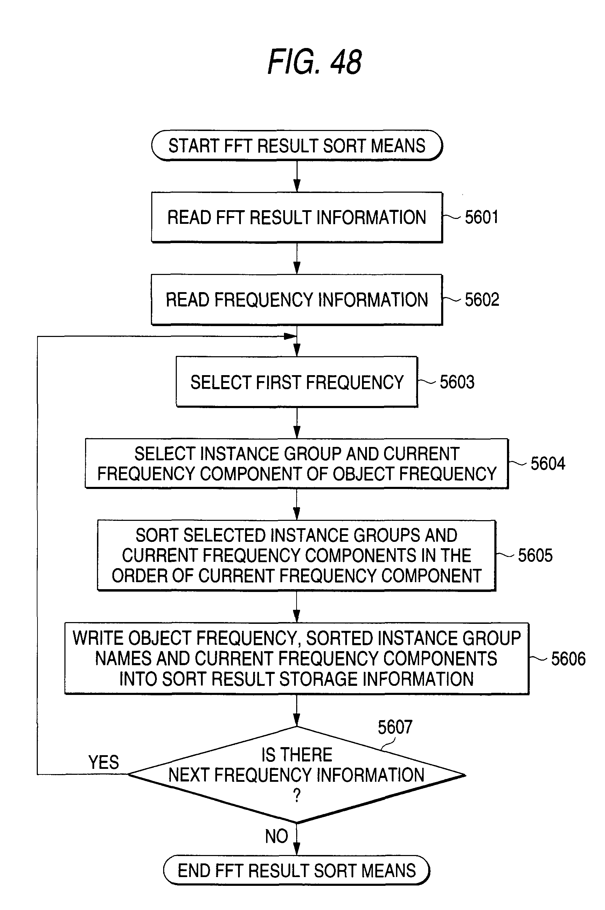

The FFT result sort means 5002 executes the analysis according to the flow chart as shown in Fig. 48.

First, step 5601 reads the FFT result information of Fig. 46 stored in the FFT result storage means 5001.

Then, step 5602 reads the frequency information contained in the FFT result information and step 5603 selects

**EP 1 132 745 A2**

the first frequency.

Then, step 5604 selects all the blocks (instance groups) and current frequency components corresponding to the frequencies being examined, and step 5605 sorts the selected blocks (instance groups) and the current frequency components in the order of current frequency component.

Step 5606 writes into the sort result storage information the frequencies being examined and the sorted block names (instance group names) and current frequency components.

The above sequence of steps from 5604 to 5606 is repeated until all the frequency information listed in the FFT result information is completely processed. When the processing is finished, the FFT result sort means is ended.

As described above, the user interface technique of performing the FFT on the current waveform for each block (instance group) and sorting the block names (instance group names) in the order of current frequency component noise can identify the noise-relevant block (instance group).

(14th Embodiment)

In the conventional EMI analysis means for LSI, it is general practice to report only the FFT result. This method takes very long to locate the EMI cause.

To deal with this problem, this embodiment adopts a user interface technique of performing calculation for each group of identification numbers that identify registers, combined circuits and memories listed in advance in the cell library information.

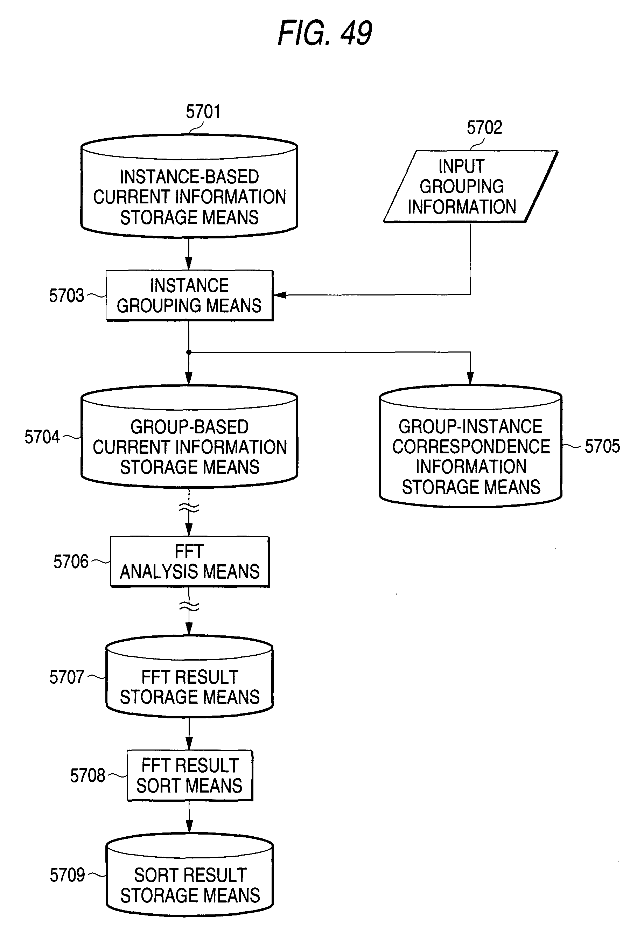

Fig. 49 shows a configuration of the EMI analysis apparatus according to the 14th embodiment of this invention. The EMI analysis apparatus shown in the figure comprises an instance-based current information storage means 5701, a grouping information input 5702, an instance grouping means 5703, a group-based current information storage means 5704, a group-instance correspondence information storage means 5705, an FFT analysis means 5706, an FFT result storage means 5707, an FFT result sort means 5708, and a sort result storage means 5709.

Of these, the instance-based current information storage means 5701, the group-based current information storage means 5704, the group-instance correspondence information storage means 5705, the FFT result storage means 5001, and the sort result storage means 5003 are allocated to the external storage device of the computer system described earlier.

The instance grouping means 5703, the FFT analysis means 5706 and the FFT result sort means 5002 are stored in the input/output calculation unit of the computer system as a group of programs each having steps as its constitutional elements.

Next, individual elements making up the EMI analysis apparatus of Fig. 49 and the procedure for analyzing the EMI will be explained.

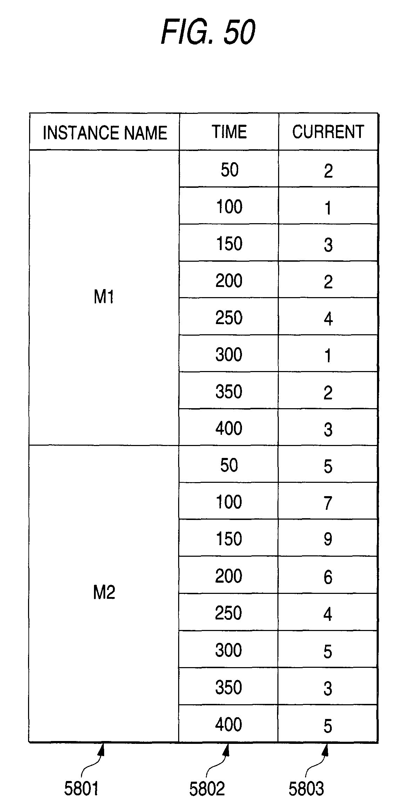

The instance-based current information storage means 5701 stores current information for each instance which consists of time and current value as shown in Fig. 50.

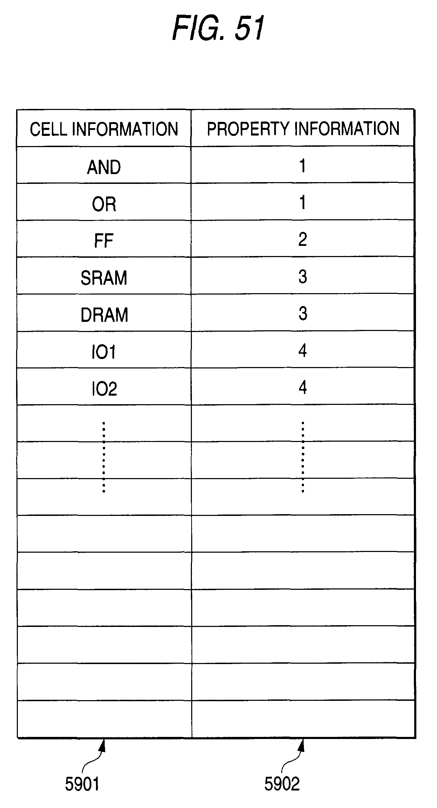

The grouping information input 5702 has cell information and property information indicating a functional property of the cell, as shown in Fig. 51.

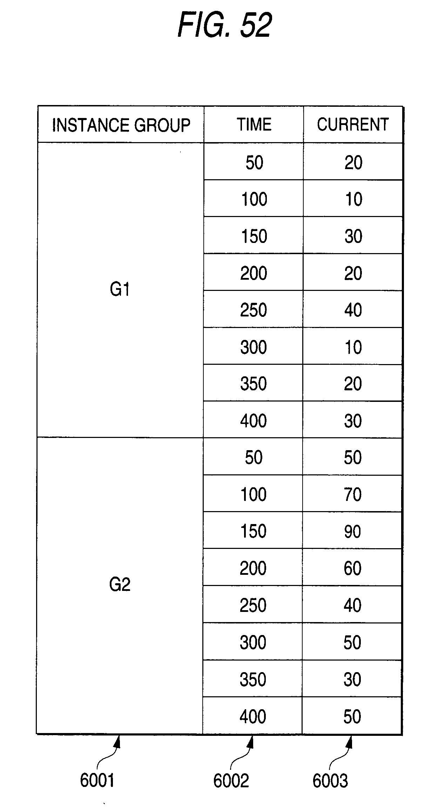

The group-based current information storage means 5704 stores current summation result information at each point in time for the instances contained in each group, which consists of time and current value as shown in Fig. 52.

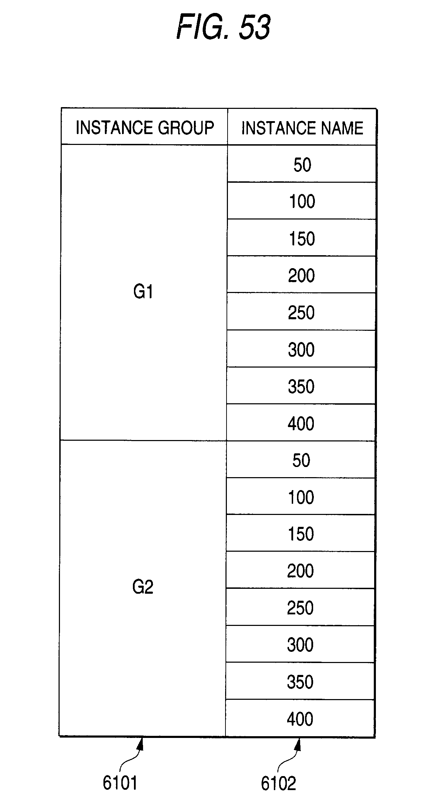

The group-instance correspondence information storage means 5705 stores information indicating instance names belonging to each block, as shown in Fig. 53.

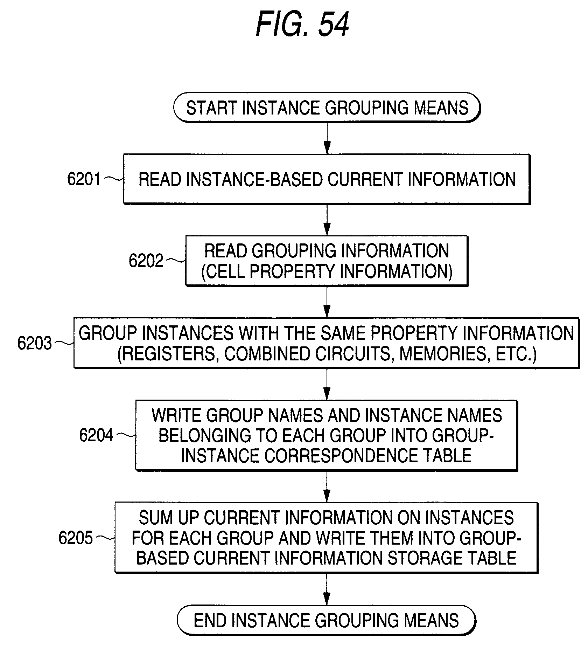

The instance grouping means 5703 executes the analysis according to the flow chart as shown in Fig. 54.

First, step 6201 reads the current information for each instance of Fig. 50 stored in the instance-based current information storage means 5701.

Then, step 6202 reads the property information of Fig. 51 representing the cell information and the functional property of each cell.

Then, step 6203 looks up the table of Fig. 51, sets the functional properties for all instances according to the cell information, and classifies all the instances into groups of registers, combined circuits and memories with the same properties.

Step 6204 gives a group name to each group and writes the group names and the instance names belonging to each group into the group-instance correspondence information of Fig. 53.

Further, step 6205 sums up the current information of instances in each group and writes them into the group-based current information storage means.

As described above, the technique of sorting the instances in each functional group in the order of current frequency component noise can identify the functional block that affects noise.

(15th Embodiment)

In the conventional EMI analysis means for LSI, it is general practice to report only the FFT result. This method takes very long to locate the EMI cause.

To deal with this problem, this embodiment adopts a user interface technique of performing calculation according to a clock tree connected to a clock input terminal.

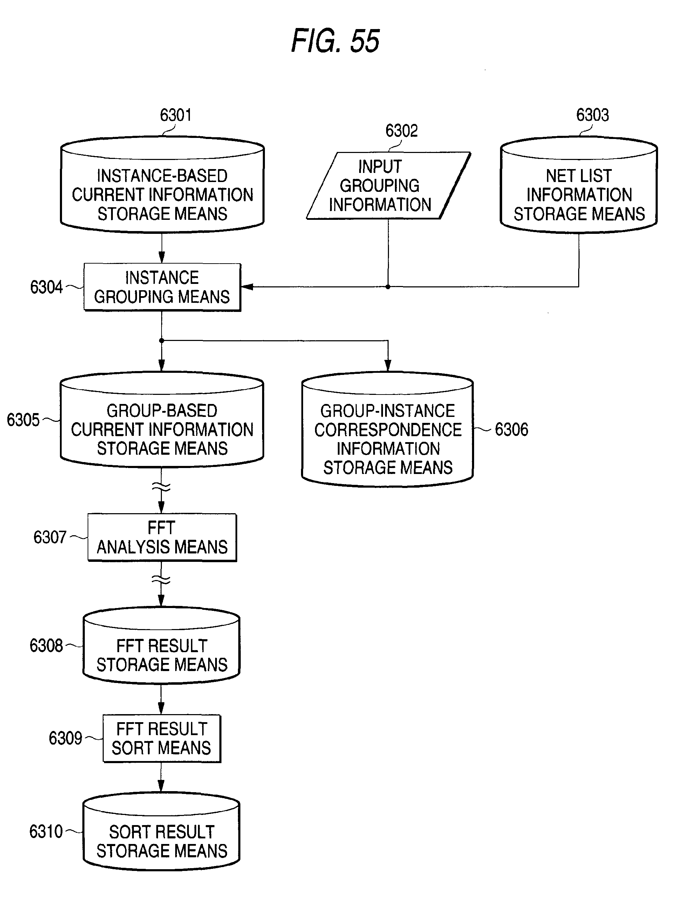

Fig. 55 shows a configuration of the EMI analysis apparatus according to one embodiment of this invention.

The EMI analysis apparatus shown in the figure comprises an instance-based current information storage means 6301, a grouping information input 6302, a netlist information storage means 6303, an instance grouping means 6304, a group-based current information storage means 6305, a group-instance correspondence information storage means 6306, an FFT analysis means 6307, an FFT result storage means 6308, and an FFT result sort means 6309, and a sort result storage means 6310.

Of these, the instance-based current information storage means 6301, the netlist information storage means 6303, the group-based current information storage means 6305, the group-instance correspondence information storage means 6306, the FFT result storage means 6308, and the sort result storage means 6310 are allocated to the external storage device of the computer system described earlier.

The instance grouping means 6304, the FFT analysis means 6307, and the FFT result sort means 6309 are stored in the input/output calculation unit of the computer system as a group of programs each having steps as its constitutional elements.

Next, individual elements of Fig. 55 making up the EMI analysis method and the procedure for analyzing EMI will be explained.

The instance-based current information storage means 6301 stores current information for each instance consisting of time and current value, as shown in Fig. 50.

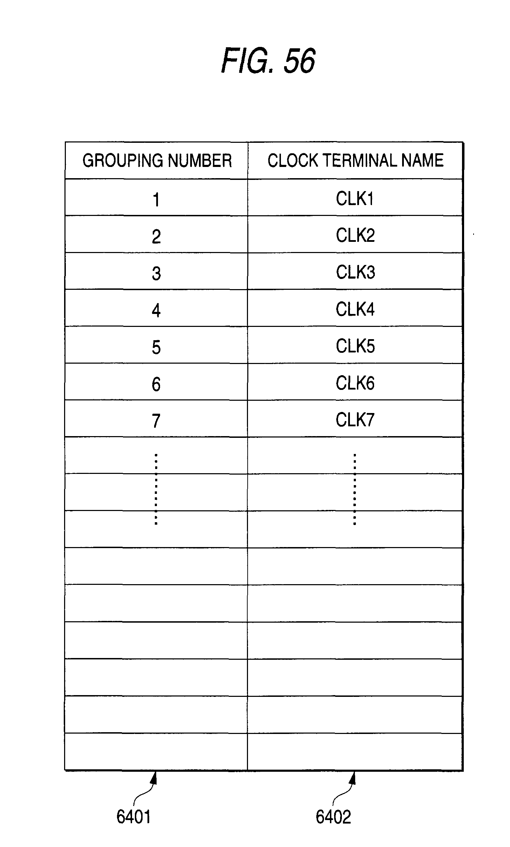

The grouping information input 6302 has a group number and a clock terminal name, as shown in Fig. 56.

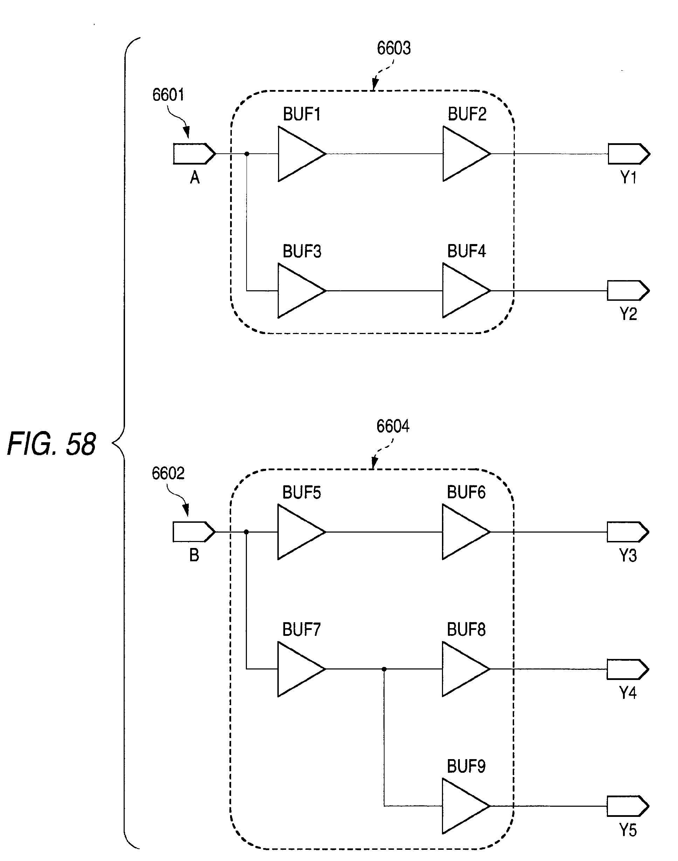

The netlist information storage means 6303 stores the netlist information as shown in Fig. 58.

The group-based current information storage means 6305 stores the current summation result information at each point in time for the instances contained in each group, which consists of time and current value as shown in Fig. 52.

The group-instance correspondence information storage means 6306 shows instance names belonging to each block as shown in Fig. 53.

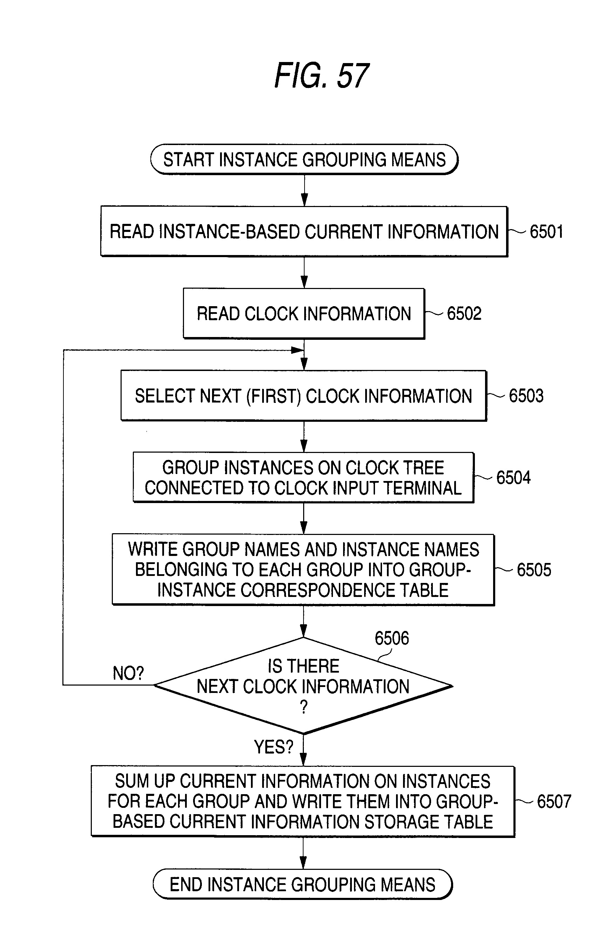

The instance grouping means 6304 executes the analysis according to the flow chart of Fig. 57.

First, step 6501 reads the current information for each instance of Fig. 50 stored in the instance-based current information storage means 6301.

Then, step 6502 reads information on grouping number and clock terminal name shown in Fig. 56.

Then, step 6503 takes in the first clock of the clock information read in.

Further, based on the input terminal 6601 and the internal instance connection information shown in Fig. 58, step 6504 groups all the instances on the clock tree connected to the clock input terminal as one group.

Step 6505 gives a group name to each group and writes the group names and the instance names belonging to each group into the group-instance correspondence information.

The sequence of steps from 6503 to 6506 is repeated until the processing is completed for all clocks.

Step 6507 sums up the current information for instances in each group and writes the total current information into the group-based current information storage means of Fig. 52. Thus, the instance grouping processing is ended.

The configuration ranging from the FFT result storage means 6308 to the sort result storage means 6310 is similar to that of the 13th embodiment.

As described above, the technique of dividing, for each clock pin, all the instances into clock trees connected to associated clock input terminals and another group of instances not belonging to these clock trees and then sorting them in the order of current frequency component noise makes it possible to identify the clock terminal that affects noise and to check how seriously it affects the whole circuits.

(16th Embodiment)

In the conventional EMI analysis means for LSI, it is general practice to report only the FFT result. This method takes very long to locate the EMI cause.

To deal with this problem, this embodiment adopts a user interface technique of performing static timing analysis (STA) on those locations whose states change simultaneously, grouping instances having the same timings, performing the FFT on the current waveforms in each group as in the 13th embodiment, and sorting them in the order of current frequency component noise.

The configuration of the 16th embodiment is similar to that of the 15th embodiment, except that the grouping information input 6302 is not used.

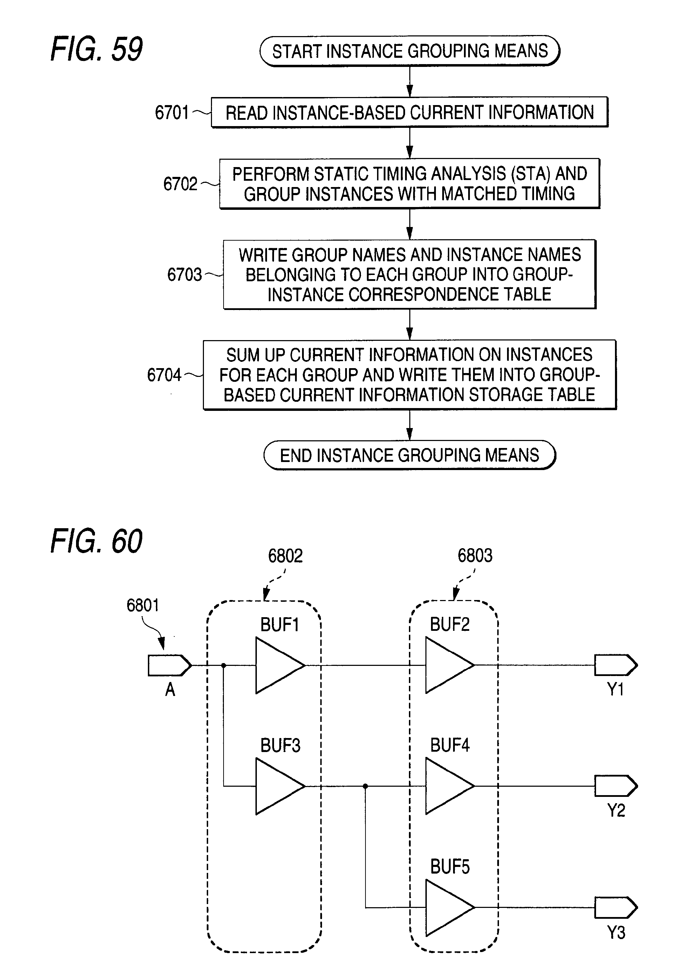

The instance grouping means 6304 executes the analysis operation according to the flow chart of Fig. 59.

Step 6701 reads the current information for each instance of Fig. 50 stored in the instance-based current information storage means 6301.

Step 6702 performs the static timing analysis (STA) using the netlist information for the internal instances shown in Fig. 60 and groups the instances with the same signal status change timings into the same group.

Step 6703 gives a group name to each group and writes the group names and the instance names belonging to each group into the group-instance correspondence information shown in Fig. 53.

Step 6704 sums up the current information for instances in each group and writes the result into the group-based current information storage means shown in Fig. 52. Now, the instance grouping processing is ended.

The configuration ranging from the FFT result storage means 6308 to the sort result storage means 6310 is similar to that of the 13th embodiment.

As described above, the technique of sorting the instances in the order of current frequency component noise in each group of instances whose statuses change simultaneously (within a predetermined time interval) can identify a noise-affecting instance group.

(17th Embodiment)

In the conventional EMI analysis means for LSI, it is general practice to report only the FFT result. This method takes very long to locate the EMI cause.

To deal with this problem, this embodiment adopts a user interface technique of displaying, from the group information obtained in the 14th, 15th and 16th embodiments, instances with large current frequency component noise and their noise levels.

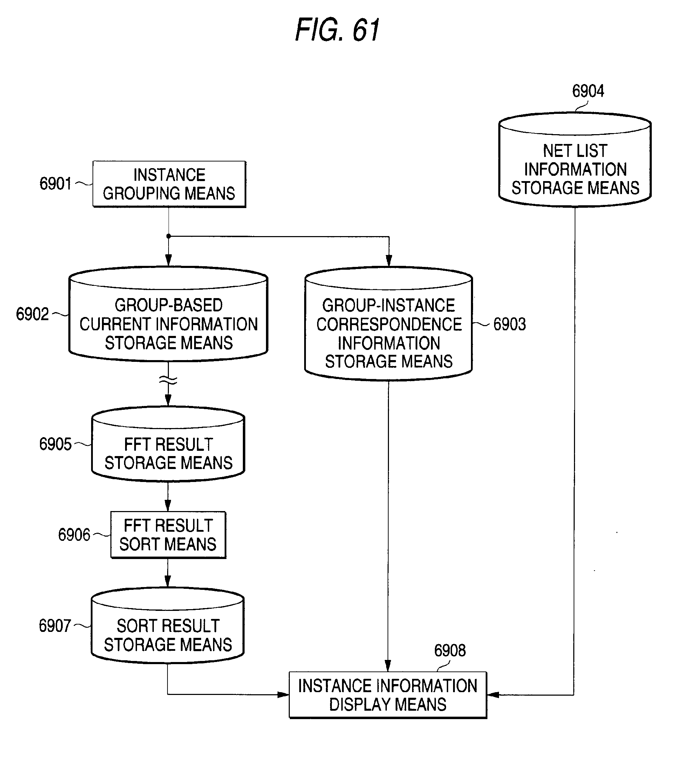

Fig. 61 shows a configuration of the EMI analysis apparatus according to one embodiment of this invention.

The EMI analysis method shown in the figure has an instance information display means 6908 added to the configuration similar to those of the embodiments 14-16 consisting of an instance grouping means 6901, a group-based current information storage means 6902, a group-instance correspondence information storage means 6903, a netlist information storage means 6904, an FFT result storage means 6905, an FFT result sort means 6906, a sort result storage means 6907.

The instance information display means 6908 is stored in the input/output calculation unit of the computer system described earlier as a group of programs each having steps as its constitutional elements.

Next, individual elements of Fig. 61 making up the EMI analysis method and the procedure for analyzing the EMI will be explained.

The configuration from the instance grouping means 6901 to the sort result storage means 6907 is similar to those of the embodiments 14, 15 and 16.

The instance information display means 6908 can display an instance name representing a location having large current frequency component noise, based on the sort result information on block names and current frequency components like the one shown in Fig. 47 stored in the sort result storage means 6907 and also the group-instance correspondence information on block names (instance group names) and instance names shown in Fig. 53 which is generated by the instance grouping means 6901 and stored in the group-instance correspondence information storage means 6903.

In the case of the embodiments 15 and 16, it is possible to display locations with large current frequency component noise by matching the locations with the netlist information shown in Fig. 58 that is stored in the netlist information storage means 6904.

This method can also display such locations by replacing the netlist information with the corresponding layout information and matching the locations in question with the layout position information.

The above method therefore offers the advantages of being able to facilitate the identifying of noise-affecting locations among the register group, combined circuit group and memory group in the embodiment 14, noise-affecting locations in a clock tree connected to the clock input terminal in the embodiment 15, and noise-affecting locations with simultaneous status changes in the embodiment 16.

(18th Embodiment)

In the conventional EMI analysis means for LSI, it is general practice to report only the FFT result. This method takes very long to locate the EMI cause.

This embodiment adopts a user interface technique of performing calculation (of Fourier series) for only a predetermined frequency without performing the FFT in the embodiments 14-17 and displaying only the information of the calculated result.

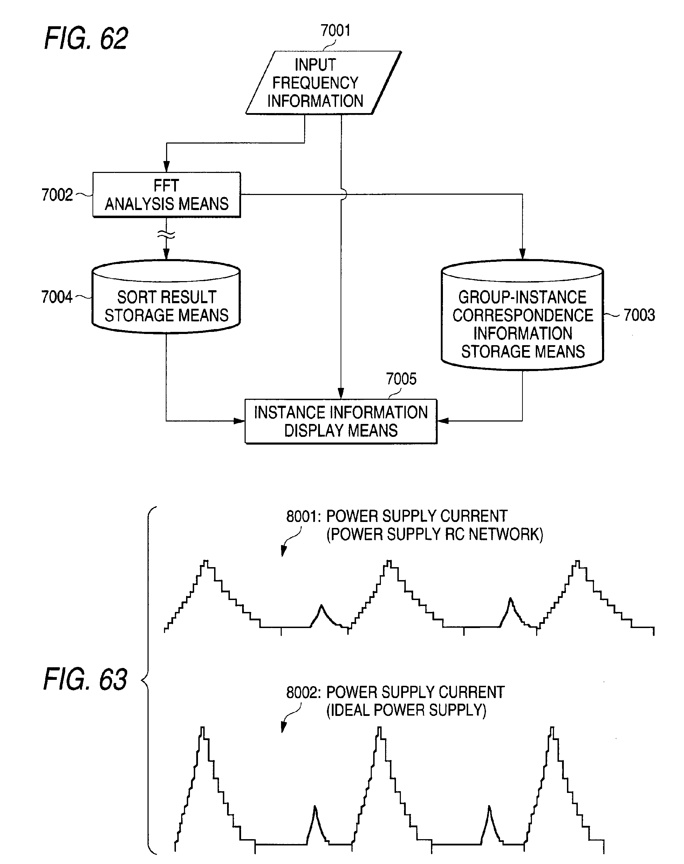

Fig. 62 shows a configuration of the EMI analysis apparatus according to one embodiment of this invention. The EMI analysis method shown in the figure has a frequency information input 7001 and an instance information display means 7005, both added to a configuration similar to those of the embodiments 14-17 consisting of an FFT analysis means 7002, a group-instance correspondence information storage means 7003 and a sort result storage means 7004.

The instance information display means 7005 is stored in the input/output calculation unit of the computer system as a group of programs each having steps as its constitutional elements.

Next, individual elements making up the EMI method of Fig. 62 and the procedure for analyzing EMI will be described.

The sort result storage means 7004 is similar to those used in the embodiments 14-17.

The sort result storage means 7004 has the information on frequency values to be analyzed.

The FFT analysis means 7002 calculates the current frequency component $\int i(t)\sin(n\omega t)dt$ for the frequency entered by the frequency information input 7001, rather than using the commonly used FFT (Fourier transform).

The instance information display means 7005 can display an instance name representing a location having large current frequency component noise, based on the sort result information on block names and current frequency components like the one shown in Fig. 47 stored in the sort result storage means 7004 and also the group-instance correspondence information on block names (instance group names) and instance names shown in Fig. 53 which is stored in the group-instance correspondence information storage means 7003.

This method has the advantage of being able to locate a noise cause affecting a particular frequency faster than the conventional method.

This method is effective where a frequency to be analyzed is already determined, as in a stage of identifying the noise cause after performing the FFT analysis on the chip.

(19th to 23rd Embodiments)

The chip EMI analysis is generally performed by FFT-analyzing the power supply current of the chip. As shown in Fig. 63, the waveform of the power supply current in the chip is deformed by the influences of impedance components of resistance (or represented as R) and capacitance (or represented as C) of a power supply wire. Hence, the impedance components of the power supply wire cannot be ignored if the EMI analysis is to be made with high precision.

In the conventional EMI analysis method, there are roughly two ways of incorporating the impedance effect of the power supply wire into the calculation of the power supply current.

(A) The transistor level netlist attached with RC of the power supply wire is subjected to the transient analysis using the SPICE simulator to calculate the power supply current.

(B) The power supply wire netlist comprising a current source modeled from the RC of a power supply wire and from the current waveforms of a plurality of transistors when given an ideal power supply is subjected to the transient analysis using the SPICE simulator to calculate the power supply current.

The method (A) can calculate the power supply current with the highest precision. The method (B) aims at increasing the processing speed by calculating in advance the current flowing through the transistors when given an ideal power supply.

The method using the (A) and (B) transient analysis is not realistic as the EMI analysis because the LSI is so large and complex that the processing time takes very long. The technique (B) of simplifying the power supply wire RC network is limited to an array-structured circuit configuration and thus cannot be a solution to the problem.

This embodiment is a technique to realize at the gate level an EMI analysis considering the effects of impedance by incorporating the effects of impedance of power supply wires into the calculation of the power supply current without using the transient analysis.

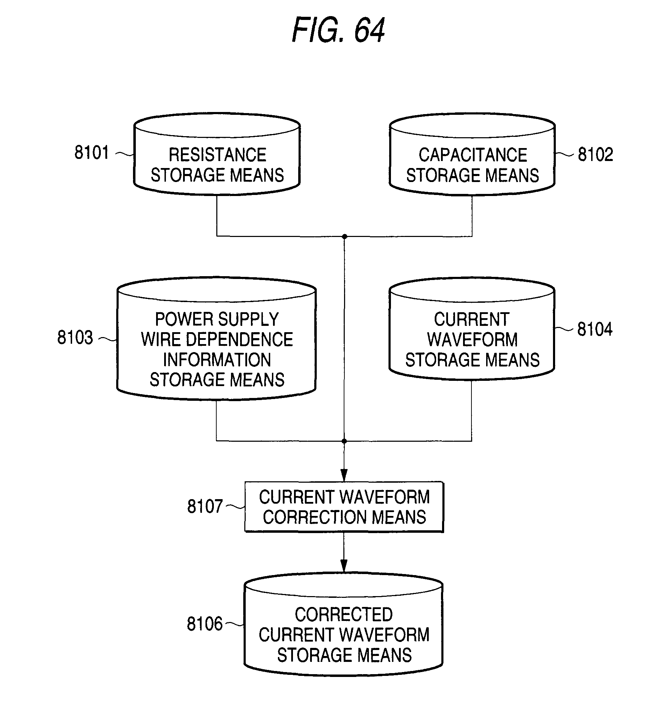

Fig. 64 shows a configuration of the EMI analysis method according to embodiments 19-23 of this invention.

The EMI analysis method shown in Fig. 64 comprises a resistance storage means 8101, a capacitance storage means 8102, a power supply wire dependence information storage means 8103, a current waveform storage means 8104, a current waveform correction means 8107, and a corrected current waveform storage means 8106.

Of these, the resistance storage means 8101, the capacitance storage means 8102, the power supply wire dependence information storage means 8103, the current waveform storage means 8104, and the corrected current waveform storage means 8106 are allocated to the external storage device of the computer system described earlier.

The current waveform correction means 8107 is stored in the power supply-considered calculation unit of the computer system as a group of programs each having steps as its constitutional elements.

The configuration of the 19th embodiment shows an overall concept of the EMI analysis method of Fig. 64.

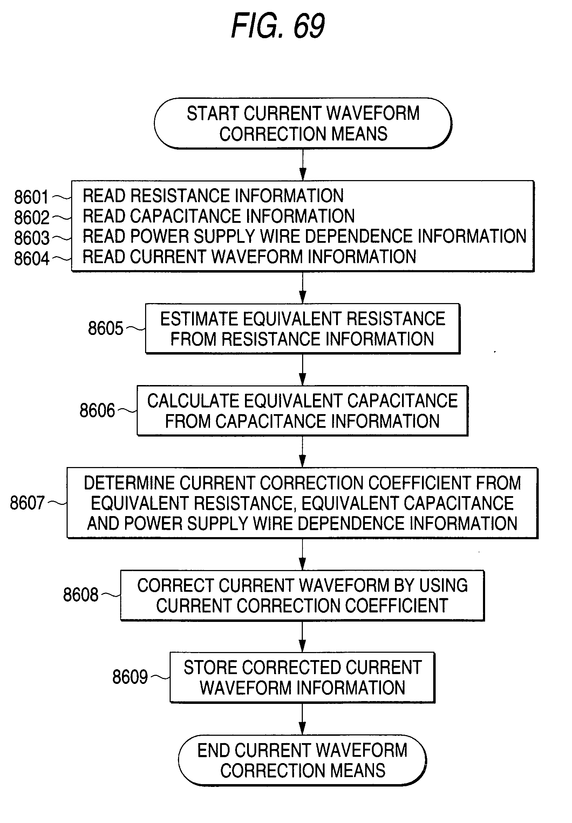

The configuration of the 20th embodiment uses tables in step 8603 and step 8607 of the flow chart of the current waveform correction means shown in Fig. 69.

The configuration of the 21st embodiment uses mathematical expressions in step 8603 and step 8607 of the flow chart of the current waveform correction means shown in Fig. 69.

The configuration of the 22nd embodiment performs a base correction in step 8608 of the flow chart of the current waveform correction means shown in Fig. 69.

The configuration of the 23rd embodiment performs an area correction in step 8608 of the flow chart of the current waveform correction means shown in Fig. 69.

Next, individual elements making up the EMI analysis method of Fig. 64 will be explained.

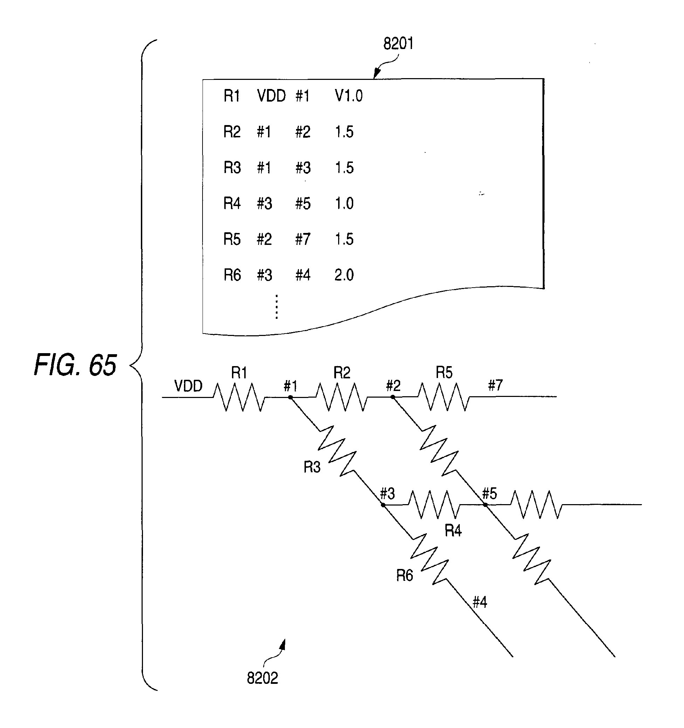

The resistance storage means 8101 stores in advance information on resistance of a power supply circuit as shown in Fig. 65 that can be obtained by LPE from the layout data.

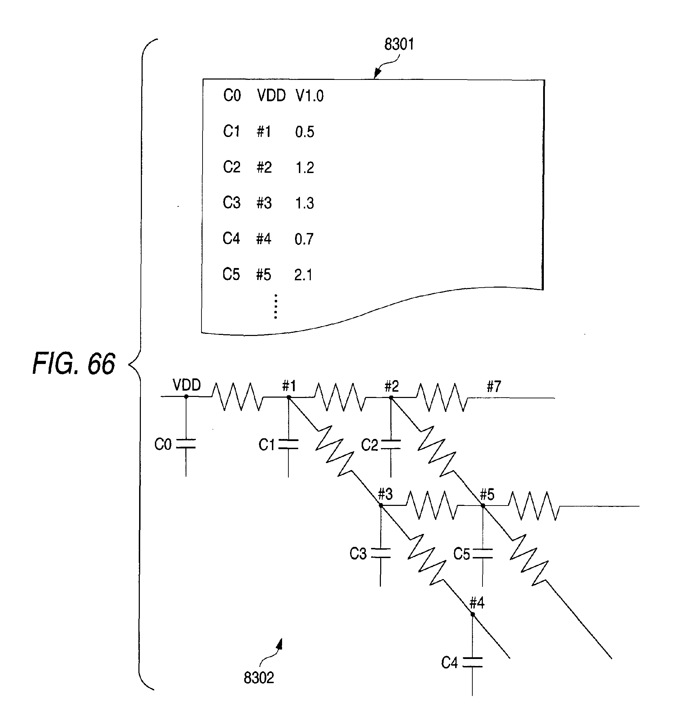

The capacitance storage means 8102 stores in advance information on capacitance of a power supply circuit as shown in Fig. 66 that can be obtained by LPE from the layout data.

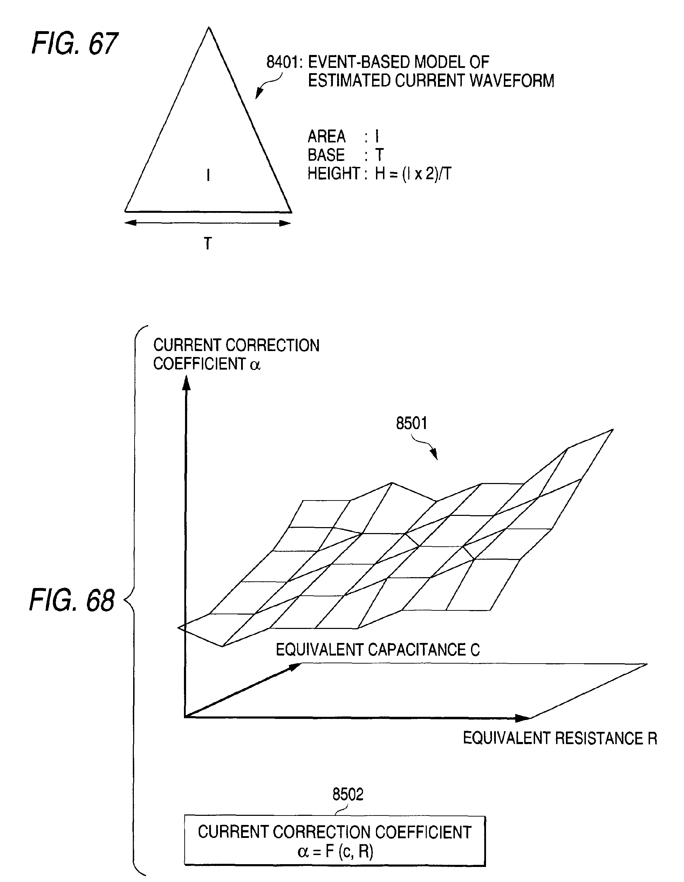

The power supply wire dependence information storage means 8103 stores in advance power supply wire dependence information as shown in Fig. 68 that is used to correct the estimated current waveform as an ideal power supply based on an equivalent capacitance and equivalent resistance of the power supply circuit.

The current waveform storage means 8104 stores in advance the estimated current waveform information as shown in Fig. 67 calculated by the event-driven type simulator.

This estimated current waveform information includes a time at which an event occurred and a base and height of a triangle.

The corrected current waveform storage means 8106 stores the corrected current waveform information calculated by the current waveform correction means 8107.

The current waveform correction means 8107 has a process of determining a correction coefficient for correcting the current waveform from the resistance information 8101, capacitance information 8102 and power supply wire dependence information 8103, and a process of using the correction coefficient thus obtained and correcting the current waveform 8104 to obtain the corrected current waveform 8106.

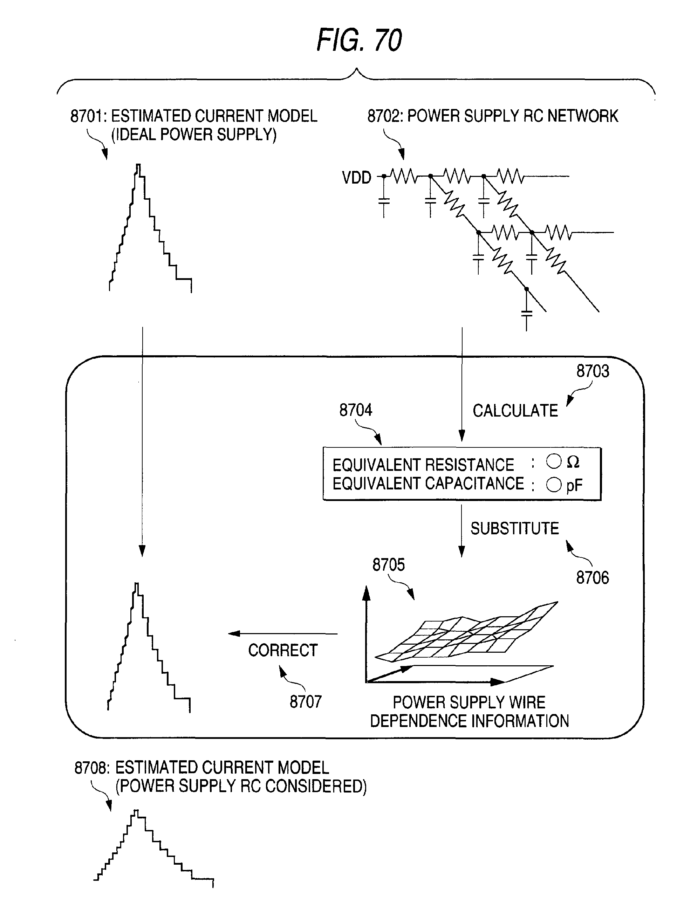

Next, we will explain about the current waveform correction means 8107 which corrects the current waveform by using the resistance information of Fig. 65, the capacitance information of Fig. 66 and the power supply wire dependence information of Fig. 68. Fig. 70 shows a conceptual diagram of the current waveform correction means 8107.

The current waveform correction means 8107 executes the analysis operation according to the flow chart of Fig. 69.

Step 8601 reads the resistance information shown at 8201 of Fig. 65 from the resistance storage means 8101. This resistance information represents information on a resistance circuit indicated at 8202 of Fig. 65, containing resistor names, node names at both ends of each resistor and resistance values.

Step 8602 reads the capacitance information shown at 8301 of Fig. 66 from the capacitance storage means 8102. This capacitance information represents information on capacitances added to the resistance network indicated at 8302 of Fig. 66, containing capacitor names, node names and capacitance values.

Step 8603 reads the power supply wire dependence information of Fig. 68 from the power supply wire dependence information storage means 8103.

In the embodiment, the power supply wire dependence information is provided in the form of a table (8501 of Fig. 68) which is prepared in advance for each current correction item by the transient analysis and which represents the relation between the equivalent resistance, the equivalent capacitance and the current correction coefficient value. The procedure for generating the table will be explained by referring to Fig. 67.

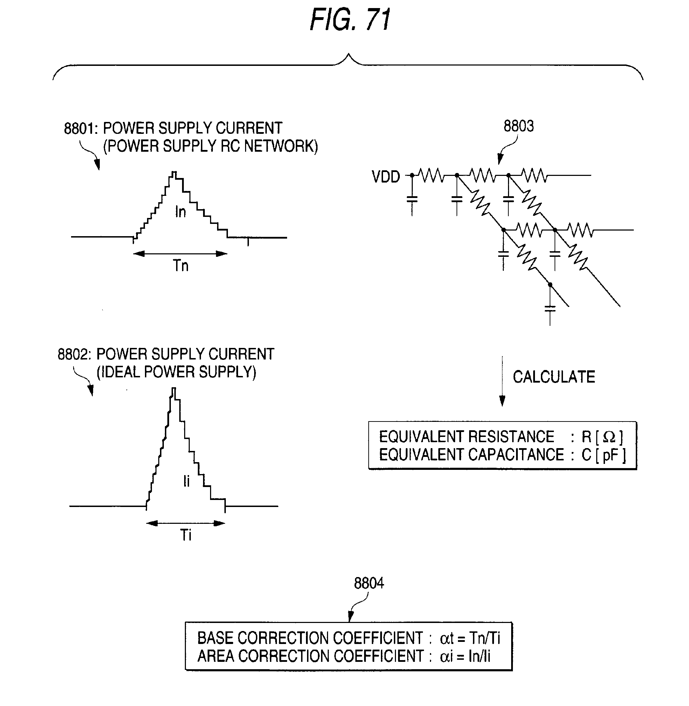

(1) First, the netlist data including RC of the power supply wire is prepared and subjected to the transient analysis to calculate the power supply current waveform. From the power supply current waveform thus obtained, a peak and a current waveform portion formed around that peak (8801 of Fig. 71) are extracted. This current waveform has high precision as it is obtained by the technique (A) that was introduced in the above description as an example of the conventional method.

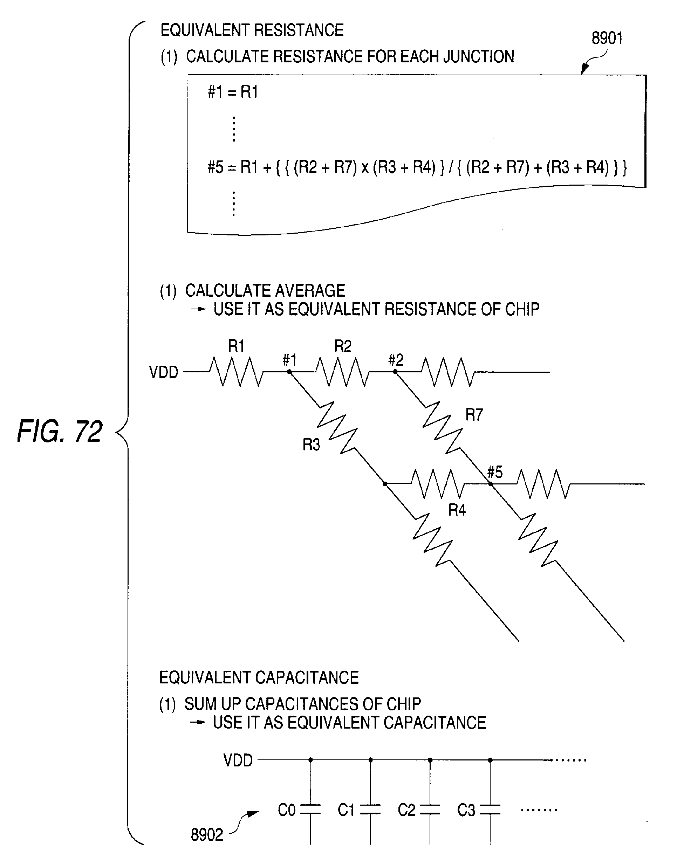

(2) The equivalent resistance of the power supply wire of the above netlist data is determined. How to determine the equivalent resistance is shown at 8901 of Fig. 72. The equivalent resistance of the chip is the sum of the equivalent resistances of all instances divided by the number of instances. For the sake of simplicity, it is assumed that the instances are connected to junctions of the resistor network. First, the equivalent resistance is calculated for each junction by using the mutual conversion between a ring wiring and a star wiring, forming a bridge circuit and using the Kirchhoff's law to solve the DC network. Next, taking the average of the equivalent resistances for all junctions can determine the equivalent resistance for the chip (8803 in Fig. 71).

(3) The equivalent capacitance of the power supply wire in the netlist data is determined. How to determine the equivalent capacitance is shown at 8902 of Fig. 72. The equivalent capacitance of the chip is the sum of decoupling capacitances in the chip. By summing all capacitance values of capacitors read in, the equivalent capacitance of the chip (8803 of Fig. 71) can be determined.

(4) Netlist data removed of the RC of the power supply wire of the above netlist data is prepared. Next, the transient analysis is performed on the prepared netlist data to calculate the power supply current waveform. From the power supply current waveform thus obtained are extracted a peak and a current waveform portion around that peak (8802 of Fig. 71). The current waveform assumes that the power supply wire is an ideal supply and does not consider any impedance of the power supply wire.

(5) Based on the ratios in base and area between the power supply current waveform (8801 of Fig. 71) determined by (1) and the power supply current waveform (8802 of Fig. 71) determined by (4), a current correction coefficient $\alpha t$ for base and a current correction coefficient $\alpha i$ for area (8804 of Fig. 71) are calculated.

(6) The equivalent resistance of the chip, the equivalent capacitance of the chip and the current correction coefficients $\alpha$ are plotted in 8501 of Fig. 68.

(7) The procedures from (1) to (6) are performed for a plurality of test data to complete the table.

In the above 21st embodiment, the mathematical expression that is calculated in advance for each current correction item by the transient analysis and statistic processing is the power supply wire dependence information. An example procedure for calculating the mathematical expression is explained below.

(1) Database is generated according to the above table generating procedure (1) to (7).
(2) The statistic processing is performed on this database to generate, for each current correction item, a mathematical expression that determines the current waveform correction coefficient from the equivalent resistance and the equivalent capacitance (8502 of Fig. 68).

Then, step 8604 reads an event-based model for the estimated current waveform of Fig. 67 from the current waveform storage means 8104.

Step 8605 calculates the equivalent resistance of the chip from the resistance information. The power supply circuit is treated as a DC network in this calculation as in the table generating procedure (2).

Step 8606 calculates the equivalent capacitance of the chip from the capacitance information. As in the above table generating procedure (3), the equivalent capacitance of the chip is determined by summing up all the capacitances.

Step 8607 applies the equivalent resistance obtained by step 8604 and the equivalent capacitance obtained by step 8605 to the power supply wire dependence information 8103 for each current correction item to determine the current correction coefficient for the circuit being analyzed.

In the 20th embodiment, the correction coefficient is determined from the table at 8501 of Fig. 68. If we let the current correction coefficient for base be $\alpha t$, the current correction coefficient for area $\alpha i$, the base correction table $\chi i$, the equivalent resistance R, and the equivalent capacitance C, then

$$\alpha t = \chi t \, (R, C)$$

$$\alpha i = \chi i \, (R, C)$$

As an example, when the equivalent resistance for the chip of 10 $\Omega$ and the equivalent capacitance for the chip of 100 pF are substituted in each current correction table, the current correction coefficient for base at and the current correction coefficient for area $\alpha i$ are determined by

$$\alpha t = \chi t \, (10, 100 \times 10E - 12) = 1.3$$

$$\alpha i = \chi i \, (10, 100 \times 10E - 12) = 0.8$$

Here (100 x 10E - 12) represents $100 \times 10^{-12}$.

In the 21th embodiment, the correction coefficient is determined from the mathematical shown at 8502 of Fig. 68. When the equivalent resistance is R and the equivalent capacitance is C, suppose that the current correction coefficient for base $\alpha t$ and the current correction coefficient for area $\alpha i$ are given by the following expressions:

$$\alpha t = (R + 3xCx10E + 11) \times 10E - 2 + 1$$

$$\alpha i = (2 \times R + C \times 10E + 11) \times 10E - 2 + 1$$

Then, if the equivalent resistance and equivalent capacitance for the chip determined by the step 8605 and step 8606 are 10 Ω and 100 pF, respectively, the current correction coefficient for base $\alpha t$ and the current correction coefficient for area $\alpha i$ are determined as follows.

$$\alpha t = (10 + 3 \times (10 \times 10E - 12) \times 10E + 11) \times 10E - 2 + 1 = 1.3$$

$$\alpha i = -(2 \times 10 + (100 \times 10E - 12) \times 10E + 11) \times 10E - 2 + 1 = 0.8$$

In the 22nd and the 23rdembodiments, step 8608 corrects the current waveform in the current waveform information 8104 by using the current correction coefficient obtained by the step 8607.

In the 22nd embodiment, the base of the current waveform is corrected by using the current correction coefficient for base obtained by the step 8607. In that case, the area of the current waveform is kept constant.

If the triangle of the current waveform event-based model before correction has an area of 100, a base of 10, a height of 20 and a current correction coefficient for base $\alpha t$ of 1.3, then the area S', base T' and height H' of the current waveform event-based model triangle after being corrected are given by

$$T' = 10 \times 1.3 = 13$$

$$S' = 100$$

$$H' = 2 \times 100 \times 1/13 = 15.4$$

In the 23rd embodiment, the area of the current waveform is corrected by using the current correction coefficient for area obtained by the step 8607. In that case, the base of the current waveform is kept constant.

If the triangle of the current waveform event-based model before correction has an area of 100, a base of 10, a height of 20 and a current correction coefficient for area $\alpha i$ of 0.8, then the area S' , base T' and height H' of the current waveform event-based model triangle after being corrected are given by

$$T' = 10$$

$$S' = 100 \times 0.8 = 80$$

$$H' = 2 \times 100 \times 1/10 = 16$$

Step 8609 stores the corrected current waveform as the corrected current waveform information (8106).

As described above, this embodiment as the 19th embodiment does not use the transient analysis and thus can realize the EMI analysis considering the power supply wire at a faster speed than in the conventional method.

Further, the advantage of using the table in the 20th embodiment is that the correction coefficient calculation method based on the table is effective when the statistical variations are large or when the amount of information used in the correction coefficient calculation is large.

Further, the advantage of using the mathematical expression in the 21st embodiment is that the correction coefficient calculation method based on the mathematical expression produces a small amount of data and is thus effective when the statistical variations are small or when the variable portion in the expression is small.

Further, in the embodiments 19, 20 and 21, the processing time and the amount of data can be optimized by choosing between the mathematical expression and the table according to the nature of the information.

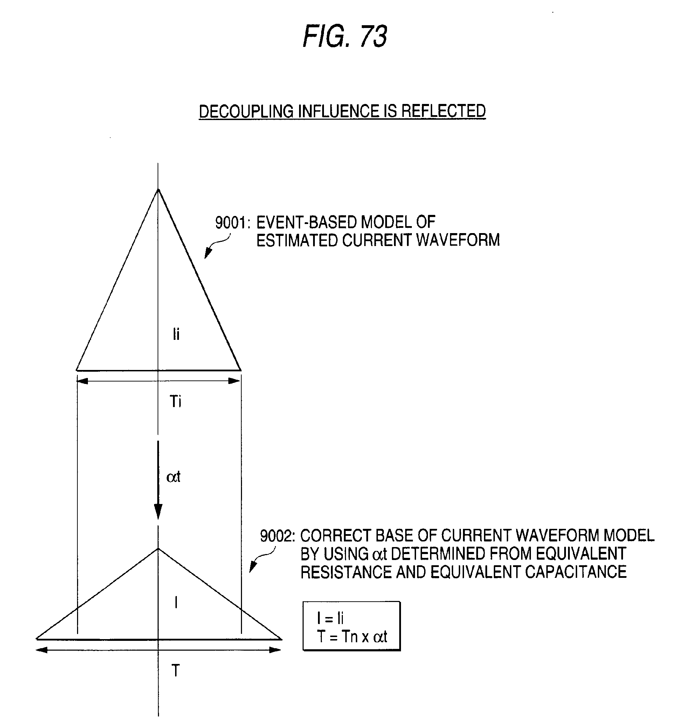

Further, in the embodiment 22, the advantage of correcting the base of the event-based model of the current waveform estimated as an ideal power supply is that optimizing the base of the current waveform can reflect the dullness of the instantaneous current due to the influence of the power supply RC component on the power supply current waveform, as shown in Fig. 73.

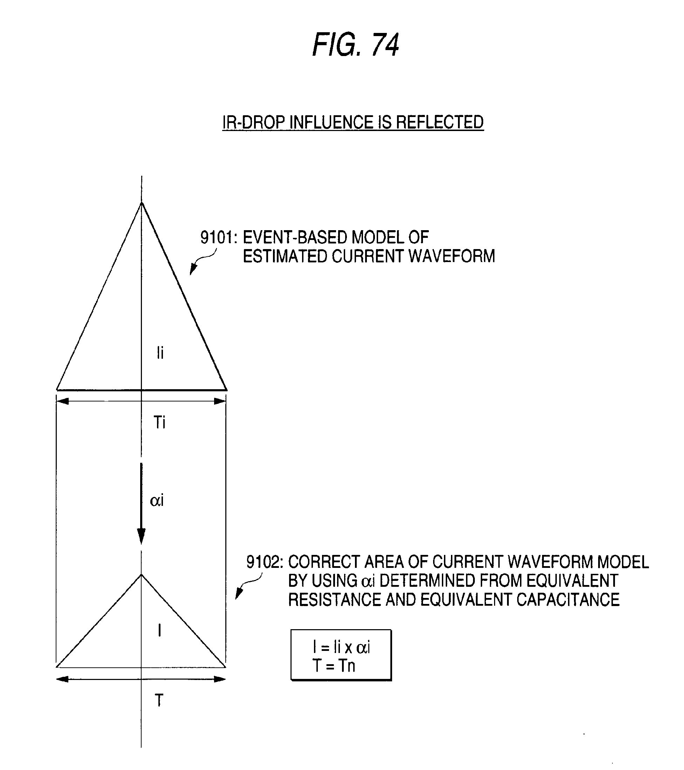

Further, in the embodiment 23, the advantage of correcting the area of the event-based model of the current waveform estimated as an ideal power supply is that optimizing the area of the current waveform can reflect the influence of the power supply voltage drop (IR drop) on the power supply current waveform, as shown in Fig. 74.

(24th Embodiment)

In the embodiment 19, after the chip layout is completed, the equivalent resistance is calculated by solving the resistance information on the power supply network as a DC circuit. While this method provides the equivalent resistance with high accuracy, it has a problem that because the power supply circuit is large in scale, solving the network using the Kirchhoff's law takes long.

The embodiment 24 adopts the post-layout power supply current correction method which uses the chip shape information and calculates the equivalent resistance of the chip by estimation, without calculating the resistance information of the power supply network as the DC circuit.

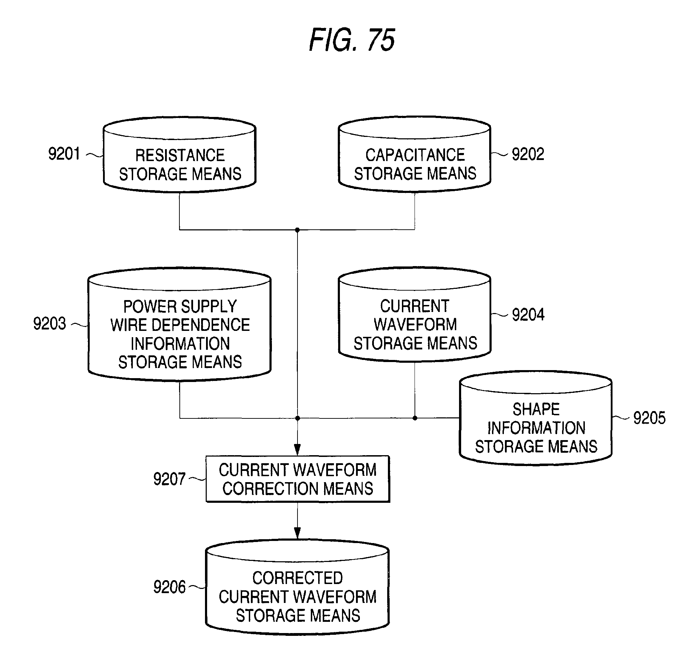

Fig. 75 shows a configuration of the EMI analysis apparatus according to the embodiment 24 of this invention. The EMI analysis apparatus shown in Fig. 75 comprises a resistance storage means 9201, a capacitance storage means 9202, a power supply wire dependence information storage means 9203, a current waveform storage means 9204, a shape information storage means 9205, a current waveform correction means 9207 and a corrected current waveform storage means 9206. Of these, the resistance storage means 9201, the capacitance storage means 9202, the power supply wire dependence information storage means 9203, the current waveform storage means 9204, the shape information storage means 9205, and the corrected current waveform storage means 9206 are allocated to the external storage device of the computer system described earlier.

The current waveform correction means 9207 is stored in the power supply-considered calculation unit of the computer system as a group of programs each having steps as its constitutional elements.

The system configuration of Fig. 75 is equivalent to the shape information storage means 9205 for power supply circuit added to the configuration of Fig. 64.

Individual elements other than the shape information storage means 9205 are similar to those of Fig. 64 as explained in the embodiment 19.

Thus, the shape information storage means 9205 will be described here. The shape information storage means 9205 is the chip shape information that can be obtained at a layout data generation stage.

What is entered into the shape information storage means 9205 includes

- chip area information.

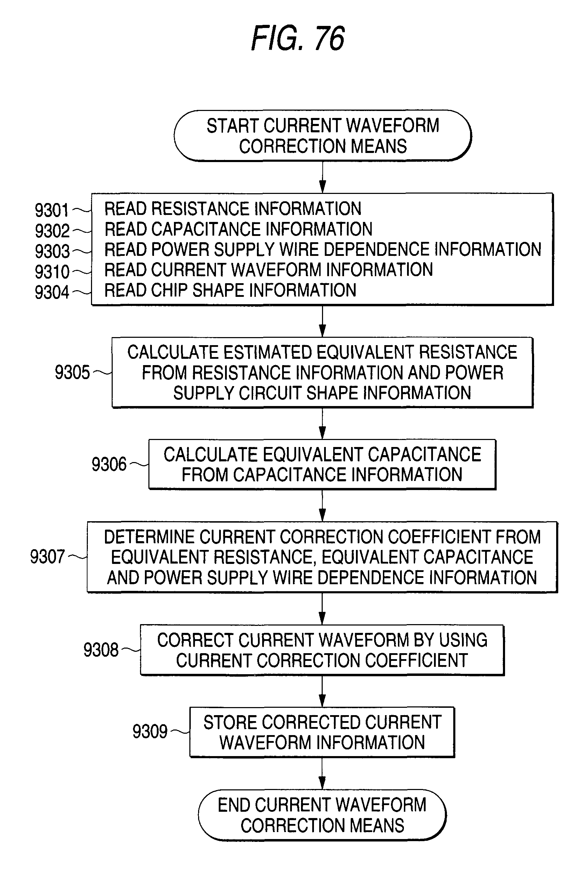

The EMI analysis method according to the embodiment 24 of this invention will be explained by referring to the flow of processing shown in Fig. 76 which is performed by the current waveform correction means 9207 of Fig. 75.

Steps other than 9310 and 9305 are similar to those of Fig. 69 explained in the embodiment 19.

First, step 9301 reads resistance information shown at 8201 of Fig. 65 from the resistance storage means 9201. This resistance information represents information on the resistor network as shown at 8202 of Fig. 65, including resistor names, node names at both ends of each resistor and resistance values of the resistors.

Next, step 9302 reads capacitance information shown at 8301 of Fig. 66 from the capacitance storage means 9202. This capacitance information represents information on the capacitances added to the resistor network shown at 8202 of Fig. 65, containing capacitor names, nodes names and capacitance values of the capacitors.

Then, step 9303 reads power supply wire dependence information of Fig. 68 from the power supply wire dependence information storage means 9203.

Then, step 9304 reads an event-based model of the estimated current waveform of Fig. 71 from the current waveform storage means 8104.

Then, step 9310 reads power supply circuit shape information from the shape information storage means 9205.

Further, step 9305 estimates an equivalent resistance of the chip from the resistance information.

The procedure for estimating the equivalent resistance in this embodiment will be explained.

(1) The resistances of the chip are summed up.
(2) Because the total resistance value calculated in (1) is proportional to the area of the chip, a correction is made by taking a square root of the total resistance.

With the above procedure, the equivalent resistance of the chip is estimated.

As an example, when the chip total resistance is 400 $\Omega$, the chip's equivalent resistance can be estimated to be

$$\sqrt{400} = 20\Omega$$

Further, step 9306 calculates the chip's equivalent capacitance from the capacitance information. This is done by summing up all the capacitances as in the process of generating the table (3) described above.

Then, step 9307 applies the equivalent resistance obtained by step 9305 and the equivalent capacitance obtained by step 9306 to the power supply wire dependence information 9203 for each current correction item to determine a current correction coefficient for the circuit being analyzed.

Then, step 9308 applies the current correction coefficient obtained by step 9307 to the current waveform information 9204 to correct the current waveform.

Finally, step 9309 stores the corrected current waveform as the corrected current waveform information (9206).

As described above, this embodiment does not use the transient analysis and thus can realize the EMI analysis considering the power supply wire at a faster speed than in the conventional method.

Further, because a complex power supply resistance network does not need to be solved during the process of calculating the equivalent resistance of the chip, a faster EMI analysis can be realized, though with a degraded precision.


(25th to 31st Embodiment)

Embodiment 19 proposes a technique of incorporating the influence of the impedance of the power supply wire into the EMI analysis result in the process of calculating the power supply current without using the transient analysis. However, in the embodiment 19, because the resistance and capacitance of the power supply wire must be prepared from the layout data by using the LPE processing, it is necessary to wait for the layout to be completed. As the LSI increases in size, the processing time of the LPE also increases, so that preprocessing before entering the EMI analysis takes time. The embodiments 25 to 31 solve this problem.

This embodiment is a technique of incorporating the influence of impedance of the power supply wire into the EMI analysis result during the process of calculating the power supply current without using the transient analysis. It is also a technique of estimating the equivalent resistance and equivalent capacitance of the power supply circuit of the chip from the information obtained at a stage of floorplan and thereby correcting the current waveform.

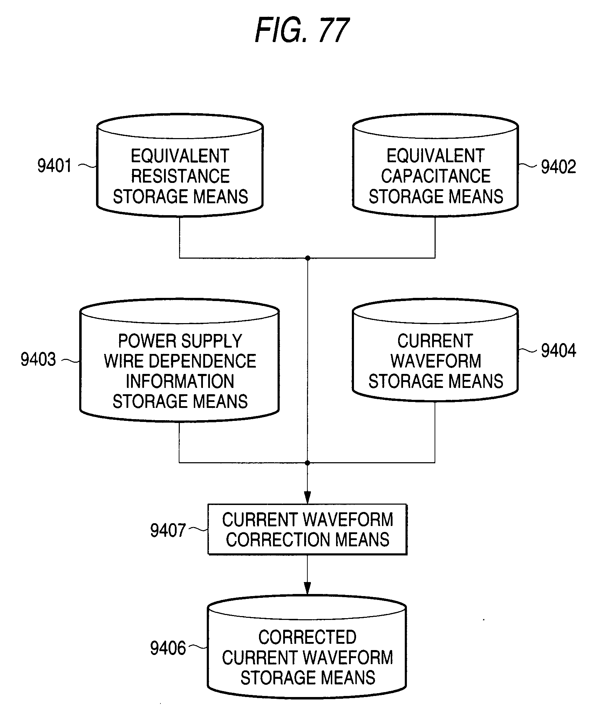

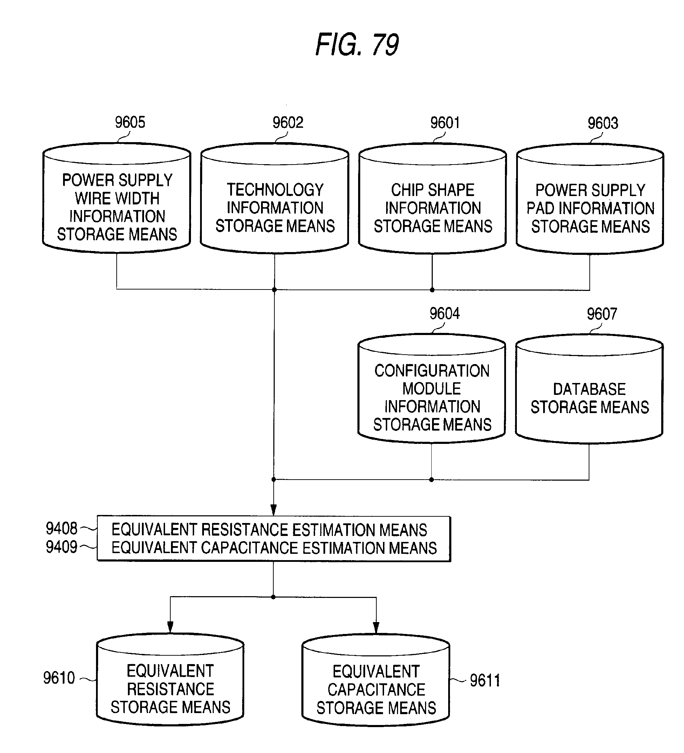

Fig. 77 and Fig. 79 show configurations of the EMI analysis method according to the embodiment 25 to 31.

First, let us explain about the configuration shown in Fig. 77 centering around the current waveform correction means.

The EMI analysis apparatus shown in Fig. 77 comprises an equivalent resistance storage means 9401, an equivalent capacitance storage means 9402, a power supply wire dependence information storage means 9403, a current waveform storage means 9404, a current waveform correction means 9407, and a corrected current waveform storage means 9406.

Of these, the equivalent resistance storage means 9401, the equivalent capacitance storage means 9402, the power supply wire dependence information storage means 9403, the current waveform storage means 9404, and the corrected current waveform storage means 9406 are allocated to the external storage device of the computer system described earlier.

The current waveform correction means 9407 on the other hand is stored in the power supply-considered calculation unit of the computer system as a group of programs each having steps as its constitutional elements.

Individual elements making up the configuration of Fig. 77 will be explained.

The equivalent resistance storage means 9401 stores in advance the equivalent resistance information containing resistance values of the power supply network estimated at the stage of floorplan.

The equivalent capacitance storage means 9402 stores in advance the equivalent capacitance information containing capacitance values of the power supply network estimated at the stage of floorplan.

The power supply wire dependence information storage means 9403 stores in advance in the form of tables and mathematical expressions the information that is used to correct the current waveform estimated as an ideal power supply according to the equivalent capacitance and equivalent resistance of the power supply network.

The current waveform storage means 9404 stores in advance the estimated current waveform information of Fig. 71 calculated by the event-driven type simulator. The estimate current waveform information has information on a time at which an event occurred and a base and height of a triangle.

The corrected current waveform storage means 9406 stores the corrected current waveform information calculated by the current waveform correction means 9407.

The current waveform correction means 9407 comprises a process of determining a correction coefficient for correcting the current waveform from the equivalent resistance information 9401, the equivalent capacitance information 9402 and the power supply wire dependence information 9403, and a process of correcting the current waveform 9404 by the correction coefficient thus obtained to produce the corrected current waveform 9406.

The processing flow of this embodiment will be described later. Now, the configuration of Fig.79 centering on the equivalent resistance estimation means and the equivalent capacitance estimation means will be explained. The configuration of Fig. 79 comprises a chip shape information storage means 9601, a technology information storage means 9602, a power supply pad information storage means 9603, a configuration module information storage means 9604, a power supply wire width information storage means 9605, a database storage means 9607, an equivalent resistance estimation means 9608, an equivalent capacitance estimation means 9609, an equivalent resistance storage means 9610, and an equivalent capacitance storage means 9611.

Of these, the chip shape information storage means 9601, the technology information storage means 9602, the power supply pad information storage means 9603, the configuration module information storage means 9604, the power supply wire width information storage means 9605, the database storage means 9607, the equivalent resistance storage means 9610 and the equivalent capacitance storage means 9611 are allocated to the external storage device of the computer system described earlier.

The equivalent resistance estimation means 9608 and the equivalent capacitance estimation means 9609 are stored in the power supply-considered calculation unit of the computer system as a group of programs each having steps as its constitutional elements.

The configuration of the 25th embodiment shows an overall concept of the EMI analysis method of Fig. 77.

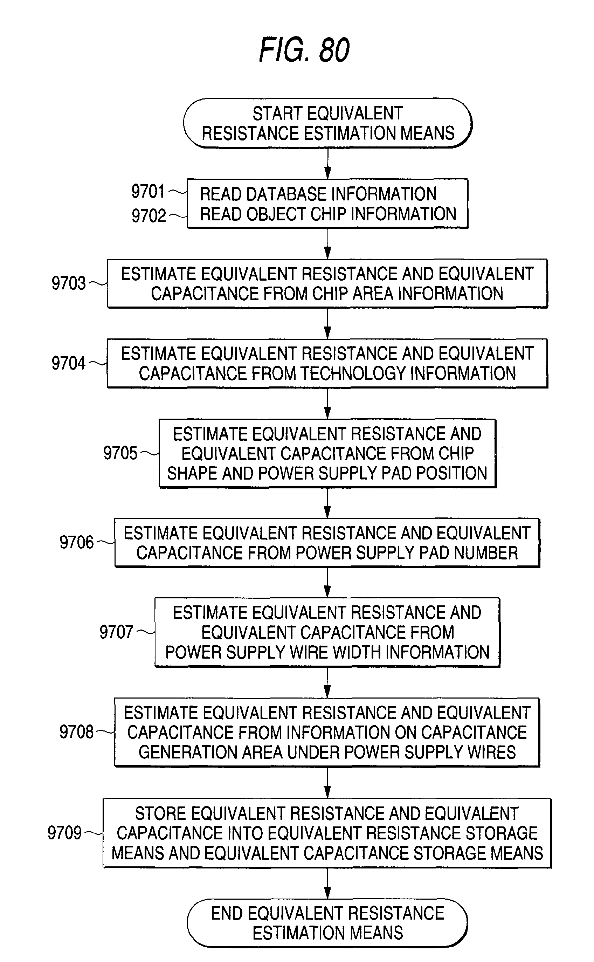

The configuration of the 26th embodiment estimates the equivalent resistance and equivalent capacitance from the area information of the chip, as shown in step 9703 of the flow chart of the current waveform correction means of Fig. 80.

The configuration of the 27th embodiment estimates the equivalent resistance and equivalent capacitance from the technology information, as shown in step 9704 of the flow chart of the current waveform correction means of Fig. 80.

The configuration of the 28th embodiment estimates the equivalent resistance and equivalent capacitance from the chip shape and the power supply pad position, as shown in step 9705 of the flow chart of the current waveform correction means of Fig. 80.

The configuration of the 29th embodiment estimates the equivalent resistance and equivalent capacitance from the number of power supply pads, as shown in step 9706 of the flow chart of the current waveform correction means of Fig. 80.

The configuration of the 30th embodiment estimates the equivalent resistance and equivalent capacitance from the power supply wire width information, as shown in step 9707 of the flow chart of the current waveform correction means of Fig. 80.

The configuration of the 31st embodiment estimates the equivalent resistance and equivalent capacitance from the capacitance generation area under power supply wire information, as shown in step 9708 of the flow chart of the current waveform correction means of Fig. 80.

Next, individual elements making up the EMI analysis method of Fig. 79 will be explained.

The chip shape information storage means 9601 has information about the shape of the object chip. Entered into this chip shape information are

- chip area determined at the specification generation stage and chip shape determined at the specification generation stage.

Except for the "chip area determined at the specification generation stage", not all of these constitutional element need to be entered.

The technology information storage means 9602 has information on the manufacturing process of the object chip.

Entered into this technology information are

- information on the power supply wire layer determined at the specification generation stage,
- dielectric constant between wire layers determined at the specification generation stage,
- resistance value of the power supply wire sheet determined at the specification generation stage, and
- applicable technology determined at the specification generation stage.

Not all of these constitutional elements need to be entered.

The power supply pad information storage means 9603 has information on the power supply pad of the object chip. Entered into this power supply pad information are

- the number of power supply pads determined at the specification generation stage, and
- power supply pad positions.

Not all of these constitutional elements need to be entered. The configuration module information storage means 9604 has information on functional modules making up the object chip.

Entered into the area information of each module are

- kind of each functional module determined at the specification generation stage,
- area information of each functional module estimated at the specification generation stage or determined by the floorplan,
- position information of each functional module determined by the floorplan,
- the number of instances(devices) information of each functional module determined by the floorplan,
- power supply wire width in each module estimated at the specification generation stage or determined by the floorplan, and
- presence or absence of capacitance cells provided around each module, which is estimated at the specification generation stage or determined by the floorplan.

Not all of these constitutional elements need to be entered.

The power supply wire width information storage means 9605 has information on the power supply wire width of the object chip.

Entered into this power supply wire width information are

- presence or absence of, and width of, a ring power supply wire provided around the chip, which is estimated at the specification generation stage or determined by the floorplan,
- width of a trunk power supply wire laid between modules, which is estimated at the specification generation stage or determined by the floorplan,
- width of a strap power supply provided between modules, which is estimated at the specification generation stage or determined by the floorplan, and
- presence or absence of a decoupling capacitance cell under the power supply wire, which is estimated at the specification generation stage or determined by the floorplan.

Not all of these constitutional elements need to be entered.

The database storage means 9607 has database information associated with the above input items that is required for estimating the equivalent resistance and equivalent capacitance.

The equivalent resistance storage means 9610 stores the equivalent resistance of the chip calculated by the equivalent resistance estimation means 9608.

The equivalent capacitance storage means 9611 stores the equivalent capacitance of the chip calculated by the equivalent capacitance estimation means 9609.

The equivalent resistance estimation means 9608 estimates the equivalent resistance of the chip based on the information read in from the above storage means.

An example processing flow will be described later.

The equivalent capacitance estimation means 9609 estimates the equivalent capacitance of the chip based on the information read in from the above storage means.

An example processing flow will be described later.

Next, in embodiments 25-31, the equivalent resistance estimation means 9608 and the equivalent capacitance estimation means 9609 will be explained by referring to the flow chart of Fig. 80.

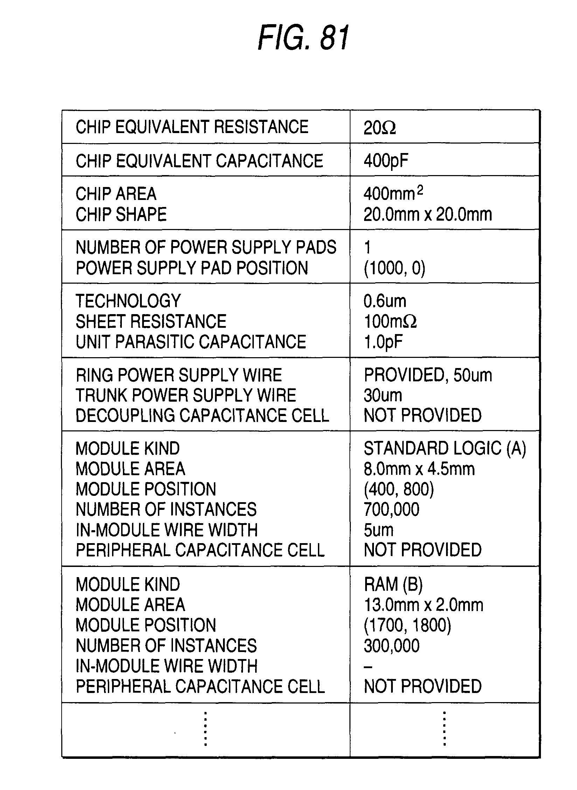

First, step 9701 reads database information (Fig. 81) from the database storage means 9607.

The database (Fig. 81) has information on various parameters of a chip and information on equivalent resistance and equivalent capacitance. The various parameter information is obtained at the specification generation stage - - an initial stage of the chip design -- or in the floorplan process. The equivalent resistance and equivalent capacitance information is obtained by the flow of the embodiment 19. That is, the equivalent resistance and the equivalent capacitance are calculated from the power supply resistance/capacitance network information that can be obtained by the LPE processing after the layout design is completed. Hence, they have high precision.

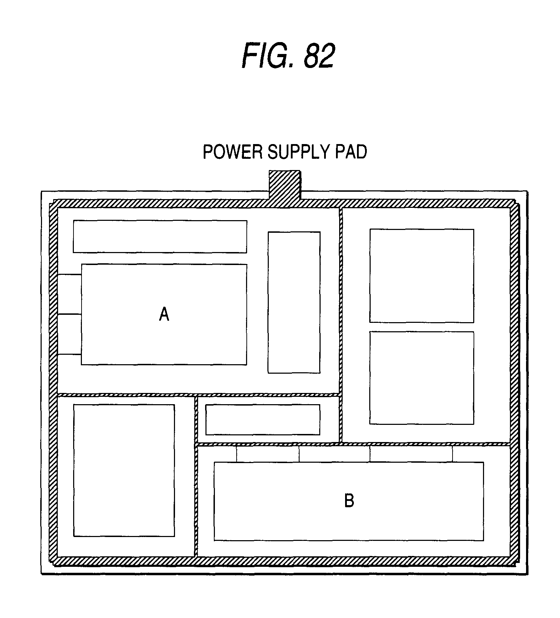

Fig. 82 is an image diagram of this database chip.

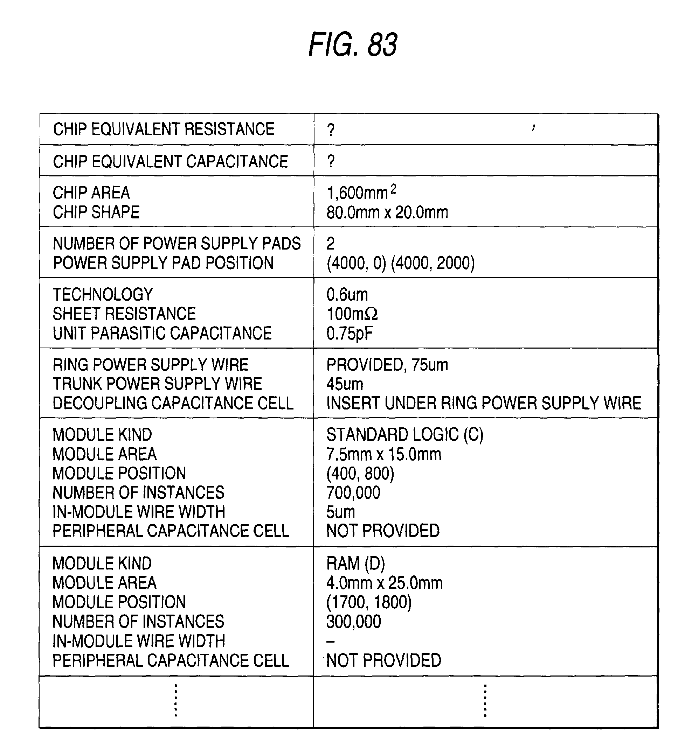

Step 9702 reads various parameter information (Fig. 83) for the object chip from the chip shape information storage means 9601, the technology information storage means 9602, the power supply pad information storage means 9603, the configuration module information storage means 9604 and power supply wire width information storage means 9605.

Of the items of Fig. 83, the capacitance per unit area can easily be determined from the information indicating which metal layer is used for the power supply wire layer and the information on the interlayer dielectric constant, both information contained in the technology information storage means. Other items are as explained in the constitutional elements of each of the above stored information.

The various parameter information of the chip is paired with the various parameter information of the database already read in. In the subsequent steps, comparison is made between the paired parameters to change the equivalent resistance and equivalent capacitance of the database to estimate the equivalent resistance and equivalent capacitance of the object chip.

As to the various parameter information of the object chip, not all of the items need to be entered. For the items not entered, the parameter comparison step is obviated. In this embodiment, assuming Fig. 83 is given, the subsequent steps will be explained.

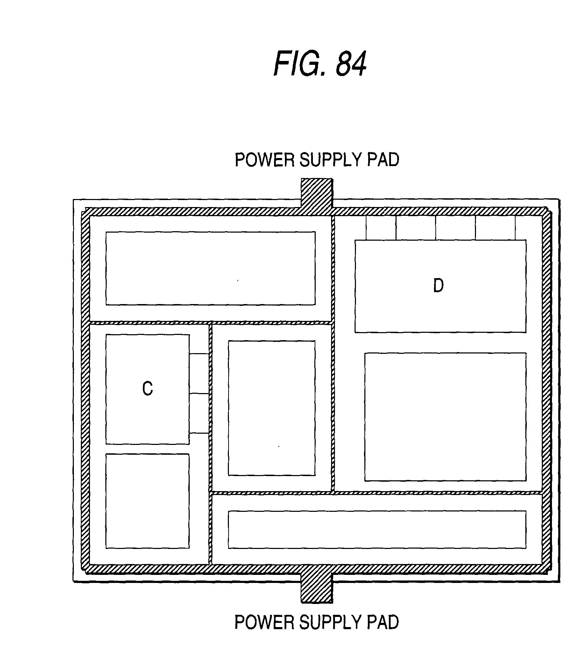

Fig. 84 is an image diagram of the chip to be subjected to the current waveform correction. In the embodiment 26, step 9703 changes the equivalent resistance value and the equivalent capacitance value of the database according to the chip area information.

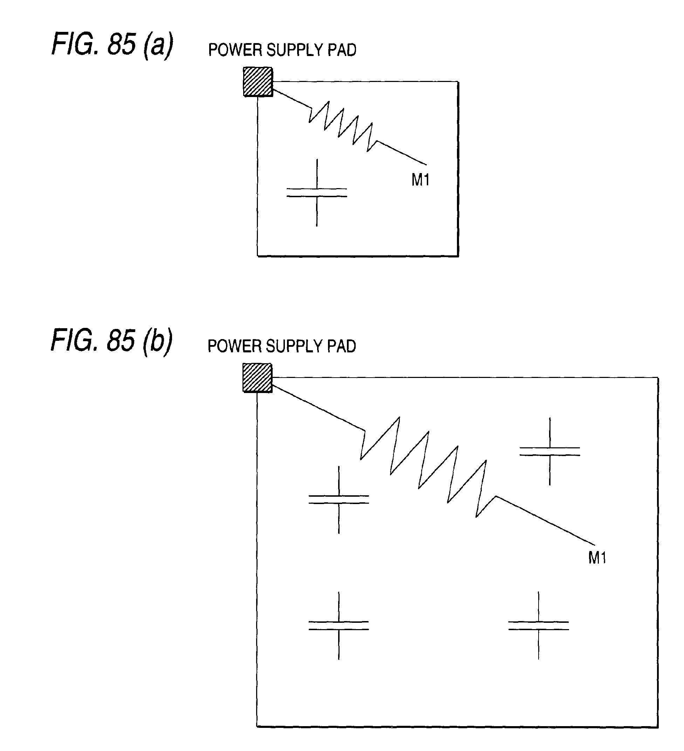

Fig. 85 shows the area dependency of the equivalent resistance and equivalent capacitance. Increasing the area of Fig. 85(a) four times results in Fig. 85(b).

As to the resistance component of the power supply circuit, if the widths of the power supply wires making up the interior of the chip are the same, when the area is increased four times, the distance from the power supply pad is increased two times and therefore the equivalent resistance is also increased two times when comparison is made for an instance M1. The equivalent resistance of the chip is the sum of the equivalent resistances of all instances divided by the number of instances and thus the equivalent resistance is not affected by an increase in the number of instances. Therefore, the equivalent resistance of the chip is proportional to the square root of the area. In this embodiment, the area of the object chip is four times the area of the database chip, so that the equivalent resistance of the object chip is changed to 40 $\Omega$, two times that of the database chip. That is,

$$20 \times 2 = 40 \ \Omega$$

As to the capacitance component of the power supply circuit, the equivalent capacitance is the sum of the decoupling capacitances of the chip and thus can be considered to be proportional to the area. In this embodiment, because the area of the object chip is four times that of the database chip, the equivalent capacitance of the object chip is changed to 800 pF, four times that of the database chip.

$$200 \times 4 = 800 \ pF$$

In the embodiment 27, step 9704 changes the equivalent resistance and the equivalent capacitance according to the technology information.

Comparison is made between the technology information of the database chip and the technology information of the object chip to change the sheet resistance value and the capacitance value per unit area if there is any difference between them.

In this embodiment, the capacitance per unit area of the object chip is 0.75 pF as opposed to 1.00 pF for the database chip. Hence, the equivalent capacitance for the chip under examination is given by

$$800 \ pF \times 0.75 = 600 \ pF$$

Because the equivalent resistance is the same, it is not changed.

In the embodiment 28, step 9705 changes the equivalent resistance according to the relation of chip shape and power supply pad position.

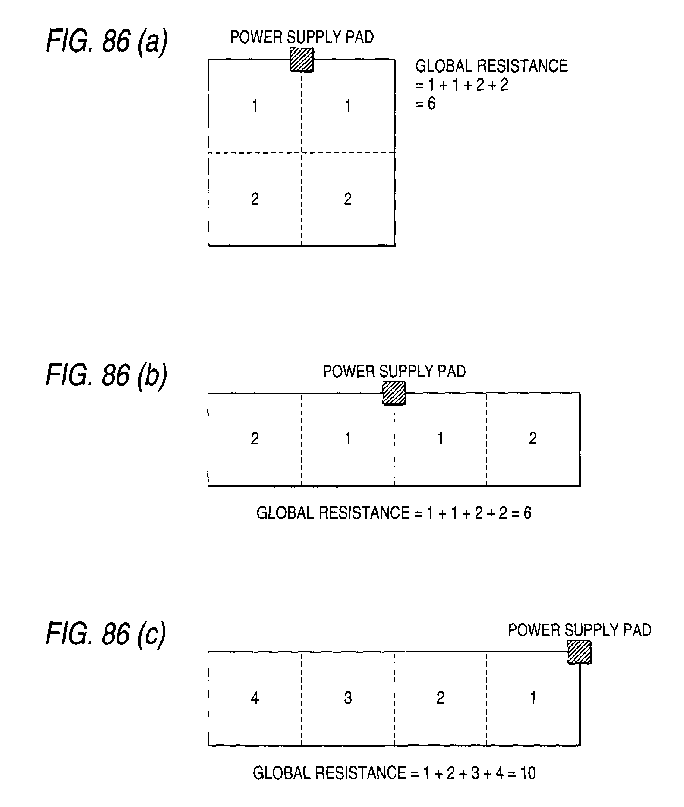

Fig. 86(a) to 86(c) show the dependency of the equivalent resistance on the chip shape and the power supply pad position.

Fig. 86 shows three different relationships between the chip shape and the power supply pad position.

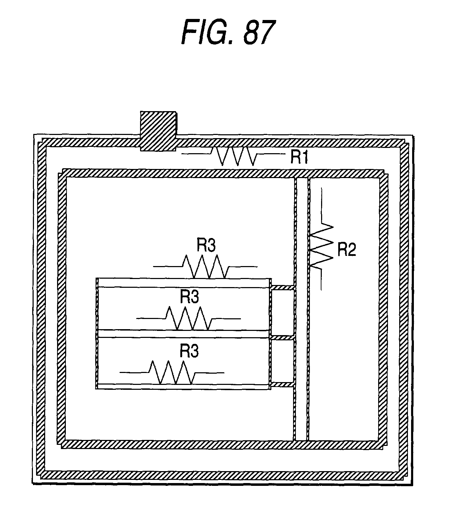

The resistance components of the power supply circuit can generally be classified into a global resistance component and a local resistance component, the global resistance component parasitizing the ring power supply wires and trunk power supply wires, the local resistance component parasitizing the power supply wires inside the module consisting of the basic intracell power supply wires and basic intercell power supply wires (Fig. 87). In Fig. 87, R1 and R2 are global resistors and R3 a local resistor.

This embodiment will be explained by considering a top module that is arranged during the floorplanning process. While in this embodiment the outside of the module is taken as a global resistor and the inside as a local resistor, the border between the global and the local resistor may be otherwise depending on the equivalent resistance to be determined (whether it is a chip or a module).

Fig. 86(a) shows chip areas distinguished according to the distance to the power supply pad. There are two types of areas, area 1 and area 2. It is considered that the area 1 and area 2 have almost the same local resistances but that the global resistance is larger in the area 2. The equivalent resistances of the area 1 and area 2 can each be considered to be the sum of the global resistance and the local resistance. For simplicity, if the global resistance of the area 1 is 1 Ω and the global resistance of the area 2 is 2 Ω, then the global component of the equivalent resistance of the chip is given by

$$1 + 1 + 2 + 2 = 6 \ \Omega$$

In Fig. 86(b), although the chip shape is different, if we look at the distance to the power supply pad, the chip areas can be classified in the same way as above and the global component of the equivalent resistance of the chip is given by

$$1 + 1 + 2 + 2 = 6 \ \Omega$$

In Fig. 86(c), the chip shape is different and there are area 3 and area 4 remote from the power supply pad. The global resistance component is greater as the distance to the power supply pad increases. For simplicity, if we assume the global resistance of area 3 to be 3 Ω and that of area 4 to be 4 Ω, the global component of the equivalent resistance of the chip is given by

$$1+1+3+4=9 \ \Omega$$

Assuming that the correction value used to estimate the global resistance of Fig. 86(c) from the global resistance of Fig. 86(b) is αg, we get

$$\alpha g = 9/6 = 1.5$$

If we also assume that a global coefficient representing a dominant term of the global resistance and the local resistance is k and the correction value for the equivalent resistance is α, then

$$\alpha = (\alpha g - 1)k + 1$$

$$= (1.5 - 1)k + 1$$

The dependency of the global resistance on the chip shape and power supply pad position is stored in a plurality of databases. If Fig. 86(b) represents the shape and power supply pad position of the database chip, Fig. 86 (c) represents the shape and power supply pad position of the object chip and the global coefficient k is 0.5 (the global coefficient is the statistical information obtained from several kinds of database chips) and if the equivalent resistance of the database chip is 20 Ω, then the equivalent resistance of the object chip is given by

$$20 \times \alpha = 20 \times \{(1.5 - 1) \times 0.5 + 1\} = 20 \times 1.25 = 25 \ \Omega$$

In this embodiment because the relation of chip shape and power supply pad position in the object chip is equal to that of the database chip, the equivalent resistance is not changed at this step.

In Fig. 29, step 9706 changes the equivalent resistance according to the number of power supply pads.

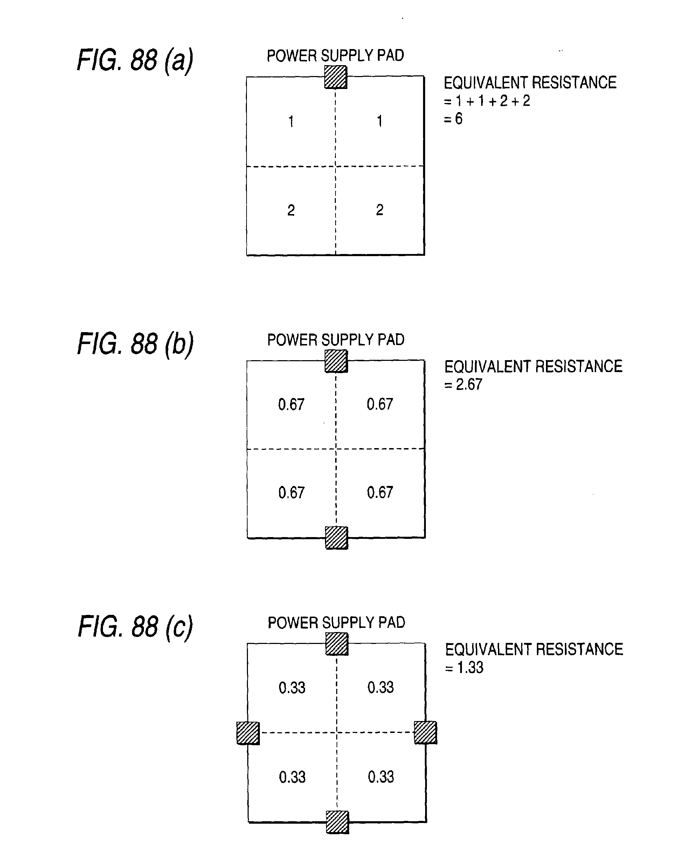

Fig. 88(a) to Fig. 88(c) show the dependency of the equivalent resistance on the number of power supply pads. These examples have the same internal circuit configurations, with different numbers of power supply pads.

When the chip area is divided into four as shown in Fig. 88(a), it may be divided into area 1 and area 2 as described in step 9705. For simplicity, it is assumed that the equivalent resistance of the area 1 is 1 Ω and that of area 2 is 2 Ω. Then, the equivalent resistance of the chip is given by

$$1 + 1 + 2 + 2 = 6 \ \Omega$$

Next, as shown in Fig. 88(b), a power supply pad is added at an opposite side. The additional pad position is normally located so that the pads are arranged evenly on the chip. At this time, when seen from the added power supply pad arranged on the lower side, the area 1 is taken as area 2 and the area 2 as area 1. This means that each area is supplied from two power supply pads. For simplicity, assuming that the power supply wires from the power supply pads to the chip areas are not shared among the pads, the equivalent resistance of each area is 0.67 $\Omega$ as shown in Fig. 88(b) and the equivalent resistance of the chip is given by

$$0.67 + 0.67 + 0.67 + 0.67 = 2.67 \ \Omega$$

When the same logic is taken, the equivalent resistance of the chip in the configuration of Fig. 88(c) is given by

$$0.33 + 0.33 + 0.33 + 0.33 = 1.33 \ \Omega$$

When the power supply pad configuration is changed from Fig. 88(b) to Fig. 88(c), the correction value $\alpha c$ for the equivalent resistance is

$$\alpha c = 1.33/2.67 = 0.5$$

Further, if we let the non-sharing coefficient for power supply wire be k, the correction value for equivalent resistance $\alpha$ is expressed by

$$\alpha = (\alpha c - 1)k + 1$$

$$= (0.5 - 1)k + 1$$

The dependency of the equivalent resistance on the number of power supply pads is stored in a plurality of databases. If Fig. 88(b) represents the database chip shape and its power supply pad number, Fig. 88(c) represents the object chip shape and its power supply pad number and the non-sharing coefficient of power supply wire k is 0.2 and if the equivalent resistance of the database chip is 20 $\Omega$, then the equivalent resistance of the object chip is given by

$$20 \ x \ \alpha = 20 \ x \ \{(0.5 - 1) \ x \ 0.2 + 1\} = 20 \ x \ 0.9 = 18 \ \Omega$$

In this embodiment, the database chip has one power supply pad and the object chip has two power supply pads. If the equivalent resistance value information that is determined in advance for each area from the database chip and the correction value $\alpha$ to be applied to the object chip that is obtained from the non-sharing coefficient (the non-sharing coefficient is statistical information obtained from several kinds of database chips) are as shown in Fig. 88, the equivalent resistance of the object chip is changed to

$$40 \ x \ 0.9 = 36 \ \Omega.$$

In the embodiment 30, step 9707 changes the equivalent resistance value and the equivalent capacitance value based on the power supply wire width information.

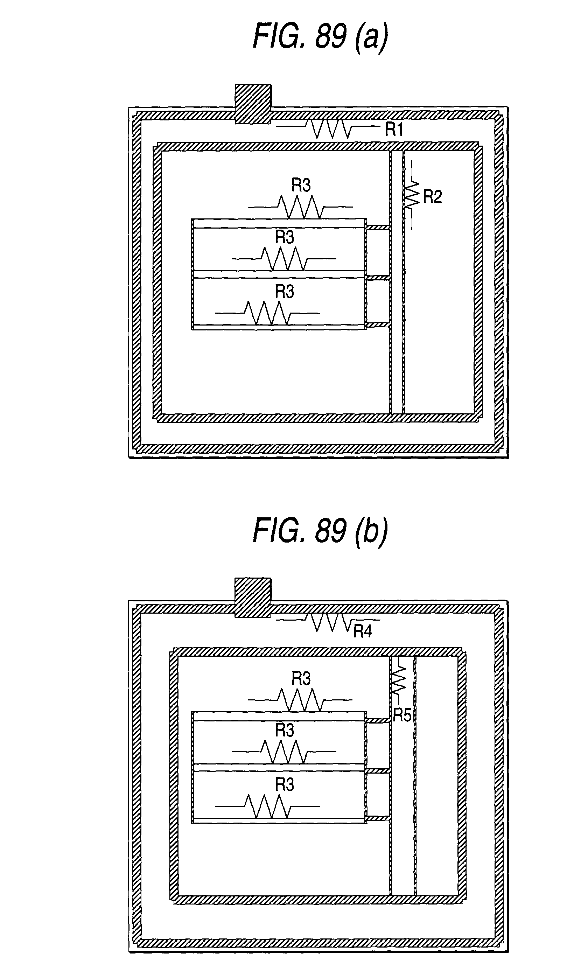

Fig. 89(a) and 89(b) show the dependency of the equivalent resistance on the power supply wire width.
In Fig. 89(a), it is assumed that the power supply wire for supplying electricity to the module is series components of R1 and R2. In Fig. 89(b), a ring wire and an intermodule trunk power supply wire, both global power supply wires, are wider in width than those in Fig. 89(a). If the global power supply wire width in Fig. 89(b) is two times wider, R4 and R5 are one-half of R1 and R2, respectively, as the resistance is inversely proportional to the width of the wire. That is, the resistance component of the global power supply wire supplying the module in Fig. 89(b) is reduced to one-half.

In this way the resistance value of the global power supply wire of the chip as a whole can be considered to be proportional to the global power supply wire width. Therefore, the global resistance correction coefficient $\alpha g$ for the chip is given by

$$\alpha g = (1/2) = 0.5$$

When the global coefficient k representing the dominant term of the global resistance and local resistance is 0.5, the correction coefficient for the chip equivalent resistance $\alpha$ is expressed as

$$\alpha = \{(0.5 - 1) \times 0.5 + 1\} = 0.75$$

The global coefficient is statistical information obtained from several kinds of database chips.

In this embodiment, the width of the global power supply wire of the object chip is 1.5 times that of the database chip. The wire width in the module is the same. If the global coefficient k determined in advance from the database chip is 0.5, the equivalent resistance of the object chip is changed further to $36 \times \{(0.67 - 1) \times 0.5 + 1\} = 36 \times 1.16 = 30\ \Omega$.

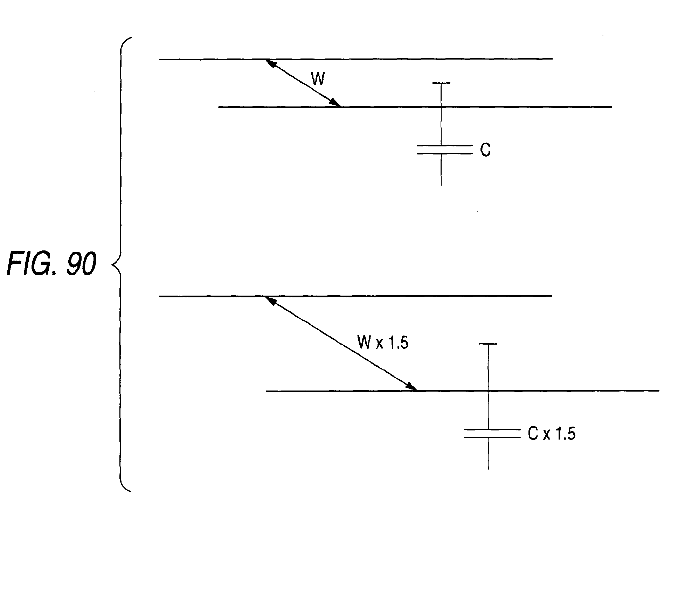

Fig. 90 shows the dependency of the capacitance on the power supply wire width.

As shown in Fig. 90, the capacitance component of the power supply wire is proportional to the width of the power supply wire.

The change from the equivalent capacitance value of the database chip to that of the object chip is not performed because the power supply wire width is already taken into account in the first step 9703 that reflects the chip area information. The change of the equivalent capacitance value according to the power supply wire width is done when the chip area is the same and the width of the power supply wire is changed. This corresponds to a case where the power supply wire width set at the specification generation stage is changed to the one set in the floorplanning process.

The relation between the equivalent capacitance and the power supply width is opposite the relation between the equivalent resistance and the power supply wire width, and the equivalent capacitance is changed in proportion to the power supply wire width. As to the capacitance component, the local wire portion is not considered in changing the capacitance because the decoupling capacitance of the global wire is dominant.

Let us assume that Fig. 89(a) shows the wire width at the stage of specification generation, Fig. 89(b) shows the wire width determined by the floorplan and both areas are equal. If the equivalent capacitance of the chip at the stage of Fig. 89(a) is 500 pF and the wire width at the stage of Fig. 89(b) is increased two times, the equivalent capacitance of the chip is given by

$$500 \times 2 = 1000\ \text{pF}$$

This embodiment follows the process of making a change from the equivalent capacitance of the database chip and thus the equivalent capacitance is not changed here.

In the embodiment 31, step 9708 changes the equivalent capacitance based on the presence or absence of the decoupling capacitance cell under the power supply wire.

According to whether the decoupling capacitance cell is to be formed under the power supply wire, the capacitance per unit area of the power supply wire is changed. Let us assume that the parasitic coupling capacitance per unit area under the power supply wire is 1.00 pF and the capacitance cell due to a gate capacitance formed under the power supply wire is 2.00 pF. If the capacitance cell is formed under all the power supply wires, the coupling capacitance is two times what it is when the capacitance cell is not formed.

In this embodiment, it is assumed that the capacitance cell is formed under all the power supply wires in the object chip while it is not formed in the database chip. If the parasitic coupling capacitance per unit area is 1.00 pF and the capacitance cell per unit area is 2.00 pF, then the equivalent capacitance of the chip is

$$600\ \text{pF} \times 2 = 1200\ \text{pF}$$

Step 9709 stores the equivalent resistance and the equivalent capacitance into the equivalent resistance storage means and the equivalent capacitance storage means.

In the case of the database chip and object chip of this embodiment, performing the above steps results in the equivalent resistance and equivalent capacitance of the object chip being estimated at

equivalent resistance: 30 Ω

equivalent capacitance: 1200 pF

Not all the steps in this embodiment need to be performed and only the steps corresponding to those items for which the information on the object chip is obtained may be executed.

As described above, the equivalent resistance estimation means and the equivalent capacitance estimation means in the embodiments 25-31 are realized.

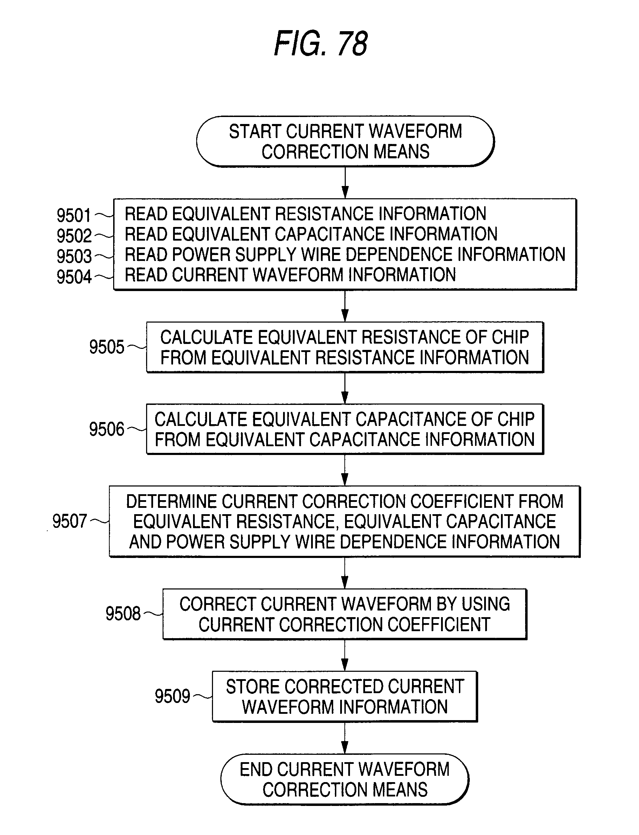

Further, the current waveform correction means 9407 in the embodiments 25-31 will be explained by referring to the flow chart of Fig. 78.

Steps other than step 9501, step 9502, step 9505 and step 9506 are similar to those of Fig. 69 as described in the embodiment 19.

First, step 9501 reads the equivalent resistance information of the chip from the equivalent resistance storage means 9401.

Next, step 9502 reads the equivalent capacitance information of the chip from the equivalent capacitance storage means 9402.

Then, step 9503 reads the power supply wire dependence information of Fig. 68 from the power supply wire dependence information storage means 9403.

Further, step 9504 reads an event-based model of estimated current waveform shown in Fig. 71 from the current waveform storage means 9404.

Then, step 9505 calculates the equivalent resistance of the chip from the resistance information. In this embodiment the resistance information has already become the equivalent resistance of the chip and is therefore practically omitted.

After this, step 9506 calculates the equivalent capacitance of the chip from the capacitance information.

In this embodiment, the capacitance information has already become the equivalent capacitance of the chip and thus this step is practically omitted.

Further, step 9507 applies the equivalent resistance obtained by step 9505 and the equivalent capacitance obtained by step 9506 to the power supply wire dependence information 9403 for each current correction item to determine the current correction coefficient for the object circuit.

Then, step 9508 applies the current correction coefficient obtained by step 9507 to the current waveform information 9404 to correct the current waveform.

Then, step 9509 stores the corrected current waveform as the corrected current waveform information (9406).

As described above, because this embodiment does not use the transient analysis, the EMI analysis considering the power supply wire can be realized faster than the conventional method.

Further, the embodiment 25 offers the advantage that the EMI analysis considering the influence of the power supply wire can be realized in an early design stage without waiting for the completion of layout.

Further, the embodiment 26 offers the advantage that the EMI analysis considering the influence of the power supply wire can be realized with high precision by using the chip area information.

Further, the embodiment 27 offers the advantage that the EMI analysis considering the influence of the power supply wire can be realized with high precision by using the technology information. Another advantage is that there is no need to prepare database for each technology.

Further, the embodiment 28 offers the advantage that the EMI analysis considering the influence of the power supply wire can be realized with still higher precision by using the chip shape and power supply pad position information.

Further, the embodiment 29 offers the advantage that the EMI analysis considering the influence of the power supply wire can be realized with high precision by using the power supply pad number information. The optimization of the number of power supply pads with respect to EMI can be performed at the stage of floorplan.

Further, the embodiment 30 offers the advantage that the EMI analysis considering the influence of the power supply wire can be realized with high precision by using the width information on the power supply wires making up the chip. The optimization of the power supply wire width with respect to EMI can be performed at the stage of floorplan.

Further, the embodiment 31 offers the advantage that the EMI analysis considering the influence of the power supply wire can be realized with high precision by using the information on the capacitance generation area under the power supply wires. The optimization of the capacitance generation with respect to EMI can be performed at the stage of floorplan.

(32nd Embodiment)

Embodiments 19-24 calculate the equivalent resistance and equivalent capacitance of the chip and correct the current in the entire chip.

Embodiment 32 calculates the equivalent resistance and equivalent capacitance for each module, rather than for the entire chip, and calculates the correction coefficient for each module to make more accurate corrections to the estimated current waveform for each module.

The EMI analysis method according to the embodiment 32 of this invention will be described.

The system configuration is similar to that of Fig. 64 described in the embodiment 19 and thus explanations of individual constitutional elements are omitted.

The current waveform correction means of this embodiment has the same process flow as that of Fig. 69 for the current waveform correction means 8107 of Fig. 64.

Individual steps of Fig. 69 in this embodiment will be explained.

Step 8601 reads resistance information shown at 8201 of Fig. 65 from the resistance storage means 8101. This resistance information represents information on a resistor network at 8202 of Fig. 65 showing, for each resistor, a resistor name, node names at both terminals and a resistance value.

First, step 8602 reads capacitance information as shown at 8301 of Fig. 66 from the capacitance storage means 8102. This capacitance information represents information on capacitance added to a resistor network at 8302 of Fig. 66 showing, for each capacitor, a capacitor name, node names and a capacitance value.

Then, step 8603 reads power supply wire dependence information shown in Fig. 68 from the power supply wire dependence information storage means 8103.

Then, step 8604 reads an event-based model of estimated current waveform shown in Fig. 67 from the current waveform storage means 8104.

Further, step 8605 calculates the equivalent resistance of each module from the resistance information. While the embodiment 19 calculates the equivalent resistance for the chip, this embodiment calculates the equivalent resistance for each module. Resistors in a module being examined and resistors in the power supply network present from the power supply to the object module are handled as a series circuit in calculating the equivalent resistance of the object module. Alternatively, as in the embodiment 24, the resistors under consideration are summed up and a square root (positive value) is taken of the sum to estimate the equivalent resistance of the module.

After this, step 8606 calculates the equivalent capacitance of each module from the capacitance information. In the table generation method (3) in the embodiment 19, the equivalent capacitance of the chip was determined by calculating the total capacitance of the chip. In the similar manner, the equivalent capacitance for each module is determined by summing up the capacitance value of the capacitor inside the object module and the capacitance value of the capacitor present between the power supply and the object module.

Step 8607 applies the equivalent resistance of the module obtained by step 8605 and the equivalent capacitance of the module obtained by the step 8606 to the power supply wire dependence information 8103 for each current correction item to determine the current correction coefficient for the object module.

Step 8608 applies the current correction coefficient for each module obtained by step 8607 to the current waveform information 8104 to correct the current waveform for each module, and sums up the corrected current waveforms.

Step 8609 stores the corrected current waveforms as the corrected current waveform information (8106).

As described above, this embodiment realizes the EMI analysis considering the power supply wires at faster speeds than in the conventional method because this embodiment does not use the transient analysis.

Further, instead of calculating the equivalent resistance and equivalent capacitance for the entire chip, the equivalent resistance and equivalent capacitance are calculated for each module and the corrected coefficient for each module is determined. This allows the estimated current waveform to be corrected more precisely for each module.

When the FFT analysis is to be made for each module, the module-based current model corrected for each module is stored and used for the FFT analysis. This allows the highly precise EMI analysis to be realized for each module.

(33rd Embodiment)

Embodiments 25 to 31 estimate the equivalent resistance and equivalent capacitance for the chip and perform the same current corrections for the entire chip.

In the embodiment 33, rather than calculating the equivalent resistance and equivalent capacitance for the entire chip, the equivalent resistance and equivalent capacitance are estimated for each module and the correction coefficient for each module is calculated to perform a more precise correction on the estimated current waveform for each module.

The EMI analysis method according to the embodiment 33 of this invention will be explained. The system configuration is the same as that of Fig. 77 explained in the embodiment 25 and thus explanation of individual constitutional elements of this system is omitted here.

The current waveform correction means of this embodiment uses the equivalent resistance and equivalent capacitance for each module, rather than using the equivalent resistance and equivalent capacitance for the chip, in the process flow of Fig. 78 representing the current waveform correction means 9407 of Fig. 77.

The system configuration concerning the equivalent resistance estimation and the equivalent capacitance estimation is the same as that of Fig. 79 explained in the embodiment 25 and thus its explanation is omitted.

The equivalent resistance estimation means and the equivalent capacitance estimation means are implemented by performing for each module the process flow of Fig. 80, which in the previous embodiment is performed for the chip and represents the equivalent resistance estimation means 9608 and equivalent capacitance estimation means 9609 of Fig. 79. At this time, the power supply port for the module is used as the power supply pad information instead of the power supply pad.

Further, the equivalent resistance and equivalent capacitance for the module obtained up to the step 9708 of Fig. 80 are local resistance and local capacitance in the module, so that the global resistance and global capacitance present between the chip power supply pad and the module need to be added. The global resistance and global capacitance can easily be determined from the distance between the module power supply port to the chip power supply pad and from the information on the power supply wire width. By adding the global resistance and global capacitance to the equivalent resistance and equivalent capacitance obtained by the step 9708, the equivalent resistance and equivalent capacitance for each module can be estimated.

As described above, this embodiment can realize the EMI analysis considering the power supply wires at faster speeds than in the conventional method because this embodiment does not use the transient analysis.

Further, by estimating the equivalent resistance and equivalent capacitance for each module, rather than for the entire chip, and calculating the correction coefficient for each module, it is possible to correct the estimated current waveform more precisely for each module at a prelayout stage.

When the FFT analysis is to be made for each module, the module-based current model corrected for each module is stored and used for the FFT analysis. This allows the highly precise EMI analysis to be realized for each module.

(35th Embodiment)

The embodiment 35 is a technique for considering the inductance component of the power supply wire in the EMI analysis.

This example is almost similar to the system of Fig. 64 explained in the embodiment 19.

In Fig. 64 when calculating the current correction coefficient from the power supply wire dependency information, the inductance component corresponding to the power supply lead portion and the power supply wire bonding portion obtained from the chip package information is taken as a third element following the resistance and capacitance. This can be realized by setting the relation between the power supply inductance component and the current waveform in a table in advance and adding it as the power supply wire dependence information.

The embodiment 35 has the advantage of being able to make highly precise current corrections considering the inductance component of the chip package.

(36th Embodiment)

The embodiment 36 is a technique in the EMI analysis that considers the influences of power supply wires on the current waveform as an ideal power supply and which, rather than performing corrections on the event-based model of the estimated current waveform, corrects the current waveform subject to the EMI analysis and obtained as an ideal power supply.

This example is almost similar to the system of Fig. 64 explained in the embodiment 19.

In Fig. 64, this is implemented by storing the power supply current waveform obtained as an ideal power supply for the chip or module and making corrections on the power supply current waveform, rather than on the event-based model of the estimated current waveform.

The embodiment 36 has the advantage that because the chip or module power supply current waveform determined as an ideal power supply is corrected, the processing can be performed up to the stage of calculating the power supply current of the chip or module. By starting the processing before the completion of the layout or before the floorplan stage, the TAT of the EMI analysis as a whole can be shortened. Further, in the transistor level EMI analysis, too, the technique of making corrections to the power supply waveform and taking the influence of the power supply wires into consideration can be adopted.

In the analysis of changes in the power supply current, which can be said to be a major cause of the EMI, this invention reflects the influences of decoupling by resistance, capacitance and inductance of power supply and ground on the calculation of a gate level power supply current, thereby realizing both high speed and high precision and allowing the EMI of LSIs to be evaluated by simulation in a realistic time. Further, this invention can provide efficient EMI countermeasures by supporting the identification of the EMI causing locations.

And the above described methods are applicable to a method of fabricating many kinds of semiconductor device. According to the above methods, very precise and accurate EMI analysis can be conducted and by considering the results of analysis, very reliable semiconductor device can be fabricated easily.

**Claims**

1. A method of analyzing the amount of electromagnetic interference of LSI by executing a logic simulation, the method including the steps of:

   allocating a discrete FFT analysis frequency width in each frequency range and performing a modelling step; and
   performing high-speed Fourier transform processing on current change information calculated by the modeling step.

2. An electromagnetic interference analysis method according to claim 1, wherein the modeling step includes:

   a discrete analysis frequency width change specifying step for specifying in a particular frequency range a change in a discrete high-speed Fourier transform (FFT) analysis frequency width; and
   a modeling process for allocating different discrete FFT analysis frequency widths to the specified frequency range and to a frequency range other than the specified frequency range and performing modeling.

3. A method of analyzing the amount of electromagnetic interference by executing a logic simulation, according to claim 1, wherein the modeling step includes a step of calculating a current frequency component simultaneously with the calculation at each point in time of a current of a circuit to be analyzed for electromagnetic interference.

4. A method of analyzing the amount of electromagnetic interference by executing a logic simulation, according to claim 1, wherein the modeling step includes a step of calculating a current frequency component for a time interval each time the current calculation is performed for that time interval, the time interval being less than a time range of an object to be analyzed, and then calculating current frequency components for the entire time range of the object based on the calculated current frequency component.

5. A method of analyzing the amount of electromagnetic interference by executing a logic simulation, according to claim 1, wherein the modeling step has:

   a current frequency component storage step; and
   a current frequency component calculation step for storing in the current frequency component storage means only those current frequency component values in excess of a predetermined threshold.

6. A method of analyzing the amount of electromagnetic interference by executing a logic simulation, according to claim 1, wherein the modeling step has:

   a current frequency component storage step; and
   a current frequency component calculation step for storing in the current frequency component storage means only a predetermined number of current frequency component values in the order of magnitude.

7. A method of analyzing the amount of electromagnetic interference by executing a logic simulation, according to claim 1, wherein the modeling step includes:
   a step of calculating a current frequency component for only a predetermined circuit portion in a network to be analyzed.

8. A method of analyzing the amount of electromagnetic interference by executing a logic simulation, according to claim 1, wherein the modeling step includes:
   a step of calculating a current frequency component for only those circuit portions in an object network having one or more circuit portions whose currents are estimated to exceed a predetermined threshold.

9. A method of analyzing the amount of electromagnetic interference by executing a logic simulation, according to claim 1, wherein the modeling step includes:

a step of calculating a current frequency component for only a predetermined number of circuit portions that are selected in the order of estimated current magnitude from an object network having two or more circuit portions.

10. A method of analyzing the amount of electromagnetic interference by executing a logic simulation, according to claim 1, wherein the modeling step includes:

a step of calculating a current frequency component for only those circuit portions in an object network having one or more circuit portions whose logic change numbers exceed a predetermined threshold.

11. A method of analyzing the amount of electromagnetic interference by executing a logic simulation, according to claim 1, wherein the modeling step includes:

a step of calculating a circuit frequency component for only a predetermined number of circuit portions that are selected in the order of logic change number from an object network having one or more circuit portions.

12. A method of analyzing the amount of electromagnetic interference by executing a logic simulation, according to claim 1, wherein the modeling step includes:

a step of estimating from network information the number of logic changes in an object network; and
a step of calculating a current frequency component for those circuit portions that are selected based on the number of logic changes from the object circuit having one or more circuit portions.

13. An apparatus for analyzing the amount of electromagnetic interference by executing a logic simulation, according to claim 1, the apparatus including:

a means as a user interface for identifying, from a result of performing FFT on a current waveform for each instance, an instance name which mainly causes noise in an associated frequency component with large noise.

14. An apparatus for analyzing the amount of electromagnetic interference by executing a logic simulation, according to claim 1, the apparatus including:

a means as a user interface for identifying, from a result of performing FFT on current waveforms for each instance group consisting of one or more instances, an instance group which mainly causes noise in an associated frequency component with large noise.

15. An apparatus for analyzing the amount of electromagnetic interference by executing a logic simulation, according to claim 1, the apparatus including:

a means as a user interface for grouping instances according to flag information written in library or for grouping them into instance groups of registers, combined circuits and memories.

16. An apparatus for analyzing the amount of electromagnetic interference by executing a logic simulation, according to claim 1, the apparatus having:

a means as a user interface for grouping instances according to whether the instances belong to a clock tree connected to each clock input terminal.

17. An apparatus for analyzing the amount of electromagnetic interference by executing a logic simulation, according to claim 1, the apparatus including:

a means as a user interface for grouping instances according to a result of identifying the timing at which status changes occur simultaneously or in a predetermined time duration.

18. An electromagnetic interference analysis apparatus according to claim 15, wherein the grouping means includes:

a means for identifying, from the instance grouping information, an instance name which mainly causes noise in an associated frequency component with large noise and then reporting information on noise level.

19. An apparatus for analyzing the amount of electromagnetic interference by executing a logic simulation, according to claim 1, the apparatus including:

a means as a user interface for performing FFT only on a predetermined frequency.

20. A method of analyzing the amount of electromagnetic interference of LSI by executing a logic simulation, the method including a current waveform correction step, the current waveform correction step comprising:

a step of calculating an equivalent resistance and an equivalent capacitance of an entire chip from a resistance and a capacitance of a power supply circuit of the chip that were determined by performing LPE based on layout data, and calculating a correction coefficient; and

a step of correcting, by using the correction coefficient, an event-based model of an estimated current waveform obtained in advance as an ideal power supply.

21. An electromagnetic interference analysis method according to claim 20, wherein the correction coefficient calculation step includes a step of calculating the equivalent resistance and equivalent capacitance of the entire chip from information on resistance and capacitance of a power supply circuit of the chip and calculating the correction coefficient by performing processing according to a table prepared in advance.

22. An electromagnetic interference analysis method according to claim 20, wherein the correction coefficient calculation step includes a step of calculating the equivalent resistance and equivalent capacitance of the entire chip from information on resistance and capacitance of a power supply circuit of the chip and calculating the correction coefficient by performing processing according to a mathematical expression prepared in advance.

23. An electromagnetic interference analysis method according to claim 20, wherein the correction processing step includes a step of correcting a base of the event-based model of the estimated current waveform obtained as an ideal power supply.

24. An electromagnetic interference analysis method according to claim 20, wherein the correction processing step includes a step of correcting an area of the event-based model of the estimated current waveform obtained as an ideal power supply.

25. An electromagnetic interference analysis method according to claim 20, wherein the correction coefficient calculation step includes a step of estimating the equivalent resistance of the chip from the resistance information of the power supply circuit by using shape information of the power supply circuit and then performing the correction coefficient calculation step at high speed.

26. A method of analyzing the amount of electromagnetic interference by executing a logic simulation, the method having:

a step of estimating an equivalent resistance and an equivalent capacitance of a power supply circuit of a chip at a floorplan stage;

a step of calculating a correction coefficient from the information on the equivalent resistance and equivalent capacitance; and

a step of correcting an event-based model of an estimated current waveform obtained in advance as an ideal power supply.

27. An electromagnetic interference analysis method according to claim 26, wherein the step of estimating the equivalent resistance and equivalent capacitance includes a step of estimating the resistance and capacitance of the power supply circuit by considering an area of the chip.

28. An electromagnetic interference analysis method according to claim 27, wherein the step of estimating the equivalent resistance and equivalent capacitance further includes a step of estimating the resistance and capacitance of the power supply circuit by considering technology information.

29. An electromagnetic interference analysis method according to claim 27, wherein the step of estimating the equivalent resistance and equivalent capacitance further includes a step of estimating the resistance and capacitance of the power supply circuit by considering a chip shape and a power supply pad position.

30. An electromagnetic interference analysis method according to claim 27, wherein the step of estimating the equivalent resistance and equivalent capacitance further includes a step of estimating the resistance and capacitance of the power supply circuit by considering the number of power supply pads.

31. An electromagnetic interference analysis method according to claim 27, wherein the step of estimating the equivalent resistance and equivalent capacitance further includes a step of estimating the resistance and capacitance of the power supply circuit by considering information on a width of the power supply wire making up the chip.

**32.** An electromagnetic interference analysis method according to claim 27, wherein the step of estimating the equivalent resistance and equivalent capacitance further includes a step of estimating the resistance and capacitance of the power supply circuit by considering a capacitance generation area under the power supply wire.

**33.** An electromagnetic interference analysis method according to claim 20 , wherein, to consider the power supply wire for each module in a post-layout electromagnetic interference analysis, the current waveform correction step includes a step of calculating an equivalent resistance and an equivalent capacitance for each module, rather than for the entire chip, and calculating a correction coefficient for each module to make corrections to the estimated current waveform more precisely for each module.

**34.** An electromagnetic interference analysis method according to claim 26, wherein, to consider the power supply wire for each module in a pre-layout electromagnetic interference analysis, the current waveform correction step includes a step of estimating an equivalent resistance and an equivalent capacitance for each module, rather than for the entire chip, by considering information on a position of each module making up the chip and information on a kind of each module and calculating a correction coefficient for each module to make corrections to the estimated current waveform more precisely for each module.

**35.** An electromagnetic interference analysis method according to claim 26 , wherein the current waveform correction step includes:

a step of calculating an equivalent resistance and an equivalent capacitance of the entire chip from information on resistance and capacitance of the power supply circuit of the chip and calculating a correction coefficient by using a table or mathematical expression prepared in advance; or
a step of correcting a base or area of an event-based model of the estimated current waveform obtained as an ideal power supply.

**36.** An electromagnetic interference analysis method according to claim 20 , wherein, to consider an inductance component of a power supply wire in the electromagnetic interference analysis, the current waveform correction step includes:

a step of calculating from package information of the chip an inductance component corresponding to the power supply lead portion and the power supply wire bonding portion and using it as a third element following the resistance and capacitance.

**37.** An electromagnetic interference analysis method according to claim 20, wherein, to consider an influence of a power supply wire on the current waveform obtained as an ideal power supply in the electromagnetic interference analysis, the current waveform correction step corrects the current waveform obtained as an ideal power supply that is to be analyzed for electromagnetic interference, instead of correcting an event-based model of the estimated current waveform.

## FIG. 1

101 POWER SUPPLY-CONSIDERED CALCULATION UNIT

106 FFT CALCULATION UNIT

102 EXTERNAL STORAGE DEVICE

103 INPUT DEVICE

107 INPUT/OUTPUT CALCULATION UNIT

105 OUTPUT DEVICE

# FIG. 2

201

LAYOUT DATA

216

WIRE/LEAD FRAME IMPEDANCE

210

POWER SUPPLY WIRE LPE PROCESSING

202

LPE RULE

LPE PROCESSING — 203

211 — POWER SUPPLY WIRE NET LIST

NET LIST ~ 204

205

TEST PATTERN

206

SWITCH LEVEL CIRCUIT SIMULATION

207 — CURRENT WAVEFORM FOR EACH TRANSISTOR

208 ~ CURRENT SOURCE MODELING PROCESSING

209 ~ CURRENT SOURCE DEVICE MODEL

212

TRANSIENT ANALYSIS SIMULATION

213 ~ CURRENT WAVEFORM RESULT

217

IR-DROP RESULT

214 ~ FFT PROCESSING

215 ~ FREQUENCY CHARACTERISTIC

# FIG. 3

301
**NET LIST**

302
**TEST VECTOR**

303
**WAVEFORM INFORMATION AT TIME OF TOGGLING**

304 — **LOGIC SIMULATOR**

305
**EVENT INFORMATION**

307
**CURRENT WAVEFORM CALCULATION PROCESSING UNIT**

306 — **SIMULATION RESULT**

308 — **CURRENT WAVEFORM CALCULATION RESULT**

309 — **FFT PROCESSING UNIT**

310 — **FREQUENCY CHARACTERISTIC**

## FIG. 4

POWER SUPPLY CURRENT
INFORMATION STORAGE MEANS — 402

↓

FFT ANALYSIS MEANS — 403

↓

FFT RESULT STORAGE MEANS — 404

## FIG. 5

| FREQUENCY [ MHz ] | CURRENT FREQUENCY COMPONENT [ mA ] |
|---|---|
| 0 | 10 |
| 5 | 1 |
| 10 | 1 |
| 15 | 1 |
| 20 | 1 |
| 25 | 1 |
| 30 | 1 |
| 35 | 1 |
| 40 | 1 |
| 45 | 30 |
| 50 | 70 |
| 55 | 30 |
| 55 | 30 |
| 60 | 1 |
| 65 | 1 |
| 70 | 1 |
| 75 | 1 |
| 80 | 1 |
| 85 | 1 |
| 90 | 1 |
| 95 | 20 |
| 100 | 50 |
| 105 | 20 |
| 110 | 1 |
| 115 | 1 |
| 120 | 1 |
| 125 | 1 |

501        502

## FIG. 6

601 — DETAILED FREQUENCY STORAGE MEANS

602 — POWER SUPPLY CURRENT INFORMATION STORAGE MEANS

603 — FFT ANALYSIS MEANS

604 — FFT RESULT STORAGE MEANS

## FIG. 7

| START FREQUENCY [ MHz ] | END FREQUENCY [ MHz ] |
|---|---|
| 45 | 55 |
| 95 | 105 |

701

702

## FIG. 8

| TIME [ ns ] | POWER SUPPLY CURRENT VALUE [ mA ] |
|---|---|
| 0 | 0 |
| 95 | 20 |
| 100 | 50 |
| 105 | 20 |
| 195 | 30 |
| 200 | 70 |
| 205 | 30 |
| 295 | 20 |
| 300 | 50 |
| 305 | 20 |
| 395 | 30 |
| 400 | 70 |
| 405 | 30 |
| 495 | 20 |
| 500 | 30 |
| 505 | 20 |

801　　　　　802

# FIG. 9

| FREQUENCY [ MHz ] | CURRENT FREQUENCY COMPONENT [ mA ] |
|---|---|
| 0 | 10 |
| 25 | 1 |
| 45 | 30 |
| 50 | 70 |
| 55 | 30 |
| 75 | 1 |
| 95 | 20 |
| 100 | 50 |
| 105 | 20 |
| 125 | 1 |

901                                        902

# FIG. 10

START FFT ANALYSIS MEANS

↓

READ DETAILED FREQUENCY INFORMATION ~ 1001

↓

READ POWER SUPPLY CURRENT INFORMATION ~ 1002

↓

IN THE DETAILED FREQUENCY INFORMATION RANGE,
USE PREDETERMINED, NORMAL DISCRETE ANALYSIS
FREQUENCY WIDTH OF 5MHz IN PERFORMING ~ 1003
FREQUENCY ANALYSIS; IN OTHER RANGE, USE COARSE
DISCRETE ANALYSIS FREQUENCY WIDTH OF 25MHz

↓

STORE FFT RESULT ~ 1004

↓

END FFT ANALYSIS MEANS

# FIG. 11

1101 ~ NET LIST STORAGE MEANS

TEST VECTOR STORAGE MEANS ~ 1102

1103 ~ CURRENT FFT ANALYSIS MEANS

1104 ~ FFT RESULT STORAGE MEANS

# FIG. 12

1201

BUF1

BUF2

A

Y1

4mA AT TURN-ON
6mA AT TURN-OFF

4mA AT TURN-ON
6mA AT TURN-OFF

BUF3

BUF4

Y2

4mA AT TURN-ON
6mA AT TURN-OFF

4mA AT TURN-ON
6mA AT TURN-OFF

BUF5

Y3

4mA AT TURN-ON
6mA AT TURN-OFF

# FIG. 13

| TIME [ ns ] | EXTERNAL INPUT TERMINAL NAME | VOLTAGE VALUE [ V ] |
|---|---|---|
| 0 | A | 0 |
| 90 | A | 2.5 |
| 190 | A | 0 |
| 290 | A | 2.5 |
| 390 | A | 0 |
| 490 | A | 2.5 |

1301

1302

1303

## FIG. 14

| FREQUENCY [ MHz ] | CURRENT FREQUENCY COMPONENT [ mA ] |
|---|---|
| 0 | 10 |
| 5 | 1 |
| 10 | 1 |
| 15 | 1 |
| 20 | 1 |
| 25 | 1 |
| 30 | 1 |
| 35 | 1 |
| 40 | 1 |
| 45 | 30 |
| 50 | 70 |
| 55 | 30 |
| 55 | 30 |
| 60 | 1 |
| 65 | 1 |
| 70 | 1 |
| 75 | 1 |
| 80 | 1 |
| 85 | 1 |
| 90 | 1 |
| 95 | 20 |
| 100 | 50 |
| 105 | 20 |
| 110 | 1 |
| 115 | 1 |
| 120 | 1 |
| 125 | 1 |

1401

1402

## FIG. 15

START CURRENT FFT ANALYSIS MEANS

READ NET LIST INFORMATION — 1501

READ TEST VECTOR INFORMATION — 1502

SELECT FIRST POINT IN TIME
(RECORDED AS PRESENT TIME) — 1503
FOR TEST VECTOR INFORMATION

CALCULATE CHANGE i (t) OVER TIME OF POWER SUPPLY
CURRENT THAT FLOWS IN NETWORK AS A RESULT
OF APPLYING THE VOLTAGE VALUE OF THE PRESENT — 1504
TIME TO EXTERNAL TERMINAL OF NET LIST

CALCULATE EACH CURRENT FREQUNCY
COMPONENT OF POWER SUPPLY CURRENT VALUE i (t):
$i (f) = i (t) \times \sin (\omega t)$ — 1505
AND ADD IT TO THE CURRENT FREQUENCY
COMPONENT OF FFT RESULT AND STORE

1506

IS THE
PRESENT TIME THE FINAL TIME OF
THE TEST VECTOR?

NO

YES

END CURRENT FFT ANALYSIS MEANS

## FIG. 16

NET LIST
STORAGE MEANS — 1601

TEST VECTOR
STORAGE MEANS — 1602

CURRENT FFT
ANALYSIS MEANS — 1603

POWER SUPPLY
CURRENT
STORAGE MEANS — 1605

FFT RESULT
STORAGE MEANS — 1604

# FIG. 17

1703

| TIME [ ns ] | CURRENT [ mA ] |
|---|---|
| 0 | 0 |
| 95 | 20 |
| 100 | 50 |
| 105 | 20 |
| 195 | 30 |
| 200 | 70 |

1704

| TIME [ ns ] | CURRENT [ mA ] |
|---|---|
| 200 | 70 |
| 205 | 30 |
| 295 | 20 |
| 300 | 50 |
| 305 | 20 |
| 395 | 30 |
| 400 | 70 |

1705

| TIME [ ns ] | CURRENT [ mA ] |
|---|---|
| 400 | 70 |
| 405 | 30 |
| 495 | 20 |
| 500 | 30 |
| 505 | 20 |

1701

1702

# FIG. 18

( START CURRENT FFT ANALYSIS MEANS )

| READ NET LIST INFORMATION | ~ 1801

| READ TEST VECTOR INFORMATION | ~ 1802

| SELECT FIRST POINT IN TIME OF TEST VECTOR INFORMATION (RECORDED AS PRESENT TIME) | ~ 1803

1804

DOES THE LENGTH OF TIME FROM THE PREVIOUS FREQUENCY ANALYSIS TO THE PRESENT TIME EXCEED A PREDETERMINED TIME INTERVAL OF 200ns?  — YES

NO

1805 — CALCULATE CHANGE i (t) OVER TIME OF POWER SUPPLY CURRENT THAT FLOWS IN NETWORK AS A RESULT OF APPLYING THE VOLTAGE VALUE OF THE PRESENT TIME TO EXTERNAL TERMINAL OF NET LIST

1806

NO ← IS THE PRESENT TIME THE FINAL TIME OF THE TEST VECTOR?

YES

1807 — PERFORM FFT FOR CURRENT AT A PREDETERMINED TIME INTERVAL WHEN FFT RESULT IS IN FFT RESULT INFORMATION, ADD WHEN FFT RESULT IS NOT IN FFT RESULT INFORMATION, STORE IT AS ADDED INFORMATION

1808

NO ← IS THE PRESENT TIME THE FINAL TIME OF THE TEST VECTOR?

YES

( END CURRENT FFT ANALYSIS MEANS )

## FIG. 19

1905 — POWER SUPPLY CURRENT INFORMATION STORAGE MEANS

1903 — FFT ANALYSIS MEANS

1904 — FFT RESULT STORAGE MEANS

## FIG. 20

| FREQUENCY [ MHz ] | CURRENT FREQUENCY COMPONENT [ mA ] |
|---|---|
| 0 | 10 |
| 45 | 30 |
| 50 | 70 |
| 55 | 30 |
| 95 | 20 |
| 100 | 50 |
| 105 | 20 |

2001      2002

# FIG. 21

( START FFT ANALYSIS MEANS )

↓

| READ POWER SUPPLY CURRENT INFORMATION |~ 2101

↓

| PERFORM FFT ON POWER SUPPLY CURRENT INFORMATION AND STORE ONLY THOSE VALUES THAT EXCEED A PREDETERMINED THRESHOLD VALUE OF 10mA IN FFT RESULT INFORMATION |~ 2102

↓

( END FFT ANALYSIS MEANS )

# FIG. 22

| POWER SUPPLY CURRENT INFORMATION STORAGE MEANS |~ 2205

↓

| FFT ANALYSIS MEANS |~ 2203

↓

| FFT RESULT STORAGE MEANS |~ 2204

# FIG. 23

| FREQUENCY [ MHz ] | CURRENT FREQUENCY COMPONENT [ mA ] |
|:---:|:---:|
| 50 | 70 |
| 100 | 50 |
| 45 | 30 |
| 55 | 30 |
| 95 | 20 |
| 105 | 20 |

2301 2302

# FIG. 24

START FFT ANALYSIS MEANS

READ POWER SUPPLY CURRENT INFORMATION — 2401

PERFORM FFT ON POWER SUPPLY CURRENT INFORMATION AND STORE ONLY A PREDETERMINED NUMBER (6) OF CIRCUIT DEVICECS SELECTED IN THE ORDER OF CURRENT FREQUENCY COMPONENT VALUES IN FFT RESULT INFORMATION — 2402

END FFT ANALYSIS MEANS

# FIG. 25

2501

BUF1

BUF2

A

4mA AT TURN-ON
6mA AT TURN-OFF

4mA AT TURN-ON
6mA AT TURN-OFF

Y1

BUF3

BUF4

4mA AT TURN-ON
6mA AT TURN-OFF

4mA AT TURN-ON
6mA AT TURN-OFF

Y2

BUF5

BUF6

4mA AT TURN-ON
6mA AT TURN-OFF

1mA AT TURN-ON
2mA AT TURN-OFF

Y3

# FIG. 26

| CIRCUIT DEVICE TO BE EMI-ANALYZED |
| --- |
| BUF1 |
| BUF2 |
| BUF3 |
| BUF4 |
| BUF5 |

## FIG. 27

EMI ANALYSIS OBJECT
INFORMATION LIMITING MEANS ~27107

EMI ANALYSIS OBJECT
INFORMATION STORAGE MEANS 2705

NET LIST
STORAGE MEANS 2701

TEST VECTOR
STORAGE MEANS 2702

CURRENT FFT
ANALYSIS MEANS 2703

FFT RESULT
STORAGE MEANS ~2704

## FIG. 28

START CURRENT FFT ANALYSIS MEANS

READ NET LIST INFORMATION ~2801

READ TEST VECTOR INFORMATION ~2802

READ EMI ANALYSIS OBJECT INFORMATION ~2803

FOR ALL POINTS IN TIME RECORDED IN TEST VECTOR,
CALCULATE CHANGE i (t) OVER TIME OF POWER SUPPLY
CURRENT THAT FLOWS IN NETWORK OF CURRENT ESTIMATION
OBJECT CIRCUIT DEVICES AS A RESULT OF APPLYING VOLTAGE
VALUE TO EXTERNAL TERMINAL OF NET LIST.  PERFORM FFT
ON THE CALCULATED CHANGE AND STORE THE RESULT. ~2804

END CURRENT FFT ANALYSIS MEANS

## FIG. 29

2901 — NET LIST STORAGE MEANS

TEST VECTOR STORAGE MEANS — 2902

2903 — CURRENT FFT ANALYSIS MEANS

2904 — FFT RESULT STORAGE MEANS

## FIG. 30

START CURRENT FFT ANALYSIS MEANS

READ NET LIST INFORMATION — 3001

READ TEST VECTOR INFORMATION — 3002

FROM INFORMATION ON CURRENTS WHEN CIRCUIT DEVICES ARE DRIVEN, SELECT CIRCUIT DEVICES WHOSE CURRENT VALUE EXCEEDS THRESHOLD OF 3mA AND REMOVE THEM FROM THE CURRENT ESTIMATION OBJECT — 3003

FOR ALL POINTS IN TIME RECORDED IN TEST VECTOR, CALCULATE CHANGE i (t) OVER TIME OF POWER SUPPLY CURRENT THAT FLOWS IN NETWORK OF CURRENT ESTIMATION OBJECT CIRCUIT DEVICES AS A RESULT OF APPLYING VOLTAGE VALUE TO EXTERNAL TERMINAL OF NET LIST. PERFORM FFT ON THE CALCULATED CHANGE AND STORE THE RESULT. — 3004

END CURRENT FFT ANALYSIS MEANS

## FIG. 31

3101 — NET LIST STORAGE MEANS

TEST VECTOR STORAGE MEANS — 3102

3103 — CURRENT FFT ANALYSIS MEANS

3104 — FFT RESULT STORAGE MEANS

## FIG. 32

START CURRENT FFT ANALYSIS MEANS

READ NET LIST INFORMATION — 3201

READ TEST VECTOR INFORMATION — 3202

FROM INFORMATION ON CURRENTS WHEN CIRCUIT DEVICES ARE DRIVEN, SELECT 5 OR LESS CIRCUIT DEVICES IN THE ORDER OF CURRENT VALUE AS THE CURRENT ESTIMATION OBJECT — 3203

FOR ALL POINTS IN TIME RECORDED IN TEST VECTOR, CALCULATE CHANGE i (t) OVER TIME OF POWER SUPPLY CURRENT THAT FLOWS IN NETWORK OF CURRENT ESTIMATION OBJECT CIRCUIT DEVICES AS A RESULT OF APPLYING VOLTAGE VALUE TO EXTERNAL TERMINAL OF NET LIST. PERFORM FFT ON THE CALCULATED CHANGE AND STORE THE RESULT. — 3204

END CURRENT FFT ANALYSIS MEANS

## FIG. 33

3301

NET LIST
STORAGE MEANS

3302

TEST VECTOR
STORAGE MEANS

3303

CURRENT FFT
ANALYSIS MEANS

3306

LOGIC CHANGE
STORAGE MEANS

FFT RESULT
STORAGE MEANS ~ 3304

## FIG. 34

3401

A

BUF1

4mA AT TURN-ON
6mA AT TURN-OFF

BUF2

4mA AT TURN-ON
6mA AT TURN-OFF

Y1

BUF3

4mA AT TURN-ON
6mA AT TURN-OFF

BUF4

4mA AT TURN-ON
6mA AT TURN-OFF

Y2

BUF5

4mA AT TURN-ON
6mA AT TURN-OFF

Y3

B

BUF6

4mA AT TURN-ON
6mA AT TURN-OFF

Y4

## FIG. 35

| TIME [ ns ] | EXTERNAL TERMINAL NAME | LOGIC VALUE |
|:---:|:---:|:---:|
| 0 | A | 0 |
| 90 | A | 1 |
| 190 | A | 0 |
| 290 | A | 1 |
| 390 | A | 0 |
| 490 | A | 1 |
| 0 | B | 0 |
| 190 | B | 1 |
| 390 | B | 0 |

3501        3502        3503

## FIG. 36

| TIME [ ns ] | ELEMENT NAME | LOGIC VALUE |
|---|---|---|
| 0 | BUF1, BUF2, BUF3, BUF4, BUF 5 | 0 |
| 90 | BUF1, BUF2, BUF3, BUF4, BUF 5 | 1 |
| 190 | BUF1, BUF2, BUF3, BUF4, BUF 5 | 0 |
| 290 | BUF1, BUF2, BUF3, BUF4, BUF 5 | 1 |
| 390 | BUF1, BUF2, BUF3, BUF4, BUF 5 | 0 |
| 490 | BUF1, BUF2, BUF3, BUF4, BUF 5 | 1 |
| 0 | BUF6 | 0 |
| 190 | BUF6 | 1 |
| 390 | BUF6 | 0 |

3601          3602          3603

# FIG. 37

START CURRENT FFT ANALYSIS MEANS

READ NET LIST INFORMATION — 3701

READ TEST VECTOR INFORMATION — 3702

FOR ALL POINTS IN TIME RECORDED IN TEST VECTOR,
CALCULATE LOGIC CHANGES THAT OCCUR AT THE OUTPUT OF
EACH CURRENT ESTIMATION OBJECT CIRCUIT DEVICE IN NETWORK — 3703
AS A RESULT OF APPLYING LOGIC VALUES TO EXTERNAL
TERMINAL OF NET LIST. STORE THE CALCULATED CHANGES.

FROM THE NUMBER OF LOGIC CHANGES THAT OCCURRED AT THE
OUTPUT OF EACH CIRCUIT DEVICE, SELECT THOSE CIRCUIT DEVICES
WHOSE LOGIC CHANGE NUMBERS EXCEED THRESHOLD OF THREE — 3704
TIMES AND SET THEM AS CURRENT ESTIMATION OBJECTS

FROM LOGIC CHANGE INFORMATION ON CURRENT
ESTIMATION OBJECT CIRCUIT DEVICES, ESTIMATE
POWER SUPPLY CURRENT INFORMATION, — 3705
PERFORM FFT ON THE ESTIMATED POWER
SUPPLY CURRENTS AND STORE THE RESULT

END CURRENT FFT ANALYSIS MEANS

## FIG. 38

# FIG. 39

START CURRENT FFT ANALYSIS MEANS

READ NET LIST INFORMATION ~ 3901

READ TEST VECTOR INFORMATION ~ 3902

FOR ALL POINTS IN TIME RECORDED IN TEST VECTOR, CALCULATE LOGIC CHANGES THAT OCCUR AT THE OUTPUT OF EACH CURRENT ESTIMATION OBJECT CIRCUIT DEVICE IN NETWORK AS A RESULT OF APPLYING LOGIC VALUES TO EXTERNAL TERMINAL OF NET LIST. STORE THE CALCULATED CHANGES. ~ 3903

FROM THE NUMBER OF LOGIC CHANGES THAT OCCURRED AT THE OUTPUT OF EACH CIRCUIT DEVICE, SELECT A PREDETERMINED NUMBER OF CIRCUIT DEVICES IN THE ORDER OF LOGIC CHANGE NUMBER AND SET THEM AS CURRENT ESTIMATION OBJECTS ~ 3904

FROM THE LOGIC CHANGE INFORMATION FOR THE CURRENT ESTIMATION OBJECT CIRCUIT DEVICES, ESTIMATE POWER SUPPLY CURRENT INFORMATION, PERFORM FFT ON THE ESTIMATED POWER SUPPLY CURRENTS AND STORE THE RESULT ~ 3905

END CURRENT FFT ANALYSIS MEANS

## FIG. 40

4001 — NET LIST STORAGE MEANS

TEST VECTOR STORAGE MEANS — 4002

4003 — CURRENT FFT ANALYSIS MEANS

4004 — FFT RESULT STORAGE MEANS

## FIG. 41

START CURRENT FFT ANALYSIS MEANS

READ NET LIST INFORMATION — 4101

READ TEST VECTOR INFORMATION — 4102

CALCULATE TOGGLE RATE FROM NET LIST INFORMATION, AND SELECT AS ANALYSIS OBJECTS THOSE CIRCUIT DEVICES ESTIMATED TO HAVE LARGE TOGGLE CHANGES — 4103

FOR ALL POINTS IN TIME RECORDED IN TEST VECTOR, CALCULATE CHANGE i (t) OVER TIME OF POWER SUPPLY CURRENT THAT FLOWS IN NETWORK OF CURRENT ESTIMATION OBJECT CIRCUIT DEVICES AS A RESULT OF APPLYING VOLTAGE VALUE TO EXTERNAL TERMINAL OF NET LIST. PERFORM FFT ON THE CALCULATED CHANGE AND STORE THE RESULT. — 4104

END CURRENT FFT ANALYSIS MEANS

## FIG. 42

5001 — FFT RESULT STORAGE MEANS

5002 — FFT RESULT SORT MEANS

5003 — SORT RESULT STORAGE MEANS

## FIG. 43

51

| INSTANCE NAME | FREQUENCY OF FFT RESULT | CURRENT FREQUENCY COMPONENT |
|:---:|:---:|:---:|
| M1 | 50 | 1.1 |
| | 100 | 1.7 |
| | 150 | 2.0 |
| | 200 | 1.9 |
| | 250 | 1.6 |
| | 300 | 0.8 |
| | 350 | 1.5 |
| | 400 | 1.8 |
| M2 | 50 | 1.5 |
| | 100 | 2.0 |
| | 150 | 1.6 |
| | 200 | 0.9 |
| | 250 | 1.2 |
| | 300 | 1.5 |
| | 350 | 1.7 |
| | 400 | 1.1 |

5101          5102                    5103

# FIG. 44

52

| FREQUENCY | INSTANCE | CURRENT FREQUENCY COMPONENT |
|-----------|----------|------------------------------|
| 50 | M4 | 2.0 |
| | M3 | 1.8 |
| | M8 | 1.7 |
| | M2 | 1.5 |
| | M7 | 1.4 |
| | M5 | 1.3 |
| | M1 | 1.1 |
| | M6 | 0.9 |
| 100 | M2 | 2.0 |
| | M6 | 1.9 |
| | M5 | 1.8 |
| | M1 | 1.7 |
| | M4 | 1.5 |
| | M3 | 1.3 |
| | M6 | 1.1 |
| | M7 | 1.0 |

5201          5202                    5203

# FIG. 45

```
        ( START FFT RESULT SORT MEANS )
                       │
                       ▼
        ┌─────────────────────────────┐
        │  READ FFT RESULT INFORMATION │──── 5301
        └─────────────────────────────┘
                       │
                       ▼
        ┌─────────────────────────────┐
        │  READ FREQUENCY INFORMATION  │──── 5302
        └─────────────────────────────┘
                       │
                       ▼
        ┌─────────────────────────────┐
        │ SELECT NEXT (FIRST) FREQUENCY│──── 5303
        └─────────────────────────────┘
                       │
                       ▼
        ┌─────────────────────────────────┐
        │ SELECT INSTANCE AND CURRENT      │
        │ FREQUENCY                        │──── 5304
        │ COMPONENT OF OBJECT FREQUENCY    │
        └─────────────────────────────────┘
                       │
                       ▼
        ┌─────────────────────────────────┐
        │ SORT SELECTED INSTANCES AND CURRENT │
        │ FREQUENCY COMPONENTS IN THE ORDER   │──── 5305
        │ OF CURRENT FREQUENCY COMPONENT      │
        └─────────────────────────────────┘
                       │
                       ▼
        ┌─────────────────────────────────┐
        │ WRITE OBJECT FREQUENCY, SORTED INSTANCE │
        │ NAMES AND CURRENT FREQUENCY COMPONENTS  │──── 5306
        │ INTO SORT RESULT STORAGE INFORMATION    │
        └─────────────────────────────────┘
                       │
                       ▼              5307
                    ╱IS THERE╲
         YES      ╱ NEXT FREQUENCY  ╲
        ◄────────  INFORMATION
                  ╲      ?      ╱
                    ╲        ╱
                       │ NO
                       ▼
        ( END FFT RESULT SORT MEANS )
```

# FIG. 46

54

| INSTANCE GROUP | FREQUENCY OF FFT RESULT | CURRENT FREQUENCY COMPONENT |
|---|---|---|
| G1 | 50 | 1.1 |
| | 100 | 1.7 |
| | 150 | 2.0 |
| | 200 | 1.9 |
| | 250 | 1.6 |
| | 300 | 0.8 |
| | 350 | 1.5 |
| | 400 | 1.8 |
| G2 | 50 | 1.5 |
| | 100 | 2.0 |
| | 150 | 1.6 |
| | 200 | 0.9 |
| | 250 | 1.2 |
| | 300 | 1.5 |
| | 350 | 1.7 |
| | 400 | 1.1 |

5401      5402      5403

## FIG. 47

| FREQUENCY | INSTANCE GROUP | CURRENT FREQUENCY COMPONENT |
|---|---|---|
| 50 | G4 | 2.0 |
| | G3 | 1.8 |
| | G8 | 1.7 |
| | G2 | 1.5 |
| | G7 | 1.4 |
| | G5 | 1.3 |
| | G1 | 1.1 |
| | G6 | 0.9 |
| 100 | G2 | 2.0 |
| | G6 | 1.9 |
| | G5 | 1.8 |
| | G1 | 1.7 |
| | G4 | 1.5 |
| | G3 | 1.3 |
| | G6 | 1.1 |
| | G7 | 1.0 |

5501      5502      5503

## FIG. 48

START FFT RESULT SORT MEANS

↓

READ FFT RESULT INFORMATION — 5601

↓

READ FREQUENCY INFORMATION — 5602

↓

SELECT FIRST FREQUENCY — 5603

↓

SELECT INSTANCE GROUP AND CURRENT FREQUENCY COMPONENT OF OBJECT FREQUENCY — 5604

↓

SORT SELECTED INSTANCE GROUPS AND CURRENT FREQUENCY COMPONENTS IN THE ORDER OF CURRENT FREQUENCY COMPONENT — 5605

↓

WRITE OBJECT FREQUENCY, SORTED INSTANCE GROUP NAMES AND CURRENT FREQUENCY COMPONENTS INTO SORT RESULT STORAGE INFORMATION — 5606

↓

5607

IS THERE NEXT FREQUENCY INFORMATION ?

YES →

NO ↓

END FFT RESULT SORT MEANS

# FIG. 49

5701 — INSTANCE-BASED CURRENT INFORMATION STORAGE MEANS

5702 — INPUT GROUPING INFORMATION

5703 — INSTANCE GROUPING MEANS

5704 — GROUP-BASED CURRENT INFORMATION STORAGE MEANS

5705 — GROUP-INSTANCE CORRESPONDENCE INFORMATION STORAGE MEANS

5706 — FFT ANALYSIS MEANS

5707 — FFT RESULT STORAGE MEANS

5708 — FFT RESULT SORT MEANS

5709 — SORT RESULT STORAGE MEANS

## FIG. 50

| INSTANCE NAME | TIME | CURRENT |
|---|---|---|
| M1 | 50 | 2 |
| | 100 | 1 |
| | 150 | 3 |
| | 200 | 2 |
| | 250 | 4 |
| | 300 | 1 |
| | 350 | 2 |
| | 400 | 3 |
| M2 | 50 | 5 |
| | 100 | 7 |
| | 150 | 9 |
| | 200 | 6 |
| | 250 | 4 |
| | 300 | 5 |
| | 350 | 3 |
| | 400 | 5 |

5801        5802        5803

## FIG. 51

| CELL INFORMATION | PROPERTY INFORMATION |
|:---:|:---:|
| AND | 1 |
| OR | 1 |
| FF | 2 |
| SRAM | 3 |
| DRAM | 3 |
| IO1 | 4 |
| IO2 | 4 |
| ⋮ | ⋮ |
| | |
| ⋮ | ⋮ |
| | |
| | |
| | |
| | |
| | |
| | |
| | |

5901           5902

# FIG. 52

| INSTANCE GROUP | TIME | CURRENT |
|---|---|---|
| G1 | 50 | 20 |
| | 100 | 10 |
| | 150 | 30 |
| | 200 | 20 |
| | 250 | 40 |
| | 300 | 10 |
| | 350 | 20 |
| | 400 | 30 |
| G2 | 50 | 50 |
| | 100 | 70 |
| | 150 | 90 |
| | 200 | 60 |
| | 250 | 40 |
| | 300 | 50 |
| | 350 | 30 |
| | 400 | 50 |

6001    6002    6003

## FIG. 53

| INSTANCE GROUP | INSTANCE NAME |
|:---:|:---:|
| G1 | 50 |
| | 100 |
| | 150 |
| | 200 |
| | 250 |
| | 300 |
| | 350 |
| | 400 |
| G2 | 50 |
| | 100 |
| | 150 |
| | 200 |
| | 250 |
| | 300 |
| | 350 |
| | 400 |

6101      6102

## FIG. 54

START INSTANCE GROUPING MEANS

6201 — READ INSTANCE-BASED CURRENT INFORMATION

6202 — READ GROUPING INFORMATION
(CELL PROPERTY INFORMATION)

6203 — GROUP INSTANCES WITH THE SAME PROPERTY INFORMATION
(REGISTERS, COMBINED CIRCUITS, MEMORIES, ETC.)

6204 — WRITE GROUP NAMES AND INSTANCE NAMES
BELONGING TO EACH GROUP INTO GROUP-
INSTANCE CORRESPONDENCE TABLE

6205 — SUM UP CURRENT INFORMATION ON INSTANCES
FOR EACH GROUP AND WRITE THEM INTO GROUP-
BASED CURRENT INFORMATION STORAGE TABLE

END INSTANCE GROUPING MEANS

## FIG. 55

6301 — INSTANCE-BASED CURRENT INFORMATION STORAGE MEANS

6302 — INPUT GROUPING INFORMATION

6303 — NET LIST INFORMATION STORAGE MEANS

6304 — INSTANCE GROUPING MEANS

6305 — GROUP-BASED CURRENT INFORMATION STORAGE MEANS

6306 — GROUP-INSTANCE CORRESPONDENCE INFORMATION STORAGE MEANS

6307 — FFT ANALYSIS MEANS

6308 — FFT RESULT STORAGE MEANS

6309 — FFT RESULT SORT MEANS

6310 — SORT RESULT STORAGE MEANS

# FIG. 56

| GROUPING NUMBER | CLOCK TERMINAL NAME |
|:---:|:---:|
| 1 | CLK1 |
| 2 | CLK2 |
| 3 | CLK3 |
| 4 | CLK4 |
| 5 | CLK5 |
| 6 | CLK6 |
| 7 | CLK7 |
| ⋮ | ⋮ |
| | |
| | |
| | |
| | |
| | |
| | |
| | |
| | |

6401　　　　　　　　　6402

## FIG. 57

START INSTANCE GROUPING MEANS

READ INSTANCE-BASED CURRENT INFORMATION — 6501

READ CLOCK INFORMATION — 6502

SELECT NEXT (FIRST) CLOCK INFORMATION — 6503

GROUP INSTANCES ON CLOCK TREE CONNECTED TO CLOCK INPUT TERMINAL — 6504

WRITE GROUP NAMES AND INSTANCE NAMES BELONGING TO EACH GROUP INTO GROUP-INSTANCE CORRESPONDENCE TABLE — 6505

6506

IS THERE NEXT CLOCK INFORMATION ?

NO?

YES?

SUM UP CURRENT INFORMATION ON INSTANCES FOR EACH GROUP AND WRITE THEM INTO GROUP-BASED CURRENT INFORMATION STORAGE TABLE — 6507

END INSTANCE GROUPING MEANS

FIG. 58

## FIG. 59

( START INSTANCE GROUPING MEANS )

6701 — READ INSTANCE-BASED CURRENT INFORMATION

6702 — PERFORM STATIC TIMING ANALYSIS (STA) AND GROUP INSTANCES WITH MATCHED TIMING

6703 — WRITE GROUP NAMES AND INSTANCE NAMES BELONGING TO EACH GROUP INTO GROUP-INSTANCE CORRESPONDENCE TABLE

6704 — SUM UP CURRENT INFORMATION ON INSTANCES FOR EACH GROUP AND WRITE THEM INTO GROUP-BASED CURRENT INFORMATION STORAGE TABLE

( END INSTANCE GROUPING MEANS )

## FIG. 60

## FIG. 61

6904

NET LIST
INFORMATION
STORAGE MEANS

6901 — INSTANCE
GROUPING MEANS

6902 — GROUP-BASED
CURRENT INFORMATION
STORAGE MEANS

GROUP-INSTANCE
CORRESPONDENCE
INFORMATION
STORAGE MEANS — 6903

6905 — FFT RESULT
STORAGE MEANS

6906 — FFT RESULT
SORT MEANS

6907 — SORT RESULT
STORAGE MEANS

6908

INSTANCE INFORMATION
DISPLAY MEANS

*FIG. 62*

7001
INPUT
FREQUENCY
INFORMATION

7002 — FFT
ANALYSIS MEANS

7004 — SORT RESULT
STORAGE MEANS

GROUP-INSTANCE
CORRESPONDENCE
INFORMATION
STORAGE MEANS — 7003

7005
INSTANCE INFORMATION
DISPLAY MEANS

*FIG. 63*

8001: POWER SUPPLY CURRENT
(POWER SUPPLY RC NETWORK)

8002: POWER SUPPLY CURRENT
(IDEAL POWER SUPPLY)

# FIG. 64

8101 — RESISTANCE STORAGE MEANS

CAPACITANCE STORAGE MEANS — 8102

8103 — POWER SUPPLY WIRE DEPENDENCE INFORMATION STORAGE MEANS

CURRENT WAVEFORM STORAGE MEANS — 8104

8107 — CURRENT WAVEFORM CORRECTION MEANS

8106 — CORRECTED CURRENT WAVEFORM STORAGE MEANS

*FIG. 65*

8201

| R1 | VDD | #1 | V1.0 |
| R2 | #1 | #2 | 1.5 |
| R3 | #1 | #3 | 1.5 |
| R4 | #3 | #5 | 1.0 |
| R5 | #2 | #7 | 1.5 |
| R6 | #3 | #4 | 2.0 |
| ⋮ | | | |

8202

8301

| | | |
|----|-----|------|
| C0 | VDD | V1.0 |
| C1 | #1  | 0.5  |
| C2 | #2  | 1.2  |
| C3 | #3  | 1.3  |
| C4 | #4  | 0.7  |
| C5 | #5  | 2.1  |

**FIG. 66**

VDD #1 #2 #7

C0 C1 C2

#3 #5

C3 C5

#4

C4

8302

*FIG. 67*

8401: EVENT-BASED MODEL OF
ESTIMATED CURRENT WAVEFORM

AREA : I
BASE : T
HEIGHT : H = (I x 2)/T

I

T

*FIG. 68*

CURRENT CORRECTION
COEFFICIENT $\alpha$

8501

EQUIVALENT CAPACITANCE C

EQUIVALENT RESISTANCE R

8502

CURRENT CORRECTION COEFFICIENT
$\alpha = F(c, R)$

# FIG. 69

```
        ┌─────────────────────────────┐
        │    START CURRENT WAVEFORM    │
        │      CORRECTION MEANS        │
        └─────────────────────────────┘
                      │
                      ▼
8601 ─┐ ┌───────────────────────────────────────────────┐
8602 ─┤ │ READ RESISTANCE INFORMATION                   │
8603 ─┤ │ READ CAPACITANCE INFORMATION                  │
8604 ─┘ │ READ POWER SUPPLY WIRE DEPENDENCE INFORMATION │
        │ READ CURRENT WAVEFORM INFORMATION             │
        └───────────────────────────────────────────────┘
                      │
                      ▼
8605 ─┐ ┌───────────────────────────────────┐
        │ ESTIMATE EQUIVALENT RESISTANCE    │
        │ FROM RESISTANCE INFORMATION       │
        └───────────────────────────────────┘
                      │
                      ▼
8606 ─┐ ┌───────────────────────────────────┐
        │ CALCULATE EQUIVALENT CAPACITANCE  │
        │ FROM CAPACITANCE INFORMATION      │
        └───────────────────────────────────┘
                      │
                      ▼
8607 ─┐ ┌──────────────────────────────────────────────────┐
        │ DETERMINE CURRENT CORRECTION COEFFICIENT FROM    │
        │ EQUIVALENT RESISTANCE, EQUIVALENT CAPACITANCE    │
        │ AND POWER SUPPLY WIRE DEPENDENCE INFORMATION     │
        └──────────────────────────────────────────────────┘
                      │
                      ▼
8608 ─┐ ┌───────────────────────────────────┐
        │ CORRECT CURRENT WAVEFORM BY USING │
        │ CURRENT CORRECTION COEFFICIENT    │
        └───────────────────────────────────┘
                      │
                      ▼
8609 ─┐ ┌───────────────────────────────────┐
        │ STORE CORRECTED CURRENT           │
        │ WAVEFORM INFORMATION              │
        └───────────────────────────────────┘
                      │
                      ▼
        ┌─────────────────────────────┐
        │    END CURRENT WAVEFORM     │
        │      CORRECTION MEANS       │
        └─────────────────────────────┘
```

# FIG. 70

8701: ESTIMATED CURRENT MODEL
(IDEAL POWER SUPPLY)

8702: POWER SUPPLY RC NETWORK

VDD

8703

8704

CALCULATE

EQUIVALENT RESISTANCE : ○ Ω
EQUIVALENT CAPACITANCE : ○ pF

SUBSTITUTE

8705

8706

CORRECT

8707

POWER SUPPLY WIRE
DEPENDENCE INFORMATION

8708: ESTIMATED CURRENT MODEL
(POWER SUPPLY RC CONSIDERED)

## FIG. 71

8801: POWER SUPPLY CURRENT
(POWER SUPPLY RC NETWORK)

In

Tn

8802: POWER SUPPLY CURRENT
(IDEAL POWER SUPPLY)

Ii

Ti

8803

VDD

CALCULATE

EQUIVALENT RESISTANCE    : R [ Ω ]
EQUIVALENT CAPACITANCE : C [ pF ]

8804

BASE CORRECTION COEFFICIENT : $\alpha t = Tn/Ti$
AREA CORRECTION COEFFICIENT : $\alpha i = In/Ii$

FIG. 72

EQUIVALENT RESISTANCE

(1) CALCULATE RESISTANCE FOR EACH JUNCTION

8901

#1 = R1

⋮

#5 = R1 + { { (R2 + R7) x (R3 + R4) } / { (R2 + R7) + (R3 + R4) } }

⋮

(1) CALCULATE AVERAGE
 → USE IT AS EQUIVALENT RESISTANCE OF CHIP

EQUIVALENT CAPACITANCE

(1) SUM UP CAPACITANCES OF CHIP
 → USE IT AS EQUIVALENT CAPACITANCE

8902

# FIG. 73

DECOUPLING INFLUENCE IS REFLECTED

9001: EVENT-BASED MODEL OF
ESTIMATED CURRENT WAVEFORM

Ii

Ti

$\alpha t$

9002: CORRECT BASE OF CURRENT WAVEFORM MODEL
BY USING $\alpha t$ DETERMINED FROM EQUIVALENT
RESISTANCE AND EQUIVALENT CAPACITANCE

I

$I = Ii$
$T = Tn \times \alpha t$

T

# FIG. 74

IR-DROP INFLUENCE IS REFLECTED

9101: EVENT-BASED MODEL OF
ESTIMATED CURRENT WAVEFORM

Ii

Ti

$\alpha$i

9102: CORRECT AREA OF CURRENT WAVEFORM MODEL
BY USING $\alpha$i DETERMINED FROM EQUIVALENT
RESISTANCE AND EQUIVALENT CAPACITANCE

I

$$I = Ii \times \alpha i$$
$$T = Tn$$

T

## FIG. 75

9201 — RESISTANCE STORAGE MEANS

CAPACITANCE STORAGE MEANS — 9202

9203 — POWER SUPPLY WIRE DEPENDENCE INFORMATION STORAGE MEANS

CURRENT WAVEFORM STORAGE MEANS — 9204

SHAPE INFORMATION STORAGE MEANS — 9205

9207 — CURRENT WAVEFORM CORRECTION MEANS

9206 — CORRECTED CURRENT WAVEFORM STORAGE MEANS

## FIG. 76

```
            ┌─────────────────────────────┐
            │   START CURRENT WAVEFORM     │
            │     CORRECTION MEANS         │
            └─────────────────────────────┘
                          │
                          ▼
  9301 ──┐  ┌──────────────────────────────────────────────────┐
  9302 ──┤  │ READ RESISTANCE INFORMATION                      │
  9303 ──┤  │ READ CAPACITANCE INFORMATION                     │
  9310 ──┤  │ READ POWER SUPPLY WIRE DEPENDENCE INFORMATION    │
  9304 ──┘  │ READ CURRENT WAVEFORM INFORMATION                │
            │ READ CHIP SHAPE INFORMATION                      │
            └──────────────────────────────────────────────────┘
                          │
                          ▼
            ┌──────────────────────────────────────────────────┐
  9305 ──── │ CALCULATE ESTIMATED EQUIVALENT RESISTANCE        │
            │ FROM RESISTANCE INFORMATION AND POWER            │
            │ SUPPLY CIRCUIT SHAPE INFORMATION                 │
            └──────────────────────────────────────────────────┘
                          │
                          ▼
            ┌──────────────────────────────────────────────────┐
  9306 ──── │ CALCULATE EQUIVALENT CAPACITANCE                 │
            │ FROM CAPACITANCE INFORMATION                     │
            └──────────────────────────────────────────────────┘
                          │
                          ▼
            ┌──────────────────────────────────────────────────┐
  9307 ──── │ DETERMINE CURRENT CORRECTION COEFFICIENT FROM    │
            │ EQUIVALENT RESISTANCE, EQUIVALENT CAPACITANCE    │
            │ AND POWER SUPPLY WIRE DEPENDENCE INFORMATION     │
            └──────────────────────────────────────────────────┘
                          │
                          ▼
            ┌──────────────────────────────────────────────────┐
  9308 ──── │ CORRECT CURRENT WAVEFORM BY USING                │
            │ CURRENT CORRECTION COEFFICIENT                   │
            └──────────────────────────────────────────────────┘
                          │
                          ▼
            ┌──────────────────────────────────────────────────┐
  9309 ──── │ STORE CORRECTED CURRENT                          │
            │ WAVEFORM INFORMATION                             │
            └──────────────────────────────────────────────────┘
                          │
                          ▼
            ┌─────────────────────────────┐
            │   END CURRENT WAVEFORM       │
            │     CORRECTION MEANS         │
            └─────────────────────────────┘
```

## FIG. 77

9401 — EQUIVALENT RESISTANCE STORAGE MEANS

EQUIVALENT CAPACITANCE STORAGE MEANS — 9402

9403 — POWER SUPPLY WIRE DEPENDENCE INFORMATION STORAGE MEANS

CURRENT WAVEFORM STORAGE MEANS — 9404

9407 — CURRENT WAVEFORM CORRECTION MEANS

9406 — CORRECTED CURRENT WAVEFORM STORAGE MEANS

## FIG. 78

START CURRENT WAVEFORM
CORRECTION MEANS

9501 — READ EQUIVALENT RESISTANCE INFORMATION
9502 — READ EQUIVALENT CAPACITANCE INFORMATION
9503 — READ POWER SUPPLY WIRE DEPENDENCE INFORMATION
9504 — READ CURRENT WAVEFORM INFORMATION

9505 — CALCULATE EQUIVALENT RESISTANCE OF CHIP
FROM EQUIVALENT RESISTANCE INFORMATION

9506 — CALCULATE EQUIVALENT CAPACITANCE OF CHIP
FROM EQUIVALENT CAPACITANCE INFORMATION

9507 — DETERMINE CURRENT CORRECTION COEFFICIENT FROM
EQUIVALENT RESISTANCE, EQUIVALENT CAPACITANCE
AND POWER SUPPLY WIRE DEPENDENCE INFORMATION

9508 — CORRECT CURRENT WAVEFORM BY USING
CURRENT CORRECTION COEFFICIENT

9509 — STORE CORRECTED CURRENT
WAVEFORM INFORMATION

END CURRENT WAVEFORM
CORRECTION MEANS

## FIG. 79

```
   9605              9602              9601              9603
┌──────────────┐ ┌──────────────┐ ┌──────────────┐ ┌──────────────┐
│ POWER SUPPLY │ │  TECHNOLOGY  │ │  CHIP SHAPE  │ │ POWER SUPPLY │
│  WIRE WIDTH  │ │ INFORMATION  │ │ INFORMATION  │ │PAD INFORMATION│
│ INFORMATION  │ │STORAGE MEANS │ │STORAGE MEANS │ │STORAGE MEANS │
│STORAGE MEANS │ │              │ │              │ │              │
└──────────────┘ └──────────────┘ └──────────────┘ └──────────────┘
```

```
                        9604              9607
                 ┌──────────────┐ ┌──────────────┐
                 │CONFIGURATION │ │              │
                 │   MODULE     │ │   DATABASE   │
                 │ INFORMATION  │ │STORAGE MEANS │
                 │STORAGE MEANS │ │              │
                 └──────────────┘ └──────────────┘
```

```
9408 ┌─────────────────────────────────────────────┐
9409 │ EQUIVALENT RESISTANCE ESTIMATION MEANS        │
     │ EQUIVALENT CAPACITANCE ESTIMATION MEANS       │
     └─────────────────────────────────────────────┘
```

```
     ┌──────────────┐ ┌──────────────┐
     │  EQUIVALENT  │ │  EQUIVALENT  │
9610 │  RESISTANCE  │ │  CAPACITANCE │ 9611
     │STORAGE MEANS │ │STORAGE MEANS │
     └──────────────┘ └──────────────┘
```

# FIG. 80

START EQUIVALENT
RESISTANCE ESTIMATION MEANS

9701 — READ DATABASE INFORMATION
9702 — READ OBJECT CHIP INFORMATION

9703 — ESTIMATE EQUIVALENT RESISTANCE AND EQUIVALENT
CAPACITANCE FROM CHIP AREA INFORMATION

9704 — ESTIMATE EQUIVALENT RESISTANCE AND EQUIVALENT
CAPACITANCE FROM TECHNOLOGY INFORMATION

9705 — ESTIMATE EQUIVALENT RESISTANCE AND
EQUIVALENT CAPACITANCE FROM CHIP
SHAPE AND POWER SUPPLY PAD POSITION

9706 — ESTIMATE EQUIVALENT RESISTANCE AND EQUIVALENT
CAPACITANCE FROM POWER SUPPLY PAD NUMBER

9707 — ESTIMATE EQUIVALENT RESISTANCE AND
EQUIVALENT CAPACITANCE FROM
POWER SUPPLY WIRE WIDTH INFORMATION

9708 — ESTIMATE EQUIVALENT RESISTANCE AND EQUIVALENT
CAPACITANCE FROM INFORMATION ON CAPACITANCE
GENERATION AREA UNDER POWER SUPPLY WIRES

9709 — STORE EQUIVALENT RESISTANCE AND EQUIVALENT
CAPACITANCE INTO EQUIVALENT RESISTANCE STORAGE
MEANS AND EQUIVALENT CAPACITANCE STORAGE MEANS

END EQUIVALENT RESISTANCE
ESTIMATION MEANS

## FIG. 81

| | |
|---|---|
| CHIP EQUIVALENT RESISTANCE | 20Ω |
| CHIP EQUIVALENT CAPACITANCE | 400pF |
| CHIP AREA<br>CHIP SHAPE | 400mm$^2$<br>20.0mm x 20.0mm |
| NUMBER OF POWER SUPPLY PADS<br>POWER SUPPLY PAD POSITION | 1<br>(1000, 0) |
| TECHNOLOGY<br>SHEET RESISTANCE<br>UNIT PARASITIC CAPACITANCE | 0.6um<br>100mΩ<br>1.0pF |
| RING POWER SUPPLY WIRE<br>TRUNK POWER SUPPLY WIRE<br>DECOUPLING CAPACITANCE CELL | PROVIDED, 50um<br>30um<br>NOT PROVIDED |
| MODULE KIND<br>MODULE AREA<br>MODULE POSITION<br>NUMBER OF INSTANCES<br>IN-MODULE WIRE WIDTH<br>PERIPHERAL CAPACITANCE CELL | STANDARD LOGIC (A)<br>8.0mm x 4.5mm<br>(400, 800)<br>700,000<br>5um<br>NOT PROVIDED |
| MODULE KIND<br>MODULE AREA<br>MODULE POSITION<br>NUMBER OF INSTANCES<br>IN-MODULE WIRE WIDTH<br>PERIPHERAL CAPACITANCE CELL | RAM (B)<br>13.0mm x 2.0mm<br>(1700, 1800)<br>300,000<br>–<br>NOT PROVIDED |
| ⋮ | ⋮ |

# FIG. 82

POWER SUPPLY PAD

# FIG. 83

| | |
|---|---|
| CHIP EQUIVALENT RESISTANCE | ?                                     , |
| CHIP EQUIVALENT CAPACITANCE | ? |
| CHIP AREA<br>CHIP SHAPE | 1,600mm$^2$<br>80.0mm x 20.0mm |
| NUMBER OF POWER SUPPLY PADS<br>POWER SUPPLY PAD POSITION | 2<br>(4000, 0) (4000, 2000) |
| TECHNOLOGY<br>SHEET RESISTANCE<br>UNIT PARASITIC CAPACITANCE | 0.6um<br>100m$\Omega$<br>0.75pF |
| RING POWER SUPPLY WIRE<br>TRUNK POWER SUPPLY WIRE<br>DECOUPLING CAPACITANCE CELL | PROVIDED, 75um<br>45um<br>INSERT UNDER RING POWER SUPPLY WIRE |
| MODULE KIND<br>MODULE AREA<br>MODULE POSITION<br>NUMBER OF INSTANCES<br>IN-MODULE WIRE WIDTH<br>PERIPHERAL CAPACITANCE CELL | STANDARD LOGIC (C)<br>7.5mm x 15.0mm<br>(400, 800)<br>700,000<br>5um<br>NOT PROVIDED |
| MODULE KIND<br>MODULE AREA<br>MODULE POSITION<br>NUMBER OF INSTANCES<br>IN-MODULE WIRE WIDTH<br>PERIPHERAL CAPACITANCE CELL | RAM (D)<br>4.0mm x 25.0mm<br>(1700, 1800)<br>300,000<br>—<br>NOT PROVIDED |
| ⋮ | ⋮ |

# FIG. 84

POWER SUPPLY PAD

POWER SUPPLY PAD

FIG. 85 (a)

POWER SUPPLY PAD

M1

FIG. 85 (b)

POWER SUPPLY PAD

M1

FIG. 86 (a)

POWER SUPPLY PAD

GLOBAL RESISTANCE
= 1 + 1 + 2 + 2
= 6

| 1 | 1 |
| 2 | 2 |

FIG. 86 (b)

POWER SUPPLY PAD

| 2 | 1 | 1 | 2 |

GLOBAL RESISTANCE = 1 + 1 + 2 + 2 = 6

FIG. 86 (c)

POWER SUPPLY PAD

| 4 | 3 | 2 | 1 |

GLOBAL RESISTANCE = 1 + 2 + 3 + 4 = 10

## FIG. 87

FIG. 88 (a)

POWER SUPPLY PAD

| 1 | 1 |
| 2 | 2 |

EQUIVALENT RESISTANCE
= 1 + 1 + 2 + 2
= 6

FIG. 88 (b)

POWER SUPPLY PAD

| 0.67 | 0.67 |
| 0.67 | 0.67 |

EQUIVALENT RESISTANCE
= 2.67

FIG. 88 (c)

POWER SUPPLY PAD

| 0.33 | 0.33 |
| 0.33 | 0.33 |

EQUIVALENT RESISTANCE
= 1.33

## FIG. 89 (a)

## FIG. 89 (b)

FIG. 90